(19) Europäisches Patentamt / European Patent Office / Office européen des brevets

(11) **EP 1 686 425 B1**

(12) **EUROPEAN PATENT SPECIFICATION**


(45) Date of publication and mention of the grant of the patent: **13.06.2018 Bulletin 2018/24**

(21) Application number: **04818880.9**

(22) Date of filing: **15.11.2004**

(51) Int Cl.:
***C08F 216/12*** *(2006.01)* ***C09D 133/14*** *(2006.01)*
***G03F 7/09*** *(2006.01)* ***G03F 7/004*** *(2006.01)*

(86) International application number:
**PCT/JP2004/016937**

(87) International publication number:
**WO 2005/050320 (02.06.2005 Gazette 2005/22)**


(54) **METHOD FOR FORMING MULTILAYER RESIST**

VERFAHREN ZUR ERZEUGUNG EINES MEHRSCHICHT-RESISTS

METHODE DE FORMATION D'UN RESIST MULTICOUCHE


(84) Designated Contracting States:
**AT BE BG CH CY CZ DE DK EE ES FI FR GB GR HU IE IS IT LI LU MC NL PL PT RO SE SI SK TR**

(30) Priority:
**19.11.2003 JP 2003389857**
**23.04.2004 JP 2004128935**
**18.06.2004 JP 2004181329**
**18.08.2004 JP 2004238813**

(43) Date of publication of application:
**02.08.2006 Bulletin 2006/31**



(73) Proprietor: **DAIKIN INDUSTRIES, LTD.**
**Osaka-shi, Osaka 530-8323 (JP)**

(72) Inventors:
- **ARAKI, Takayuki, c/o Yodogawa-seisakusho Settsu-shi, Osaka 566-8585 (JP)**
- **KOH, Meiten, c/o Yodogawa-seisakusho Settsu-shi, Osaka 566-8585 (JP)**
- **SATO, Kazuyuki, c/o Yodogawa-seisakusho Settsu-shi, Oaka 566-8585 (JP)**
- **OHASHI, Mihoko, c/o Yodogawa-seisakusho Settsu-shi, Osaka 566-8585 (JP)**
- **KISHIKAWA, Yosuke, c/o Yodogawa-seisakusho Settsu-shi, Osaka 566-8585 (JP)**

(74) Representative: **Hoffmann Eitle**
**Patent- und Rechtsanwälte PartmbB**
**Arabellastraße 30**
**81925 München (DE)**



(56) References cited:

| | |
|---|---|
| **WO-A1-00/53647** | **WO-A1-02/066526** |
| **WO-A2-02/44816** | **JP-A- 6 041 768** |
| **JP-A- 11 124 531** | **JP-A- 11 124 531** |
| **JP-A- 2001 133 984** | **JP-A- 2004 037 887** |



Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).


EP 1 686 425 B1

## Description

TECHNICAL FIELD

The present invention relates to a method of forming a laminated resist produced by forming an antireflection layer on a photoresist layer.

BACKGROUND ART

In recent years, with the advance of high integration and high speed operation of LSI, scale down of design rule is demanded, and for that reason, reduction of wavelength of exposure light source used for forming a resist pattern has been progressing. In a mass production process of 64 M bit DRAM (dynamic random access memory), KrF excimer laser (248 nm) has been used, and in production of 256 M and 1G bit or more DRAM, ArF excimer laser (193 nm) having a shorter wavelength is used as an exposure light source. Recently aiming at further micro fabrication, $F_2$ (157 nm) laser having a further shorter wavelength is studied as a new exposure light source.

For an exposure system for those lithography processes, a combination of monochromatic light and dioptric system lens is mainly used. However since a standing wave is generated due to interference between the incident light and the reflection light from a substrate at the time of exposure, fluctuation in dimensions such as width of pattern line and breakage of pattern form arise. Particularly in the case of forming a fine resist pattern on a semiconductor substrate having a step, such a dimensional fluctuation and breakage of pattern form due to a standing wave are significant (standing wave effect).

So far methods for reducing this standing wave effect have been proposed, such as a method of blending a light absorbing agent in a resist material, a method of providing an antireflection layer on a top surface of a resist layer (ARCOR method, JP60-38821A, JP62-62520A, JP62-62521A) and a method of providing an antireflection layer on a bottom surface of a resist (BARC method, JP62-159143A). Among those methods, the ARCOR method comprises a step for forming a transparent upper antireflection film layer on a top surface of a resist and peeling the film after exposure. In this method, a fine pattern having a high dimensional accuracy, particularly a high matching accuracy is formed by its easy film formation procedure.

In the BARC method, too, a high reflection reducing effect can be obtained, but in the case where a substrate has a step, there are disadvantages that a thickness of the antireflection film on the step fluctuates largely, thereby greatly changing a reflectance and the reflectance is increased if the antireflection film thickness is increased for reducing a film thickness fluctuation. Therefore a combination use of an upper antireflection film layer to be provided on the top surface of the photoresist layer is desired. The upper antireflection film layer has not only a primary function of reflection reduction but also a function of preventing a developing failure by enhancing affinity for a developing solution after the exposure or a function as a barrier film from environment, and therefore will be a more important material.

At the initial stage of development, perfluoropolyether having a low refractive index was studied as an antireflection film material for the ARCOR method, but had demerits from the viewpoint of practical use because a fluorine-containing hydrocarbon solvent must be used as a diluent or a releasing agent, thereby resulting in a high cost and causing a problem with film forming property.

In order to overcome those demerits, fluorine-containing antireflection film materials which can be released easily with an aqueous alkali solution used as a developing solution or pure water used as a rinsing solution have been developed (JP5-188598A, JP6-41768A, JP6-51523A, JP7-234514A, JP8-305032A, JP8-292562A, JP11-349857A and JP11-352697A).

Those materials are mainly compositions of a water soluble polymer such as polyvinyl pyrrolidone or polyvinyl alcohol which is a non-fluorine-containing binder polymer; and a low molecular weight fluorine-containing alkylsulfonic acid, fluorine-containing alkylcarboxylic acid or amine salt thereof; or further a high molecular weight fluorine-containing polyether having sulfonic acid, carboxylic acid or amine salt thereof at an end of its trunk chain.

However when a low molecular weight fluorine-containing alkylsulfonic acid, fluorine-containing alkylcarboxylic acid or amine salt thereof is used, there is a disadvantage that diffusion thereof in a resist layer occurs because its molecular weight is low, and a pattern profile of a resist is deteriorated.

Also when a high molecular weight fluorine-containing polyether having sulfonic acid, carboxylic acid or amine salt thereof at an end of its trunk chain is used, there are disadvantages that in the case of a molecular weight being high enough for preventing the diffusion, its water solubility is lowered or it becomes insoluble and also film forming property is lowered.

Further an antireflection film prepared by using, as a binder polymer, polyvinyl pyrrolidone developed for the use for KrF is not suitable as an antireflection film material for a ArF resist since polyvinyl pyrrolidone has a high refractive index at an exposure wavelength of ArF excimer laser and a low exposure light transmission.

On the other hand, in order to compensate for those demerits, compositions for an antireflection film prepared

by using a fluorine-containing polymer having sulfonic acid or its amine salt in a side chain thereof (JP2001-194798A, JP2001-200019A) or by using a fluorinated alkylamine salt of carboxylic acid or a perfluoro compound having, as a counter ion, alkanolamine salt (JP2001-133984A) have been developed.

Among them, in the case of fluorine-containing antireflection film materials having sulfonic acid or amine salt thereof in its side chain (JP2001-194798A, JP2001-200019A), there are problems that since acidity of the sulfonic acid or amine salt thereof is too strong, a surface layer portion of a resist pattern is rounded after developing, thereby causing a problem in an etching step; a surface layer portion of an un-exposed portion also undergoes chemical amplification reaction, and a thickness of the un-exposed portion is decreased; and corrosion and rusting of equipment for producing devices arise due to an influence of an acid component, thereby causing defect of products.

On the other hand, in the case of fluorine-containing antireflection film materials prepared by using a perfluoro compound having, as a counter ion, fluorinated alkanolamine salt or alkylamine salt of carboxylic acid (JP2001-133984A), a fluorine content is low and a refractive index being low enough for practical use cannot be obtained. Also there are disadvantages that due to a small amount of hydrophilic groups contained in the monomer, solubility (=dissolution rate) in a resist developing solution and an aqueous solvent is very low, and film forming property is not good.

Also compositions for an antireflection film prepared by using a fluorine-containing polymer having a high content of carboxyl groups are studied (JP11-124531A, JP2004-37887A), but only polymers having a low molecular weight are obtained as a fluorine-containing polymer having carboxyl groups, and studies are made with respect to compositions for an antireflection film for a resist prepared by using such low molecular weight fluorine-containing polymers.

Those low molecular weight fluorine-containing polymers are insufficient in solubility in water, and addition of amines or surfactants is necessary. As a result, there are problems that a refractive index of an antireflection film is decreased and transparency is lowered.

Further in order to make the polymers soluble, it is necessary to mix a large amount of a water soluble organic solvent such as alcohols to water, and as a result, there arises intermixing between the resist layer and the antireflection layer when coating on a resist film and a sufficient reflection reducing effect cannot be obtained.

Accordingly, the present situation is such that materials for an upper antireflection film layer, particularly materials for an upper antireflection film layer for ArF and $F_2$ photoresists which eliminate the mentioned problems and have practical water solubility are desired.

As mentioned above, conventional polymers used for antireflection film materials are high in a refractive index, and a sufficient effect thereof in pattern formation could not be obtained.

On the other hand, conventional materials were insufficient in water solubility even if a refractive index thereof was low. Therefore when forming an antireflection film on a photoresist layer, it was necessary to use an organic solvent for a coating composition containing a polymer. As a result, there arose intermixing between the photoresist layer and the antireflection layer to make an interface between them unclear and effects resulting from a low refractive index could not be exhibited sufficiently. Also solubility in a developing solution (dissolution rate) was insufficient, and in a conventional developing process, the antireflection layer could not be removed and even in a step for removing a resist layer of exposed region in the developing process, there was a case where the antireflection layer could not be smoothly removed.

A problem to be solved in the present invention is to form a laminated resist which has a sufficient reflection reducing effect particularly in a photolithography process using light in a vacuum ultraviolet region by providing, on a photoresist layer, an antireflection film for a resist obtained from a fluorine-containing polymer having a lower refractive index and excellent solubility in a developing solution and also has sufficient developing characteristics even in a developing step of the photolithography process.

DISCLOSURE OF INVENTION

The present inventors have made intensive studies with respect to various fluorine-containing polymers having hydrophilic group, and as a result, have found a fluorine-containing polymer being capable of exhibiting both of a low refractive index and solubility in water or a developing solution (aqueous solution of 2.38 mass-% of tetramethylammonium hydroxide) and also have found that by providing, on a photoresist layer, an antireflection layer obtained from this fluorine-containing polymer, good reflection reducing effect can be exhibited in an exposure process of photolithography and the antireflection layer can be easily removed in a developing process.

Namely, the invention relates to a method of forming a laminated photoresist which comprises the steps of:(I) forming a photoresist layer (LI) on a substrate, and

(II) forming an antireflection layer (L2) on the photoresist layer (L1) by applying a coating composition comprising a fluorine-containing polymer (A) which has

(i) in a structural unit derived from a fluorine-containing ethylenic monomer having a -COOH group, $\geq$ 0.14 moles

of -COOH groups per 100 g of the polymer (A), which -COOH group has a pKa value of ≥ 11;
(ii) a fluorine content of≥ 50 mass-%, and
(iii) a number average molecular weight of 31,000-750,000.

BRIEF DESCRIPTION OF DRAWING

Fig. 1 is a flow chart for explaining the method of forming the laminated photoresist of the present invention.

BEST MODE FOR CARRYING OUT THE INVENTION

First, the fluorine-containing polymer (A) constituting the antireflection layer (L2) in the method of forming the laminated photoresist of the present invention is explained below.

In the present invention, the fluorine-containing polymer (A) which is used for the antireflection layer (L2) has a -COOH as a hydrophilic group Y. This -COOH group is introduced as a part of a structural unit of the fluorine-containing polymer (A) by polymerizing a fluorine-containing ethylenic monomer having -COOH group.

Namely, it is important for the fluorine-containing polymer to have a repeat unit (structural unit) of a fluorine-containing ethylenic monomer having -COOH group, thereby enabling particularly both of a low refractive index and water solubility or solubility in a developing solution (dissolution rate) to be exhibited and further enabling the obtained thin antireflection film layer to be endowed with a good mechanical strength as a self-supporting film.

It is particularly preferable that among the structural units constituting the fluorine-containing polymer (A), the structural unit having the -COOH group is substantially comprised of only a structural unit obtained by polymerizing a fluorine-containing ethylenic monomer having the -COOH group, thereby enabling a lower refractive index to be achieved while maintaining good water solubility or solubility in a developing solution (dissolution rate).

In the structural unit which is derived from a fluorine-containing ethylenic monomer having the -COOH group and constitutes the fluorine-containing polymer (A), the -COOH group hasa pKa value of ≤ 11.

The acidic OH group in -COOH can have a pKa value of ≤ 11 irrespective of an ambient structure, and the pKa value is concretely ≤ 6, more preferably ≤ 5.

A lower limit of a pKa value of the acidic OH group in the -COOH group is 1, preferably 2, more preferably 3. If the pKa value is too low, depending on kind of the lower photoresist layer (LI), there is a case where too high acid strength or acid diffusion has an adverse effect on a pattern profile and causes an excessive decrease of a thickness of an un-exposed portion.

The -COOH group as a hydrophilic group having -OH group is preferred particularly because of excellent transparency and a low refractive index, and further from the viewpoint of water solubility and solubility in a developing solution.

Particularly -COOH group is useful and preferred especially for an antireflection film in a ArF or KrF photolithography process since it is excellent in water solubility and solubility in a developing solution and has transparency at a wavelength of not less than 193 nm.

A fluorine content of the fluorine-containing polymer (A) used for the antireflection layer (L2) of the present invention is not less than 50 mass-%. When the fluorine content is less than 50 mass-% in a photolithography process using light of ≤ 200 nm in a vacuum ultraviolet region at exposing, a refractive index measured at such a wavelength becomes too high. As a result, a reflection reducing effect cannot be obtained sufficiently, and an effect of decreasing an adverse influence on a resist pattern due to a standing wave effect and a multiple reflection effect becomes insufficient.

The fluorine content of the fluorine-containing polymer (A) is preferably ≥ 55 mass-%, more preferably ≥ 57.5 mass-%, which is preferred since it is possible to obtain a refractive index, for example, at 193 nm of ≤ 1.46, particularly ≤ 1.44, further ≤ 1.42.

An upper limit of the fluorine content is 70 mass-%, preferably 65 mass-%, more preferably 62.5 mass-%, especially 60 mass-%. If the fluorine content is too high, water repellency of the formed film becomes too high and there is a case where a dissolution rate in a developing solution is decreased and repeatability of the dissolution rate is lowered.

Further in the present invention, it is important to use, for the antireflection layer (L2), a fluorine-containing polymer having a specific content or more of -COOH group, namely, a fluorine-containing polymer having -COOH group content higher than that of conventional polymers.

Concretely the number of moles of the -COOH group in 100 g of the fluorine-containing polymer (A) is ≥ 0.14, which gives good water solubility and good solubility in a developing solution (dissolution rate) and enables the polymer to be put into practical use.

If the number of moles of the -COOH group in 100 g of the fluorine-containing polymer (A) is less than 0.14, the polymer becomes insoluble in water or in a developing solution, or even if the polymer dissolves in a developing solution, a dissolution rate at the developing process is low and practicability of the polymer in a photolithography process becomes insufficient.

The number of moles of the -COOH group in 100 g of the fluorine-containing polymer (A) is not less than 0.21, more preferably not less than 0.22.

An upper limit of the content (the number of moles) of -COOH group is 0.5, more preferably 0.45, further preferably 0.4 in 100 g of the fluorine-containing polymer (A). If the content of -COOH group is too high, there is a case where transparency in a vacuum ultraviolet region is lowered and a refractive index is increased.

Particularly, if its content is increased too much, there is a high tendency that at a wavelength of 193 nm, transparency is lowered and a refractive index becomes worse (is increased). The number of moles of -COOH groups in 100 g of the polymer is preferably 0.14-0.40, more preferably 0.21-0.29, particularly preferably 0.22-0.28. When the content of - COOH groups is in the above-mentioned range, it is possible to achieve good water solubility, a low refractive index and good transparency of the fluorine-containing polymer.

Also the present inventors have made studies regarding further enhancement of water solubility of the above-mentioned fluorine-containing polymer having high contents of -COOH group and fluorine, and as a result, have found that the fluorine-containing polymer having a specific number average molecular weight has good water solubility.

As a result, even in the case of dissolving the polymer in a solvent mixture of water and alcohol solvent, a mixing ratio of the alcohol solvent can be reduced, and it is possible to prevent lowering of a reflection reducing effect which arises due to intermixing at an interface when overcoating the coating composition on the resist film.

Further it was found out that when a composition is prepared by using water, water solubility can be maintained stably when storing for a long period of time. Also it was found out that good solubility is exhibited in the case of adding an acidic substance, surfactant, organic solvent and other additives.

Namely, a number average molecular weight of the above-mentioned fluorine-containing polymer having -COOH group is 31,000-750,000, preferably 31,000-500,000, more preferably 31,000-300,000, particularly preferably 40,000-200,000.

If the number average molecular weight is too low, water solubility is lowered. Even if the polymer can be dissolved in water, stability of the aqueous solution becomes insufficient, and also the fluorine-containing polymer is partially subject to sedimentation, precipitation or turbidity in white during storing or by adding additives.

On the other hand, if the number average molecular weight is too high, film forming property of the antireflection film is lowered, which is not preferred.

In the method of forming a laminated photoresist of the present invention, when the fluorine-containing polymer (A) satisfying the above-mentioned requirements with respect to kind (i) and content (iii) of the -COOH group and fluorine content (ii) is used for the antireflection layer (L2), the laminated photoresist can be practically applicable to conventional photoresist processes and can decrease an adverse effect on a resist pattern due to a standing wave effect and multiple reflection effect.

The first of the preferred examples of the fluorine-containing polymer (A) having hydrophilic group is a fluorine-containing polymer represented by the formula -(M1)-(N1)-(M-1), wherein

M1 is a structural unit derived from a fluorine-containing monomer of formula (1):

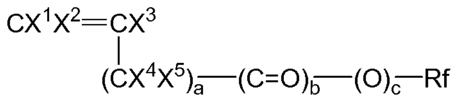

(1)

wherein

$X^1$ and $X^2$ each independently are H or F;
$X^3$ is H, F, Cl, $CH_3$ or $CF_3$;
$X^4$ and $X^5$ each independently are H or F;
Rf is a monovalent organic group in which 1-4 hydrophilic groups Y are bonded to a fluorine-containing $C_{1-40}$-alkyl group or a monovalent organic group in which 1-4 hydrophilic groups Y are bonded to a fluorine-containing $C_{2-100}$-alkyl group having ether bond; and
a, b and c each independently are 0 or 1,

N1 is a structural unit derived from a monomer copolymerizable with the monomer of formula (1), and
the structural units M1 and N1 are contained in amounts of 30-100 mol-% and 0-70 mol-%, respectively.

The fluorine-containing monomer of the formula (1) is characterized by having a monovalent organic group Rf containing a fluorine-containing alkyl group in its side chain and having 1- 4 -COOH groups bonded to the Rf group. Since the monomer itself contains the - COOH groups and many fluorine atoms, a low refractive index, water solubility

and solubility in a developing solution can be given to the polymer obtained from such a monomer.

Rf in the fluorine-containing monomer of the formula (1) is preferably a fluorine-containing $C_{1-40}$-alkyl group in which 1-4 -COOH groups are bonded or a fluorine-containing $C_{2-100}$-alkyl group having ether bond in which 1-4 -COOH groups are bonded. Usually Rf having one -COOH group is preferred.

Also preferred as the Rf is $C_{1-40}$-perfluoroalkyl in which -COOH group is bonded or $C_{2-100}$-perfluoroalkyl having ether bond in which -COOH is bonded, from the point that a refractive index of the polymer can be decreased more.

The fluorine-containing monomer of the formula (1) is preferred because polymerizability thereof is good and homopolymerization thereof or copolymerization with other fluorine-containing ethylenic monomer is possible.

The first preferred example of the fluorine-containing ethylenic monomer of the formula (1) having the hydrophilic group Y is a monomer represented by the formula (2):

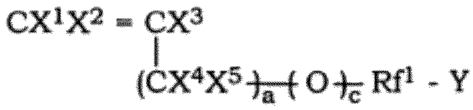 (2)

wherein $X^1$, $X^2$, $X^3$, $X^4$, $X^5$, a, c and the -COOH group Y are as defined in the formula (1); $Rf^1$ is a divalent fluorine-containing $C_{1-40}$-alkylene group or a divalent fluorine-containing $C_{2-100}$-alkylene group having ether bond. The fluorine-containing ethylenic monomer of the formula (2) is preferred because polymerizability thereof is good and homopolymerization or copolymerization with other fluorine-containing ethylenic monomer is possible.

Examples of the fluorine-containing ethylenic monomer (2) having a -COOH group Y are those of formula (2-1) wherein $Rf^1$ is as defined in the formula (2):

**$CH_2$=CFCF2-O-$Rf^1$-Y (2-1)**

The monomers of the formula (2-1) are concretely fluorine-containing ethylenic monomers represented by:

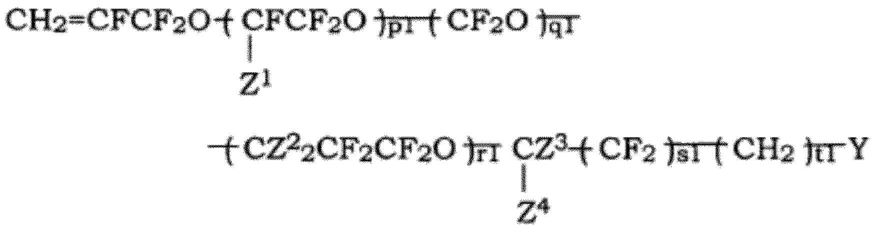

wherein $Z^1$ is F or $CF_3$; $Z^2$ and $Z^3$ are H or F; $Z^4$ is H, F or $CF_3$; p1 + q1 + r1 is an integer of 0-10; s1 is 0 or 1; t1 is an integer of 0-5; when both of $Z^3$ and $Z^4$ are H, p1 + q1 + r1 + s1 is not 0. Those monomers are preferred because homopolymerizability thereof is excellent and more - COOH groups Y can be introduced to the fluorine-containing polymer, thereby enabling a low refractive index and excellent water solubility and solubility in a developing solution to be imparted to the antireflection layer (L2).

Also those monomers have high copolymerizability with fluorine-containing ethylene such as tetrafluoroethylene or vinylidene fluoride and can impart a low refractive index to the antireflection layer (L2).

Further examples thereof are:

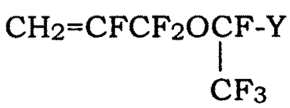 , 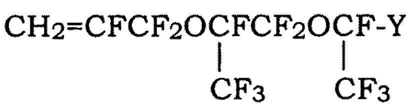 ,

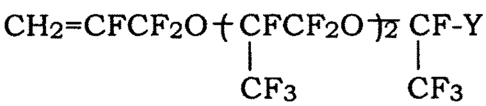 , 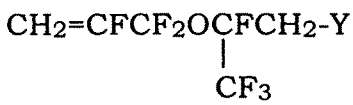 ,

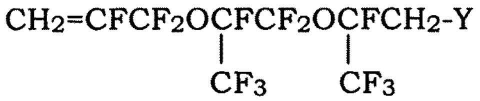,

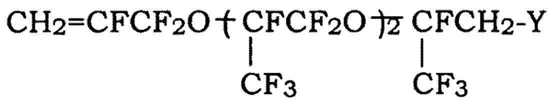,

$CH_2$=$CFCF_2OCH_2CF_2$-Y,

$CH_2$=$CFCF_2O(CH_2CF_2CF_2O)CH_2CF_2$-Y,

$CH_2$=$CFCF_2OCH_2CF_2CH_2$-Y,

$CH_2$=$CFCF_2O(CH_2CF_2CF_2O)CH_2CF_2CH_2$-Y,

$CH_2$=$CFCF_2OCF_2CF_2$-Y,

$CH_2$=$CFCF_2O(CH_2CF_2CF_2O)CF_2CF_2$-Y,

$CH_2$=$CFCF_2OCF_2CF_2CH_2$-Y,

$CH_2$=$CFCF_2O(CH_2CF_2CF_2O)CF_2CF_2CH_2$-Y,

$CH_2$=$CFCF_2OCF_2$-Y, $CH_2$=$CFCF_2O(CF_2CF_2O)CF_2$-Y,

$CH_2$=$CFCF_2OCF_2CH_2$-Y, $CH_2$=$CFCF_2O(CF_2CF_2O)CF_2CH_2$-Y

Among them, preferred are:

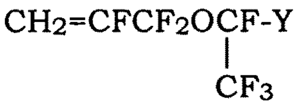, 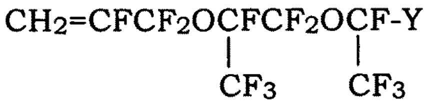,

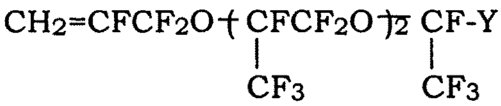, 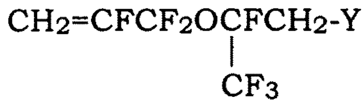,

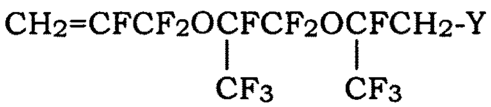,

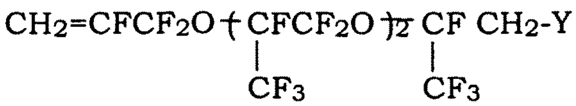,

Further examples of the fluorine-containing monomer of the formula (2) having the - COOH group Y are fluorine-containing ethylenic monomers of formula (2-2) wherein $Rf^1$ is as defined in the formula (2):

$CF_2$-CF-O-$Rf^1$-Y (2-2)

The monomers of the formula (2-2) are concretely fluorine-containing ethylenic monomers represented by:

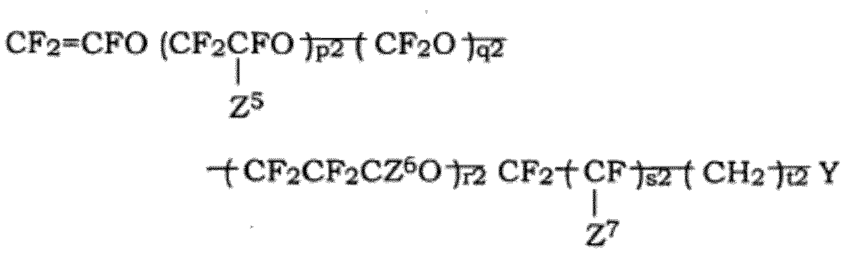

wherein $Z^5$ is F or $CF_3$; $Z^6$ is H or F; $Z^7$ is H or F; p2 + q2 + r2 is an integer of 0-10; s2 is 0 or 1; t2 is an integer of 0-5. Those monomers are have high copolymerizability with fluorine-containing ethylene such as tetrafluoroethylene or vinylidene fluoride and can impart a low refractive index to the antireflection layer (L2).

Further examples of the monomer of the formula (2-2) are:

$CF_2=CFOCF_2CF_2-Y$ , 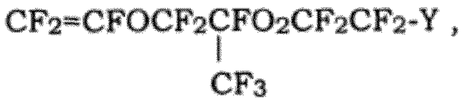

$CF_2-CFOCF_2CF_2CF_2-Y$, $CF_2=CFOCF_2CF_2CH_2-Y$,

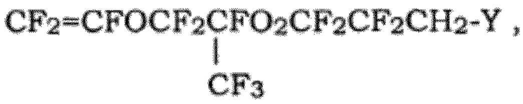

$CF_2-CFOCF_2CF_2CF_2CH_2-Y$, $CF_2-CFOCF_2CF_2OCF_2-Y$,

$CF_2-CFOCF_2CF_2CF_2OCF_2CF_2-Y$,

$CF_2=CFOCF_2CF_2CH_2OCF_2CF_2-Y$,

$CF_2-CFOCF_2CF_2OCF_2CH_2-Y$,

$CF_2-CFOCF_2CF_2CF_2OCP_2CF_2CH_2-Y$,

$CF_2-CFOCF_2CF_2CH_2OCF_2CF_2CH_2-Y$

Examples of other fluorine-containing ethylenic monomer of the formula (2) having -COOH group Y are:

$CF_2=CFCF_2-O-Rf^1-Y$, $CF_2=CF-Rf^1-Y$,

$CH_2=CF-Rf^1-Y$ and $CH_2-CH-O-Rf^1-Y$,

wherein $Rf^1$ is as defined in the formula (2), and there are concretely:

$CF_2=CFCF_2OCF_2CF_2CF_2-Y$,

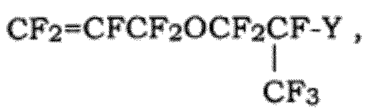

$CF_2=CFCF_2OCF_2CF_2CF_2CH_2-Y$,

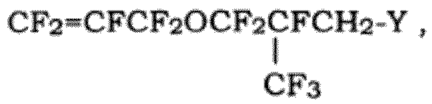

$CF_2$=$CFCF_2$-Y, $CF_2$=$CFCF_2CH_2$-Y, $CH_2$=$CHCF_2CF_2CH_2CH_2$-Y,

$CH_2$=$CHCF_2CF_2$-Y, $CH_2$=$CHCF_2CF_2CH_2$-Y,

$CH_2$=$CHCF_2CF_2CF_2CF_2$-Y, $CH_2$-$CHCF_2CF_2CF_2CF_2CH_2$-Y,

$CH_2$-$CHOCH_2CF_2CF_2$-Y, $CH_2$-$CHOCH_2CF_2CF_2CH_2$-Y

The fluorine-containing polymer of the formula (M-1) to be used for the antireflection layer (L2) of the present invention may be a homopolymer of the fluorine-containing monomer of the formula (1) having the -COOH group or a copolymer thereof with other monomer.

In the case of a homopolymerizable monomer among the monomers of the formula (1), the homopolymer is more preferred since a dissolution rate of the antireflection layer (L2) in a developing solution can be increased.

In the case of a copolymer, the structural unit (N1) as a copolymerizable component can be selected optionally, but is preferably so selected as to set a refractive index low within a range of maintaining solubility in a developing solution. Concretely the structural unit (N1) is selected from structural units derived from fluorine-containing ethylenic monomers.

Particularly preferred are those selected from the following structural units (N1-1) and (N1-2).

(N1-1) Structural unit derived from a fluorine-containing ethylenic monomer having 2 or 3 carbon atoms and at least one fluorine atom:

This structural unit N1-1 is preferred because a refractive index can be effectively decreased and transparency can be improved without lowering solubility in a developing solution, and also because a strength of the antireflection layer can be improved.

Concrete examples are $CF_2$=$CF_2$, $CF_2$=CFCl, $CH_2$=$CF_2$, CFH=$CH_2$, CFH=$CF_2$, $CF_2$=$CFCF_3$, $CH_2$=$CFCF_3$ and $CH_2$=$CHCF_3$. Among them, preferred are tetrafluoroethylene ($CF_2$=$CF_2$), chlorotrifluoroethylene ($CF_2$=CFCl) and vinylidene fluoride ($CH_2$=$CF_2$) from the viewpoint of good copolymerizability and high effects of imparting transparency and a low refractive index.

(N1-2) Structural unit derived from a monomer of formula (n1-2):

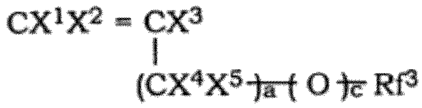 (n1-2)

wherein $X^1$, $X^2$, $X^3$, $X^4$, $X^5$, a and c are as defined in the formula (1);

$Rf^3$ is a fluorine-containing $C_{1-40}$-alkyl group or a fluorine-containing $C_{2-100}$-alkyl group having ether bond.

This structural unit is preferred since a refractive index can be effectively decreased and transparency can be improved effectively. Preferred are:

$CH_2$=$CFCF_2$-O-$Rf^3$, $CF_2$-CF-O-$Rf^3$, $CF_2$=$CFCF_2$-O-$Rf^3$,

$CF_2$=CF-$Rf^3$, $CH_2$-CH-$Rf^3$, $CH_2$-CH-O-$Rf^3$

wherein $Rf^3$ is as defined in the formula (n1-2).

The proportion of each structural unit in the fluorine-containing polymer of the formula is optionally selected depending on the above-mentioned preferable fluorine content and hydrophilic group content. The structural units M1 and N1 are contained in amounts of preferably 30-100 mol-% and 0-70 mol-%, further preferably 40-100 mol-% and 0-60 mol-%, more preferably 50-100 mol-% and 0-50 mol-%, especially preferably 60-100 mol-% and 0-40 mol-%, respectively.

The number average molecular weight of the fluorine-containing polymer of the formula is 31,000-750,000, preferably up to 200,000, more preferably up to 100,000, particularly preferably up to 50,000.

If the molecular weight is too low, there is a case where there arise problems that a strength of the antireflection layer (L2) becomes too low and the fluorine-containing polymer itself penetrates into the lower photoresist layer (L1). Also there is a case where film forming property of the antireflection layer is lowered and as a result, formation of a uniform thin film becomes difficult.

The second of the preferred fluorine-containing polymer (A) to be used for the antireflection layer (L2) of the present invention is represented by the formula -(M2)-(N2)- (M-2), wherein

M2 is a structural unit derived from a fluorine-containing monomer of formula (4):

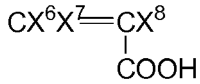

(4)

wherein $X^6$ and $X^7$ each independently are H or F; $X^8$ is H, F, Cl, $CH_3$ or $CF_3$; at least one of $X^6$-$X^8$ contains F;

N2 is a structural unit derived from a monomer copolymerizable with the monomer of formula (4); and

the structural units M2 and N2 are contained in amounts of 10-100 mol-% and 0-90 mol-%, respectively.

This fluorine-containing polymer contains, as a component for imparting water solubility and solubility in a developing solution, a structural unit derived from a fluorine-containing acrylic acid which is a fluorine-containing monomer having -COOH group Y. This polymer is preferred particularly from the viewpoint of excellent water solubility and solubility in a developing solution.

Examples of the fluorine-containing monomer of the formula (4) are:

$CH_2$=CF-COOH , $CF_2$=CF-COOH ,

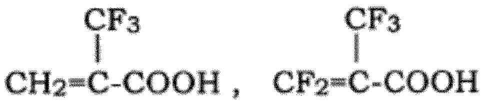

and particularly preferred are:

$CH_2$=CF-COOH and 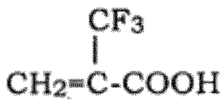

from the viewpoint of goof polymerizability.

The fluorine-containing polymer (M-2) to be used for the antireflection layer (L2) of the present invention may be a homopolymer of the fluorine-containing monomer of the formula (4), but it is usually preferable that the polymer contains the optional structural unit N2 by copolymerization.

The structural unit N2 of copolymerizable component can be selected optionally, but is preferably so selected as to set a refractive index low within a range of maintaining solubility in a developing solution. The structural unit N2 is concretely selected from structural units of the following fluorine-containing ethylenic monomers.

(N2-1) Structural unit derived from a fluorine-containing acrylate monomer:

Concretely preferred are structural units derived from fluorine-containing acrylate monomers represented by the formula (n2-1):

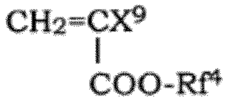

(n2-1)

wherein $X^9$ is H, F or $CH_3$; $Rf^4$ is a fluorine-containing $C_{1-40}$-alkyl group or a fluorine-containing $C_{2-100}$-alkyl group having ether bond. Those monomers are preferred since copolymerizability with the fluorine-containing monomer of the formula (4) is high and a low refractive index can be imparted to the fluorine-containing polymer.

In the fluorine-containing acrylate of the formula (n2-1), examples of $Rf^4$ group are:

$$-(CH_2)_{d1}-(CF_2)_{e1}-Z^8$$

($Z^8$ is H, F or Cl; d1 is an integer of 1-4; e1 is an integer of 1-10),

$-CH(CF_3)_2$,

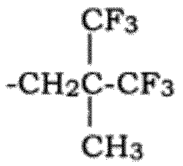 , 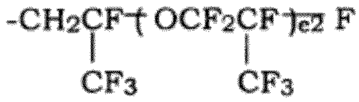

(e2 is an integer of 1-5),

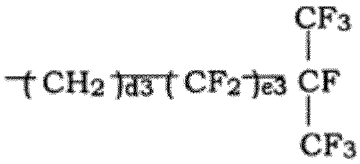

(d3 is an integer of 1 to 4; e3 is an integer of 1-10).
(N2-2) Structural unit derived from a fluorine-containing vinyl ether monomer:
Concretely preferred are structural units derived from fluorine-containing vinyl ethers of formula (n2-2):

$CH_2=CHO-Rf^5$ (n2-2)

wherein $Rf^5$ is a fluorine-containing $C_{1-40}$-alkyl group or a fluorine-containing $C_{2-100}$-alkyl group having ether bond. Those monomers are preferred since copolymerizability with the fluorine-containing monomer of the formula (4) is high and a low refractive index can be imparted to the fluorine-containing polymer.

Preferred examples of the monomer of the formula (n2-2) are:

$$CH_2=CHOCH_2-(CF_2)_{e4}-Z^9$$

($Z^9$ is H or F; e4 is an integer of 1-10),

$$CH_2=CHOCH_2CH_2-(CF_2)_{e5}-F$$

(e5 is an integer of 1-10),

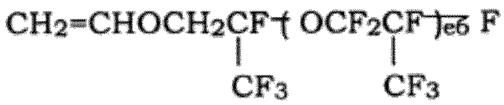

(e6 is an integer of 1-10).
More concrete examples are structural units derived from the following monomers:

$CH_2=CHOCH_2CF_2CF_2H$,

$CH_2=CHOCH_2\text{-}(CF_2CF_2)_2\text{-}H$ ,

$CH_2=CHOCH_2\text{-}(CF_2CF_2)_3\text{-}H$ ,

$CH_2=CHOCH2CF_2CF_3$,
$CH_2=CHOCH_2CF_3$,

$CH_2=CHOCH_2CH_2\text{-}(CF_2CF_2)_4\text{-}F$ ,

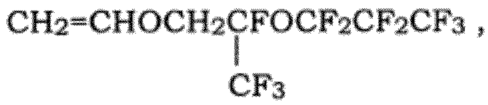

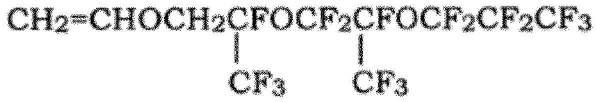

Also there are the following structural units (N2-3) and (N2-4).

(N2-3) Structural unit derived from a fluorine-containing allyl ether of formula (n2-3):

$CH_2\text{-}CHCH_2O\text{-}Rf^6$ (n2-3)

(N2-4) Structural unit derived from a fluorine-containing vinyl monomerof formula (n2-4):

$CH_2=CH\text{-}Rf^7$ (n2-4)

wherein $Rf^6$ and $Rf^7$ area fluorine-containing $C_{1\text{-}40}$-alkyl group or a fluorine-containing $C_{2\text{-}100}$-alkyl group having ether bond.

Those structural units are preferred since a low refractive index can be given to the fluorine-containing polymer.
Examples of the monomers (n2-3) and (n2-4) are:

$CH_2=CHCH_2OCH_2CF_2CF_2H$,

$CH_2=CHCH_2OCH_2\text{-}(CF_2CF_2)_2\text{-}H$,

$CH_2=CHCH_2OCH_2\text{-}(CF_2CF_2)_3\text{-}H$,

$CH_2=CHCH_2OCH_2CF_2CF_3$,

$CH_2\text{-}CHCH_2OCH_2CF_3$,

$CH_2=CHCH_2OCH_2CH_2\text{-}(CF_2CF_2)_4\text{-}F$,

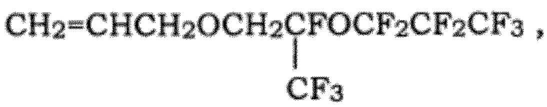

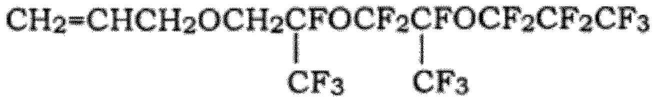

$CH_2=CH-(CF_2CF_2)_2-F$,

$CH_2=CH-(CF_2CF_2)_4-F$

The proportion of each structural unit in the fluorine-containing polymer of the formula (M-2) is optionally selected depending on the above-mentioned preferred fluorine content and hydrophilic group content. The structural units M2 and N2 are contained in amounts of preferably 10-100 mol-% and 0-90 mol-%, further preferably 20-80 mol-% and 20-80 mol-%, more preferably 30-70 mol-% and 30-70 mol-%, especially preferably from 40-60 mol-% and 40-60 mol-%, respectively.

If the proportion of the structural unit (M2) is too low, water solubility and solubility in a developing solution become insufficient, and if the proportion of the structural unit (M2) is too high, a refractive index becomes too high. Therefore the both cases are not preferred.

The number average molecular weight of the fluorine-containing polymer of the formula (M-2) is 31,000-750,000, preferably up to 200,000, more preferably up to 100,000, particularly preferably up to 50,000.

If the molecular weight is too low, there is a case where there arise problems that a strength of the antireflection layer (L2) becomes too low and the fluorine-containing polymer itself penetrates into the lower photoresist layer (L1). Also there is a case where film forming property of the antireflection layer is lowered and as a result, formation of a uniform thin film becomes difficult.

Preferred examples of the fluorine-containing polymer (A) to be used for the antireflection layer (L2) of the present invention are fluorine-containing polymers represented by the following formulae (M-1-1) and (M-2-1).

Fluorine-containing polymer which has a number average molecular weight of 31,000-200,000 and is represented by the formula -(M1-1)- (M-1-1),
wherein M1-1 is a structural unit derived from a monomer of formula (2-1):

$CH_2=CFCF_2-O-Rf^1-Y$ (2-1)

in which $Rf^1$ is as defined in the formula (2). Namely, the fluorine-containing polymer (A) is a fluorine-containing allyl ether homopolymer containing one or more monomers selected from the monomers of the formula (2-1). This polymer is preferred since both of a high fluorine content and a high hydrophilic group content can be obtained, thereby giving a low refractive index and excellent solubility in a developing solution.

Fluorine-containing polymer which has a number average molecular weight of from 1,000 to 200,000 and is represented by the formula -(M2)-(N2-2)- (M-2-1),
wherein M2 is a structural unit derived from a monomer of formula (4):

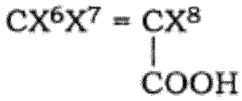

(4)

wherein $X^6$, $X^7$ and $X^8$ are as defined in the formula (4) explained supra,
the structural unit N2-2 is a structural unit derived from a monomer of formula (n2-2):

$CH_2-CHO-Rf^5$ (n2-2)

in which $Rf^5$ is as defined in the formula (n2-2) explained supra, and the structural units M2 and N2-2 are contained in amounts of 30-70 mol-% and 30-70 mol-%, respectively.

Preferred monomers for the structural unit M2 are those exemplified supra in the monomers of the formula (4). Particularly preferred are structural units derived from monomers selected from:

$CH_2=CF-COOH$ and 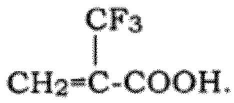.

Preferred monomers for the structural unit N2-2 are those exemplified supra in the monomers of the formula (n2-2). Particularly preferred are structural units derived from monomers represented by:

$$CH_2=CHOCH_2-(CF_2)_{e4}-Z^9$$

wherein $Z^9$ is H or F; e4 is an integer of 1-10.

Those polymers are preferred particularly because of excellent water solubility and solubility in a developing solution.

In the method of forming the laminated photoresist of the present invention, the antireflection layer (L2) is formed on the previously formed photoresist layer (L1) by applying the coating composition containing the above-mentioned fluorine-containing polymer (A).

The coating composition for forming the antireflection layer (L2) contains:

(A) the fluorine-containing polymer having the -COOH group Y and
(B) at least one solvent selected from water and alcohols.

It is preferable that the solvent (B) is selected from solvents which do not re-dissolve the previously formed lower photoresist layer (L1) when the coating composition is applied. From this point of view, the solvent (B) is preferably water and/or alcohols.

The fluorine-containing polymer (A) of the present invention has good solubility in those water and alcohols.

Among the solvents (B), water is not limited particularly. Preferred are distilled water, ion exchange water, water subjected to filtration and water subjected to adsorption treatment to remove organic impurities and metal ion.

Alcohols are optionally selected from those which do not re-dissolve the photoresist layer (LI), depending on kind of the photoresist layer (L1). Generally lower alcohols are preferred, and concretely methanol, ethanol, isopropanol and n-propanol are preferred.

In addition to the solvent (B), a water soluble organic solvent may be used together for the purpose of e.g. improving coatability, within a range not re-dissolving the photoresist layer (L1).

A water soluble organic solvent is not limited particularly as far as it dissolves in water in an amount of $\geq 1$ mass-%. Preferred examples thereof are, for instance, ketones such as acetone and methyl ethyl ketone; esters of acetic acids such as methyl acetate and ethyl acetate; polar solvents such as dimethylformamide, dimethyl sulfoxide, methyl cellosolve, cellosolve acetate, butyl cellosolve, butyl carbitol and carbitol acetate.

An adding amount of the water soluble organic solvent to be added in addition to water or alcohol is 0.1-50 mass-%, preferably 0.5-30 mass-%, more preferably 1-20 mass-%, particularly preferably 1-10 mass-% based on the total amount of the solvent (B).

To the coating composition forming the antireflection layer (L2) of the present invention may be added, as case demands, at least one selected from basic substances, for example, ammonia and organic amines. In this case, there is a case where a -COOH group having a pKa value of $\leq 11$ may be a hydrophilic moiety in the form of derivative, for example, ammonium salt, amine salt or the like in the coating composition.

Especially, the addition of the basic substance is effective for enhancing water solubility and solubility in a developing solution and also for maintaining repeatability of a dissolution rate in a developing solution. Also it is effective for adjusting the pH value of the coating composition to be within an optimum range.

With respect to the organic amines, preferred are water soluble organic amine compounds. Preferred examples thereof are, for instance, primary amines such as methylamine, ethylamine, propylamine, butylamine and cyclohexylamine; secondary amines such as dimethylamine, diethylamine, dipropylamine and dibutylamine; tertiary amines such as trimethylamine, triethylamine, tripropylamine, tributylamine, pyridine, pyrrole, piperidine, oxazole and morpholine; hydroxylamines such as monoethanolamine, propanolamine, diethanolamine, triethanolamine and tris(hydroxymethyl)aminomethane; quaternary ammonium compounds such as tetramethylammonium hydroxide, tetraethylammonium hydroxide, tetrapropylammonium hydroxide and tetrabutylammonium hydroxide; primary, secondary and tertiary polyamines such as ethylenediamine, diethylenediamine, tetraethylenediamine, pyrazine and s-triazine.

Among them, from the point of maintaining a low refractive index and increasing a dissolution rate in a developing solution, preferred are hydroxylamines such as monoethanolamine, propanolamine, diethanolamine, triethanolamine

and tris(hydroxymethyl)aminomethane, and particularly preferred is monoethanolamine.

In the coating composition, ammonia or organic amine can be added usually in an amount of 0.01-10 mole, preferably 0.1-5 mole, more preferably 0.5-1 mole based on 1 mole of hydrophilic group of the fluorine-containing polymer (A) to be used.

To the coating composition forming the antireflection layer (L2) of the present invention may be added, as case demands, a known surfactant.

The addition of a surfactant is effective for improving wettability of the coating composition to the surface of the lower photoresist layer (L1) and for forming a uniform thin film, and further is preferred for decreasing a surface tension of the obtained antireflection layer (L2) after the coating, thereby resulting in stabilization of solubility in a developing solution. Further the addition of surfactant is preferred for preventing striation.

Examples of the surfactant to be added are nonionic surfactants, anionic surfactants and ampholytic surfactants, and anionic surfactants are used preferably.

Examples of nonionic surfactants are polyoxyethylene alkyl ethers, for instance, polyoxyethylene lauiyl ether, polyoxyethylene stearyl ether, polyoxyethylene oleyl ether, polyoxyethylene cetyl ether, polyoxyethylene octyl phenyl ether, polyoxyethylene nonyl phenyl ether, polyethylene glycol dilaurate and polyethylene glycol distearate; polyoxyethylene fatty acid diester, polyoxy fatty acid monoester, polyoxyethylene/polyoxypropylene block polymer and acetylene glycol derivative.

Examples of the anionic surfactants are alkyl diphenylether disulfonic acid and its ammonium salt or organic amine salt; alkyl diphenylether sulfonic acid and its ammonium salt or organic amine salt; alkylbenzene sulfonic acid and its ammonium salt or organic amine salt; polyoxyethylene alkyl ether sulfuric acid and its ammonium salt or organic amine salt; alkyl sulfuric acid and its ammonium salt or organic amine salt.

Examples of ampholytic surfactants are 2-alkyl-N-carboxymethyl-N-hydroxyethyl imidazolinium betaine and lauric acid amidopropylhydroxysulfone betaine.

Also fluorine-containing surfactants are preferred because a low refractive index of the antireflection layer (L2) can be maintained. Examples thereof are:

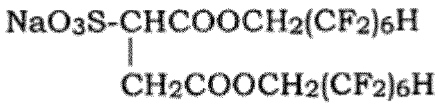 ,

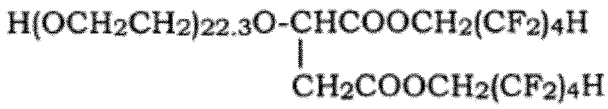 ,

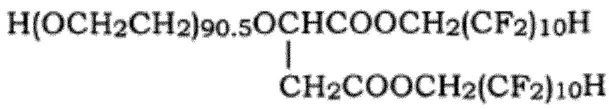 ,

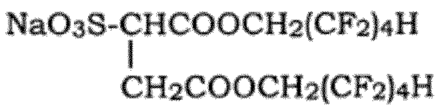 ,

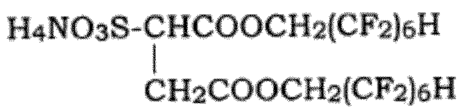 ,

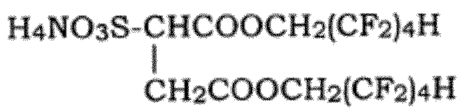 ,

$H(CF_2CF_2)_5$-COONa, $F_3C$-$(CF_2)_7$-$SO_3K$,
H-$(CF_2)_6$-$CH_2$-$OSO_3Na$,

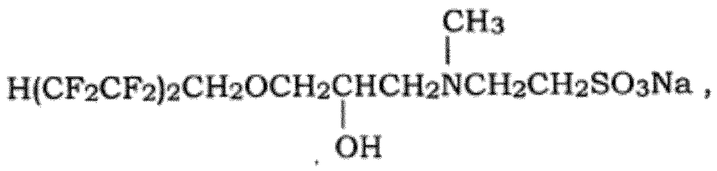

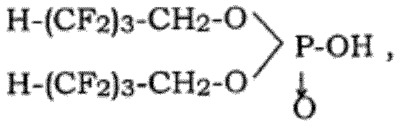

$H(CF_2CF_2)_5$-$COONH_4$, $F_3C$-$(CF_2)7$-$SO_3NH_4$,
H-$(CF_2)_6$-$CH_2$-$OSO_3NH_4$,

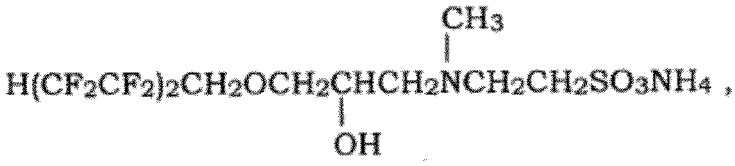

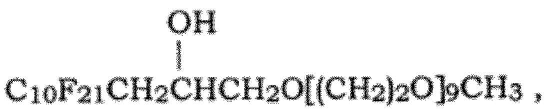

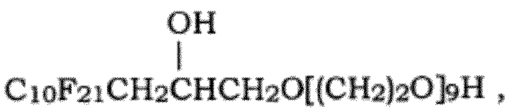

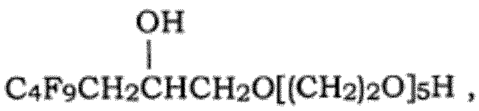

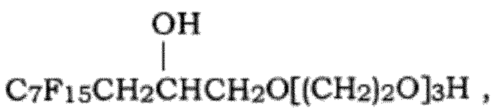

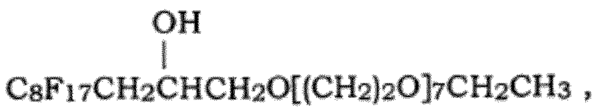

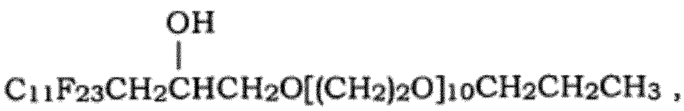

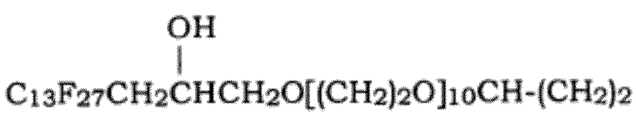

,

With respect to the fluorine-containing surfactants, not only the above-mentioned low molecular weight compounds but also the following high molecular weight compounds are preferred because a low refractive index of the antireflection layer (L2) can be maintained.

There are concretely copolymers having a number average molecular weight of 1,000-500,000 and containing component units derived from (a) acrylic ester or methacrylic acid ester having fluoroalkyl group (monomer (a)), (b) polyalkylene glycol acrylate or polyalkylene glycol methacrylate (monomer (b)), (c) 3-chloro-2-hydroxypropyl (meth)acrylate (monomer (c)) and (d) glycerol mono(meth)acrylate (monomer (d)), and fluorine-containing polymer surfactants containing such a copolymer.

The monomers providing each component unit are explained below.

Examples of the monomer (a) are, for instance, one or two or more compounds of the formula:

$$Rf^{20}R^{10}OCOCR^{11}=CH_2$$

Wherein $Rf^{20}$ is linear or branched $C_{3-20}$-perfluoroalkyl ; $R^{11}$ is H or methyl; $R^{10}$ is linear or branched $C_{1-10}$-alkylene, $-SO_2N(R^{12})R^{13}$-($R^{12}$ is $C_{1-10}$-alkyl; $R^{13}$ is linear or branched $C_{1-10}$-alkylene) or $-CH_2CH(OR^{14})CH_2$-($R^{14}$ is H or $C_{1-10}$-acyl).

Examples of the monomer (a) are as follows. These monomers may be used alone or in a mixture of two or more thereof.

(a-1) $CF_3(CF_2)_n(CH_2)_mOCOCR^{11}=CH_2$ ($R^{11}$ is H or methyl; n is an integer of 2-19, m is an integer of 1-10). Examples thereof are:

$CF_3(CF_2)_7(CH_2)_{10}OCOCH=CH_2$,
$CF_3(CF_2)_7(CH_2)_2OCOCH=CH_2$,
$CF_3(CF_2)_6CH_2OCOC(CH_3)=CH_2$,
$CF_3(CF_2)_7(CH_2)_2OCOC(CH_3)=CH_2$,
$CF_3(CF_2)_9(CH_2)_2OCOC(CH_3)=CH_2$,
$CF_3(CF_2)_{11}(CH_2)_2OCOC(CH_3)=CH_2$,

(a-2) $(CF_3)_2CF(CF_2)_n(CH_2)_mOCOCR^{11}=CH_2$ ($R^{11}$ is H or methyl; n is an integer of 0-17, m is an integer of 1-10). An examples thereof is:
$(CF_3)_2CF(CF_2)_8(CH_2)_2OCOCH=CH_2$

(a-3)

$$CF_3(CF_2)_nSO_2N(R^{12})(CH_2)_mOCOCR^{11}=CH_2$$

($R^{11}$ is H or methyl; $R^{12}$ is $C_{1-10}$-alkyl; n is an integer of 2-19, m is an integer of 1-10). Examples thereof are:

$CF_3(CF_2)_7SO_2N(CH_3)(CH_2)_2OCOCH=CH_2$
$CF_3(CF_2)_7SO_2N(C_2H_5)(CH_2)_2OCOC(CH_3)=CH_2$

(a-4)

$$(CF_3)_2CF(CF_2)_nCH_2CH(OR^{14})(CH_2)_mOCOCR^{11}=CH_2$$

($R^{11}$ is H or methyl; $R^{14}$ is H or $C_{1-10}$-acyl; n is an integer of 0-17, m is an integer of 1-10). Examples thereof are:

$(CF_3)_2CF(CF_2)_8CH_2CH(OCOCH_3)CH_2OCOC(CH_3)=CH_2$,

$(CF_3)_2CF(CF_2)_8CH_2CH(OH)CH_2OCOCH-CH_2$

Preferred examples of the monomer (b) are, for instance, one or two or more compounds of the formula:

$$CH_2=CR^{15}COO-(R^{16}O)_n-R^{17}$$

wherein $R^{15}$ and $R^{17}$ are hH or methyl; $R^{16}$ is $C_{2-6}$-alkylene, n is an integer of 3-50.

Usually $-CH_2CH_2-$ is suitable as $R^{16}$. $R^{16}$ may be, for example, $-CH(CH_3)CH_2-$ or - $CH(C_2H_5)CH_2-$ . Namely,

in the present invention, polyethylene glycol acrylate or methacrylate in which $R^{16}$ is $-CH_2CH_2-$ can be used particularly preferably. Also, n is selected from integers of 3-50, and usually when n is selected from integers of 9-25, especially good result can be obtained. It is a matter of course that the monomer (b) may be in the form of a mixture of two or more monomers having different kind of $R^{16}$ and different number of n.

Examples of the monomer (b) are as follows. These monomers may be used alone or in a mixture of two or more thereof.

(b-1)

$$CH_2=CR^{15}COO(CH_2CH_2O)_nR^{17}$$

($R^{15}$ and $R^{17}$ are H or methyl; n is an integer of 3-50). Examples thereof are:

$CH_2=C(CH_3)COO(CH_2CH_2O)_3H$,

$CH_2=C(CH_3)COO(CH_2CH_2O)_6H$,

$CH_2=C(CH_3)COO(CH_2CH_2O)_9H$,

$CH_2=C(CH_3)COO(CH_2CH_2O)_{40}H$,

$CH_2=C(CH_3)COO(CH_2CH_2O)_9CH_3$,

$CH_2=C(CH_3)COO(CH_2CH_2O)_{23}CH_3$

(b-2)

$$CH_2=CR^{15}COO(CH_2CH(CH_3)O)_nR^{17}$$

($R^{15}$ and $R^{17}$ are H or methyl; n is an integer of 3-50). Examples thereof are:

$CH_2=C(CH_3)COO(CH_2CH(CH_3)O)_{12}H$,

$CH_2=CHCOO(CH_2CH(CH_3)O)_{11}CH_3$

(b-3)

$$CH_2=CR^{15}COO(CH_2CH_2O)_n(CH_2CH(CH_3)O)_mR^{17}$$

($R^{15}$ and $R^{17}$ are H or methyl; n + m is an integer of 3-50). Examples thereof are:
$CH_2=C(CH_3)COO(CH_2CH_2O)_5(CH_2CH(CH_3)O)_3H$

3-Chloro-2-hydroxypropyl (meth)acrylate of the monomer (c) is 3-chloro-2-hydroxypropyl acrylate and/or 3-chloro-2-hydroxypropyl methacrylate represented by:

$CH_2=CR^{18}COOCH_2CH(OH)CH_2Cl$

wherein $R^{18}$ is H or methyl.

Glycerol mono(meth)acrylate of the monomer (d) is glycerol monoacrylate and/or glycerol monomethacrylate represented by:

$CH_2=CR^{19}COOCH_2CH(OH)CH_2OH$

wherein $R^{19}$ is H or methyl.

In the copolymer to be used in the present invention as a fluorine-containing polymer surfactant, a copolymerization ratio of the (meth)acrylic acid ester (monomer (a)) having fluoroalkyl group is at least 5 mass-%, preferably 6-70

mass-%.

A copolymerization ratio of the polyalkylene glycol (meth)acrylate (monomer (b)) is at least 10 mass-%, preferably from 14-60 mass-%. If the ratio is less than 10 mass-%, dispersibility in water tends to be lowered.

A copolymerization ratio of the 3-chloro-2-hydroxypropyl (meth)acrylate (monomer (c)) is at least 0.5 mass-%, preferably 0.5-30 mass-%. A copolymerization ratio of the glycerol mono (meth)acrylate (monomer (d)) is at least 0.5 mass-%, preferably 0.5-30 mass-%.

It is preferable that a total copolymerization ratio of 3-chloro-2-hydroxypropyl (meth)acrylate (monomer (c)) and glycerol mono(meth)acrylate (monomer (d)) is at least 1 % by mass, preferably 1.2-30 mass-%. Also it is preferable that a ratio of 3-chloro-2-hydroxypropyl (meth)acrylate (monomer (c)) to the sum of monomer (c) and monomer (d) is 10-90 mass-%, particularly 20-80 mass-%.

A number average molecular weight of the fluorine-containing polymer surfactant is 1,000-500,000, preferably 5,000-200,000. If it is less than 1,000, durability tends to be lowered, and if it exceeds 500,000, a viscosity of the surfactant solution becomes high, and there is a case where workability is lowered. The fluorine-containing polymer surfactant may be a random copolymer or a block copolymer.

With respect to those copolymers to be used as the fluorine-containing polymer surfactant, besides the monomers (a), (b), (c) and (d) can be copolymerized a copolymerizable monomer having no fluoroalkyl group such as ethylene, vinyl chloride, halogenated vinylidene, styrene, (meth)acrylic acid, alkyl ester of (meth)acrylic acid, benzyl methacrylate, vinyl alkyl ketone, vinyl alkyl ether, isoprene, chloroprene, maleic anhydride or butadiene. When those other monomers are copolymerized, dispersibility, uniform coatability, water- and oil-repellency and durability can be enhanced and a low refractive index can be obtained. Also other various properties such as solubility and water resistance can be optionally improved. A copolymerization ratio of the comonomer having no fluoroalkyl group is 0-40 mass-%, preferably 0-20 mass-%.

The copolymer suitable as the fluorine-containing polymer surfactant of the present invention contains, for example, the following copolymerizable components, but the composition of the copolymer is not limited to them.

(Composition I)

Copolymer containing:

19-22 parts by mass (pbm) of monomer (a) represented by
$CF_3CF_2(CF_2CF_2)_nCH_2CH_2OCOC(CH_3)=CH_2$ (a mixture of compounds of n=3, n=4 and n=5 in a weight ratio of 5:3:1),
8-13 pbm of monomer (b) represented by $CH_2=C(CH_3)COO(CH_2CH_2O)_9CH_3$,
4-7 pbm of monomer (b) represented by $CH_2=C(CH_3)COO(CH_2CH(CH_3)O)_{12}H$,
3-5 pbm of monomer (c) represented by $CH_2=C(CH_3)COOCH_2CH(OH)CH_2Cl$ and
1-2 pbm of monomer (d) represented by $CH_2=C(CH_3)COOCH_2CH(OH)CH_2OH$.

(Composition II)

Copolymer containing:

8-13 pbm of monomer (a) represented by $CF_3CF_2(CF_2CF_2)_nCH_2CH_2OCOC(CH_3)=CH_2$ (a mixture of compounds of n=3 and n=4 in a weight ratio of 5.4:1),
8-12 pbm of monomer (b) represented by $CH_2=C(CH_3)COO(CH_2CH_2O)_9CH_3$,
4-9 pbm of monomer (b) represented by $CH_2=C(CH_3)C00(CH_2CH(CH_3)O)_{12}H$,
0.5-3 pbm of monomer (c) represented by $CH_2=C(CH_3)COOCH_2CH(OH)CH_2Cl$ and
0.3-2 pbm of monomer (d) represented by $CH_2=C(CH_3)COOCH_2CH(OH)CH_2OH$.

(Composition III)

Copolymer containing:

5-8 pbm of monomer (a) represented by $CF_3CF_2(CF_2CF_2)_nCH_2CH_2OCOC(CH_3)=CH_2$ (a mixture of compounds of n=3 and n=4 in a weight ratio of 3.9:1),
14-17 pbm of monomer (b) represented by $CH_2=C(CH_3)COO(CH_2CH_2O)_9CH_3$,
5-8 pbm of monomer (b) represented by $CH_2=C(CH_3)COO(CH_2CH(CH_3)O)_{12}H$,
0.5-1.5 pbm of monomer (c) represented by $CH_2=C(CH_3)COOCH_2CH(OH)CH_2Cl$ and
0.5-1.5 pbm of monomer (d) represented by $CH_2=C(CH_3)COOCH_2CH(OH)CH_2OH$.

Examples of commercial products of the copolymer are KP341 (trade name available from Shin-Etsu Chemical Co., Ltd.),

POLYFLOW No.75 and POLYFLOW No.95 (trade name available from Kyoeisha Chemical Co., Ltd.), F TOP EF301, EF303, EF352 and EF204 (trade name available from Tokem Products Co., Ltd.), MEGAFAC F171 and F173 (trade name available from Dai-Nippon Ink and Chemicals Incorporated), Fluorad FC430 and FC431 (trade name available from Sumitomo Three M), Asahi Guard AG710, Surfron S-382, SC-101, 5SC-102, SC-103, SC-104, SC-105 and SC-106 (trade name available from Asahi Glass Co., Ltd.) and the like. Those surfactants can be used alone or in a mixture of two or more thereof.

An amount of the surfactant is usually ≤ 100 pbm, preferably ≤ 70 pbm, particularly preferably 0.1-50 pbm based on 100 pbm of the sum of polymer components in the antireflection film material.

To the coating composition forming the antireflection layer (L2) of the present invention may be added, as case demands, a known acid.

The acid is added mainly for the purpose of adjusting a pH value of the coating composition to be ≤ 4, preferably ≤ 3, more preferably ≤ 2.

By forming the antireflection layer (L2) with the acidic coating composition, diffusion and migration of the acid to the antireflection layer (L2) from the photoresist layer (L1) after the exposure can be prevented and the resist pattern profile can be prevented from being in the form of T-top.

With respect to the acid to be used in the present invention, any of an organic acid and inorganic acid may be used. Preferred examples of the organic acid are alkyl sulfonic acid, alkylbenzene sulfonic acid, alkylcarboxylic acid, alkylbebzenecarboxylic acid and partly fluorinated acids thereof. Preferred alkyl groups are those having 1-20 carbon atoms. Those organic acids are used in an amount of usually 0.1-2.0 mass-%, preferably 0.5-1.0mass-% in the composition.

Fluorine-containing organic acids may be fluoroalkylsulfonic acid and fluoroalkylcarboxylic acid having a fluorine chain of perfluoroalkyl group or hydrofluoroalkyl group, and the fluorine chain may be a linear or branched chain.

Examples of the fluoroalkyl group are not only those having 1-4 carbon atoms but also those having 5-15 carbon atoms.

Other examples thereof are 1,1,2,2,3,3,4,4,5,5-decafluoropentyl; 1,1,2,2,3,3,4,4,5,5,6,6-decafluorohexyl, 1,1,2,2,3,3,4,4,5,5,6,6,7,7-tetradecafluoroheptyl, 1,1,2,2,3,3,4,4,5,5,6,6,7,7,8,8-hexadecafluorooctyl; 1,1,2,2,3,3,4,4,5,5,6,6,7,7,8,8,9,9-octadecafluorononyl; 1,1,2,2,3,3,4,4,5,5,6,6,7,7,8,8,9,9,10,10-eicosafluorodecyl; 2-(perfluorononyl)ethyl, 2,2,3,3,4,4,5,5,6,6,7,7,8,8,9,9,10,10,11,11-eicosafluoroundecyl, perfluorodecylmethyl, 1,1,2,2,3,3,4,4,5,5,6,6,7,78,8,9,9,10,10,11,11-docosafluoroundecyl, perfluoroundecyl; 2-(perfluorodecyl)ethyl, 2,2,3,3,4,4,5,5,6,6,7,7,8,8,9,9,10,10,11,11,12,12-docosafluorododecyl, perfluoroundecylmethyl, 1,1,2,2,3,3,4,4,5,5,6,6,7,7,8,8,9,9,10,10,11,11,12,12- tetracosafluorododecyl, perfluorododecyl; 2-(perfluoroundecyl) ethyl, 2,2,3,3,4,4,5,5,6,6,7,7,8,8,9,9,10,10,11,11,12,12,13, 13-tetracosafluorotridecyl, perfluorododecylmethyl, 1,1,2,2,3,3,4,4,5,5,6,6,7,7,8,8,9,9,10,10,11,11,12,12,13,13-hexacosafluorotridecyl, perfluorotridecyl, 2-(perfluorododecyl)ethyl, 2.2.3.3.4.4.5.5.6.6.7.7.8.8.9.9.10.10.11.11.12.12.13.13.14.14-hexacosafluorotetradecyl, perfluorotridecylmethyl, 1.1.2.2.3.3.4.4.5.5.6.6.7.7.8.8.9.9.10.10.11.11.12.12.13.13.14.14-octacosafluorotetradecyl, perfluorotetradecyl, 2-(perfluorotridecyl)ethyl, 2,2,3,3,4,4,5,5,6,6,7,7,8,8,9,9,10,10,11,11,12,12,13,13,14,14,15,15-octacosafluoropentadecyl, perfluorotetradecylmethyl, 1,1,2,2,3,3,4,4,5,5,6,6,7,7,8,8,9,9,10,10,11,11,12,12,13,13,14,14,15,15-triacontafluoropentadecyl and perfluoropentadecyl.

Examples of such a fluoroalkylsulfonic acid are 2-(perfluoropropyl)ethanesulfonic acid, 1,1,2,2,3,3,4,4,5,5-decafluoropentanesulfonic acid, perfluoropentanesulfonic acid; 2-(perfluorobutyl)ethanesulfonic acid, 1,1,2,2,3,3,4,4,5,5,6,6-dodecafluorohexane sulfonic acid, perfluorohexanesulfonic acid, 2-(perfluoropentyl)ethanesulfonic acid, 1,1,2,2,3,3,4,4,5,5,6,6,7,7-tetradecafluoroheptanesulfonic acid, perfluoroheptanesulfonic acid; 2-(perfluorohexyl)ethanesulfonic acid, 1,1,2,2,3,3,4,4,5,5,6,6,7,7,8,8-hexadecafluorooctanesulfonic acid, perfluorooctanesulfonic acid; 2-(perfluoroheptyl)ethanesulfonic acid, 1,1,2,2,3,3,4,4,5,5,6,6,7,7,8,8,9,9-octadecafluorononanesulfonic acid, perfluorononanesulfonic acid; 2-(perfluorooctyl)ethanesulfonic acid, 1,1,2,2,3,3,4,4,5,5,6,6,7,7,8,8,9,9,10,10-eicosafluorodecanesulfonic acid, perfluorodecanesulfonic acid; 2-(perfluorononyl)ethanesulfonic acid, 1,1,2,2,3,3,4,4,5,5,6,6,7,7,8,8,9,9,10,10,11,11- docosafluoroundecanesulfonic acid, perfluoroundecanesulfonic acid; 2-(perfluorodecyl) ethane sulfonic acid, 1,1,2,2,3,3,4,4,5,5,6,6,7,7,8,8,9,9,10,10,11,11,12,12-tetracosafluorododecanesulfonic acid, perfluorododecanesulfonic acid; 2-(perfluoroundecyl)ethanesulfonic acid, 1,1,2,2,3,3,4,4,5,5,6,6,7,7,8,8,9,9,10,10,11,11,12,12,13,13-hexacosafluorotridecanesulfonic acid, perfluorotridecanesulfonic acid; 2-(perfluorododecyl) ethane sulfonic acid, 1,1,2,2,3,3,4,4,5,5,6,6,7,7,8,8,9,9,10,10,11,11,12,12,13,13,14,14-octacosafluorotetradecanesulfonic acid, perfluorotetradecanesulfonic acid; 2-(perfluorotridecyl) ethane sulfonic acid, 1,1,2,2,3,3,4,4,5,5,6,6,7,7,8,8,9,9,10,10,11,11,12,12,13,13,14,14,15,15-triacontafluoropentadecanesulfonic acid and perfluoropentadecanesulfonic acid.

Examples of fluoroalkylcarboxylic acid are 2-(perfluoropropyl)ethanecarboxylic acid, 1,1,2,2,3,3,4,4,5,5-decafluoropentanecarboxylic acid, perfluoropentanecarboxylic acid; 2-(perfluorobutyl)ethanecarboxylic acid, 1,1,2,2,3,3,4,4,5,5,6,6-dodecafluorohexanecarboxylic acid, perfluorohexanecarboxylic acid; 2-(perfluoropentyl)ethanecarboxylic acid, 1,1,2,2,3,3,4,4,5,5,6,6,7,7- tetradecafluoroheptanecarboxylic acid, perfluoroheptanecarboxylic acid; 2-(perfluorohexyl)ethanecarboxylic acid, 1,1,2,2,3,3,4,4,5,5,6,6,7,7,8,8-hexadecafluorooctanecarboxylic acid, perfluorooctanecarboxylic acid; 2-(perfluoroheptyl)ethanecarboxylic acid, 1,1,2,2,3,3,4,4,5,5,6,6,7,7,8,8,9,9-octadecafluorononanecarboxylic acid, perfluorononanecarboxylic acid; 2-(perfluorooctyl)ethanecarboxylic acid, 1,1,2,2,3,3,4,4,5,5,6,6,7,7,8,8,9,9,10,10-eicosafluorodecanecarboxylic acid, perfluorodecanecarboxylic acid; 2-(perfluorononyl)ethanecarboxylic acid, 1,1,2,2,3,3,4,4,5,5,6,6,7,7,8,8,9,9,10,10,11,11-docosafluoroundecanecarboxylic acid, perfluoroundecanecarboxylic acid; 2-(perfluorodecyl)ethanecarboxylic acid, 1,1,2,2,3,3,4,4,5,5,6,6,7,7,8,8,9,9,10,10,11,11,12,12-tetracosafluorododecanecarboxylic acid, perfluorododecanecarboxylic acid; 2-(perfluoroundecyl) ethanecarboxylic acid, 1,1,2,2,3,3,4,4,5,5,6,6,7,7,8,8,9,9,10,10,11,11,12,12,13,13-hexacosafluorotridecanecarboxylic acid,
perfluorotridecanecarboxylic acid; 2-(perfluorododecyl) ethanecarboxylic acid, 1,1,2,2,3,3,4,4,5,5,6,6,7,7,8,8,9,9,10,10,11,11,12,12,13,13,14,14-octacosafluorotetradecanecarboxylic acid, perfluorotetradecanecarboxylic acid; 2-(perfluorotridecyl)ethanecarboxylic acid, 1,1,2,2,3,3,4,4,5,5,6,6,7,7,8,8,9,9,10,10,11,11,12,12,13,13,14,14,15,15-triacontafluoropentadecanecarboxylic acid and perfluoropentadecanecarboxylic acid.

Those fluoroalkylsulfonic acids and fluoroalkylcarboxylic acids can be used alone or in a mixture of two or more thereof.

Preferred examples of the inorganic acid are sulfuric acid, hydrochloric acid, nitric acid, phosphoric acid, hydrofluoric acid and hydrobromic acid. Those inorganic acids are preferred for the purpose of adjusting a pH value of the coating composition to ≤ 4.0. The inorganic acid is usually used in an amount of 0.01-0.2 mass-% based on the coating composition. The above-mentioned organic acids and inorganic acids may be used alone or in a mixture of two or more thereof.

To the coating composition forming the antireflection layer (L2) of the present invention may be added, as case demands, a water soluble polymer other than the fluorine-containing polymer (A). The water soluble polymer can be used for improving film forming property, and may be used within a range (kind and amount of the polymer) neither having an adverse effect on a refractive index of the coating film nor lowering transparency of the coating film.

Examples of the water soluble polymer are, for instance, polyvinyl alcohols, polyalkyl vinyl ethers (polymethyl vinyl ether, polyethyl vinyl ether), polyacrylic acids, acrylate resins having carboxyl group, polymethacrylic acids, polyethylene glycols and celluloses.

An amount of the water soluble polymer is 0.1-100 pbm, preferably 0.5-50 pbm, more preferably 1-30 pbm, particularly preferably 1-20 pbm based on 100 pbm of the fluorine-containing polymer (A) contained in the coating composition.

To the coating composition forming the antireflection layer (L2) of the present invention may be added, as case demands, a known photoacid generator. The addition of the photoacid generator to the coating composition can prevent diffusion and migration of an acid to the antireflection layer (L2) from the photoresist layer (L1) after the exposure and the resist pattern profile can be prevented from being in the form of T-top.

Examples of the acid generator are, for instance, onium salt, haloalkyl group-containing compound, o-quinonediazide compound, nitrobenzyl compound, sulfonic acid ester compound and sulfone compound. Those acid generators can be used alone or in a mixture of two or more thereof. The preferred acid generator is onium salt.

An amount of the acid generator is usually ≤ 20 pbm, preferably ≤ 10 pbm, particularly preferably ≤ 5 pbm based on 100 pbm of the fluorine-containing polymer (A) contained in the coating composition. If the amount of the acid generator is too large, there is a tendency that developing property of the laminated resist is lowered and transparency and a refractive index of the antireflection layer (L2) are deteriorated.

Also to the coating composition forming the antireflection layer (L2) of the present invention may be added, for example and as case demands, a defoaming agent, light absorbing agent, storage stabilizer, antiseptic agent, adhesion promoter, photoacid generator and dye.

In the coating composition forming the antireflection layer (L2) of the present invention, the content of the fluorine-containing polymer (A) having hydrophilic group varies depending on kind and molecular weight of the polymer, kind and amount of additives, kind of a solvent and the like, and is optionally selected so that a suitable viscosity being capable of forming a thin coating film is obtained. For example, the content of the polymer is 0.1-50 mass-%, preferably 0.5-30 mass-%, more preferably 1-20 mass-%, particularly preferably 2-10 mass-% based on the whole coating composition.

The coating composition is applied on the photoresist layer (L1) to form the antireflection layer (L2). For the application, conventional methods are adopted. Examples of the suitable methods are rotary coating method, cast coating method, roll coating method and the like, and particularly a rotary coating method (spin coating method) is preferred. Other method of forming the antireflection layer (L2) is as mentioned infra.

Next, explained below is the method of forming the antireflection layer (L2) of the present invention on the photoresist layer (L1) to form the laminated photoresist and further one example of the method of forming a fine pattern using the laminated photoresist by means of the drawing.

Fig. 1 is a diagrammatic view for explaining each step (a) to (e) of the method of forming a fine pattern via the method of forming the laminated photoresist of the present invention.

(a) A step for forming the photoresist layer (L1):

First, as shown in Fig. 1(a), the photoresist composition is coated on a substrate L0 by e.g. a rotary coating method in a coating thickness of 0.01-5 μm, preferably 0.05-0.5 μm, more preferably 0.1-0.3 μm.

Next, pre-baking treatment is carried out at a pre-determined temperature of ≤ 150°C, preferably 80-130°C to form the photoresist layer (L1).

Examples of the above-mentioned substrate are, for instance, a silicon wafer; a glass substrate; a silicon wafer or glass substrate provided with an organic or inorganic antireflection film; a silicon wafer which has steps and is provided with various insulating films, electrode and wiring on a surface thereof; a mask blank; a semiconductor wafer of III-V group compound such as GaAs or AlGaAs and a semiconductor wafer of II-VI group compound; and a piezoelectric wafer of crystal, quartz or lithium tantalate.

In the present invention, conventional photoresist compositions can be used. There can be used, for example, a positive photoresist containing, as main components, novolak resin and diazonaphthoquinone (for g-line or i-line lithography), a chemically amplifying positive or negative resist prepared by using polyhydroxystyrene as a binder resin (for KrF lithography), a chemically amplifying positive photoresist prepared by using an acrylic polymer having an alicyclic structure at its side chain or an alicyclic polymer having a polynorbornene structure (for ArF lithography) and a chemically amplifying positive photoresist prepared by using a fluorine-containing polymer (for $F_2$ lithography).

Since the antireflection layer (L2) of the present invention can realize a further lower refractive index as compared with conventional ones, it can be preferably applied especially to photography processes of a chemically amplifying positive photoresist using an acrylic polymer having an alicyclic structure at its side chain or an alicyclic polymer having a polynorbornene structure (ArF lithography) and a chemically amplifying positive photoresist prepared by using a fluorine-containing polymer (for $F_2$ lithography), and purposes such as precise pattern profile, high dimensional accuracy and repeatability thereof are achieved effectively.

(b) A step for forming the antireflection layer (L2):

As shown in Fig. 1(b), on the dried photoresist layer L1 is applied the coating composition containing the fluorine-containing polymer (A) by a rotary coating method. Then pre-baking is carried out, as case demands, to form the antireflection layer L2.

At that time, it is preferable that the thickness $d_{tarc}$ of the antireflection layer L2 is adjusted to a thickness calculated by an equation:

$$D_{tarc} = x \cdot \lambda/4n_{tarc}$$

wherein $d_{tarc}$ is a thickness (nm) of the antireflection layer; x is an odd number integer; λ is an exposure wavelength (nm); $n_{tarc}$ is a refractive index measured at an exposure wavelength (λ) of the antireflection layer, thereby exhibiting a reflection reducing effect at the upper interface of the resist film, namely lowering a reflectance and decreasing an influence of a standing wave.

The pre-baking conditions are optionally selected for the purpose of evaporating the residual solvent (B) in the antireflection layer L2 and forming a further uniform thin film. For example, the pre-baking temperature is selected within a range of from room temperature to 150°C, preferably 40-120°C, more preferably 60-100°C.

(c) An exposure step:

Subsequently as shown in Fig. 1(c), a pattern is drawn on the laminated photoresist (L1 + L2) by irradiating the photoresist with energy rays as shown by an arrow 13 through a mask 11 having a desired pattern to selectively exposing a specific area 12.

In this case, examples of the energy rays (or chemical radiation) are, for instance, g-line (λ = 436 nm), i-line (λ = 365 nm), KrF excimer laser beam (λ = 248 nm), ArF excimer laser beam (λ = 193 nm) and $F_2$ laser beam (λ = 157 nm). The energy ray is optionally selected depending on a photolithography process.

Asw further examples, it is also possible to use, as an exposure light, X-ray, high energy electron beam or synchrotron radiation, or to scan electron beam or ion beame without using the mask to directly expose the laminated photoresist to the pattern.

The reflection reducing effect of the present invention is exhibited most particularly when ArF excimer laser beam or $F_2$ laser beam is used as an exposure light.

Subsequently by carrying out post-exposure baking (PEB step) at a temperature of 70-160°C, preferably 90-140°C for 30 seconds to 10 minutes, a latent image 14 is formed on the exposed area 12 of the photoresist layer L1 as shown in Fig. 1(d). At this time, an acid generated by the exposing acts as a catalyst to decompose the dissolution-inhibiting group (protective group) and thereby solubility in a developing solution is increased and the exposed area of the resist film becomes soluble in a developing solution.

Also the antireflection layer L2 may be removed by rinsing 25 with pure water or the like before carrying out the above-mentioned post-exposure baking (PEB step) or may be removed in the developing step after the PEB.

(d) Developing step:

Then when the photoresist layer L1 after the post-exposure baking is subjected to developing with a developing solution, the un-exposed area of the photoresist layer L1 remains on the substrate because its solubility in the developing solution is low but the exposed area 12 is dissolved in the developing solution as mentioned above.

On the other hand, the upper antireflection layer L2 is excellent in solubility in the developing solution irrespective of the exposed area and un-exposed area, and therefore even if it remains undissolved, it is removed together with the exposed portion in the developing step.

As the developing solution, an aqueous solution of 2.38 mass-% of tetramethylammonium hydroxide is preferably used. Also to the aqueous solution of 2.38 mass-% of tetramethylammonium hydroxide may be added a surfactant or alcohol such as methanol, ethanol, propanol or butanol in order to adjust wettability to the surfaces of antireflection layer L2 and photoresist layer L1.

Next, after flowing away the developing solution with pure water, lower alcohol or a mixture thereof, the substrate is dried and thus a desired resist pattern 15 can be formed as shown in Fig. 1(e).

Mentioned above is the explanation in the case of forming the laminated photoresist on the substrate L0, but the formation of the laminated photoresist is not limited to the case of forming the resist on a so-called substrate. The laminated photoresist may also be formed on a specific layer such as an electrically conductive film or insulating film which is formed on the substrate. Also it is possible to form an antireflection film (lower antireflection layer), for example, DUV-30, DUV-32, DUV-42 and DUV44 available from Brewer Science Co., Ltd. on the substrate. The laminated photoresist may be formed on a substrate treated with an adhesion improver.

Also when an intended fine pattern of an electrically conductive film or an insulating film is formed by using the so-formed fine resist pattern as a mask and etching a specific layer under the mask and then other steps are carried out, semiconductor devices and electronic devices can be produced. Since those steps are well known, explanation thereof is omitted.

The second of the present invention relates to the coating composition containing the fluorine-containing polymer having -COOH group and the water soluble solvent. This is a particularly preferred coating composition for more effectively and efficiently obtaining the above-mentioned antireflection film to be provided on the resist film.

Namely, the coating composition of the present invention contains:

(A1) a fluorine-containing polymer having carboxyl group and
(B) at least one solvent selected from the group consisting of water and alcohols, and
the fluorine-containing polymer (A1) has a number average molecular weight of from 10,000 to 750,000 and is represented by the formula -(M3)-(N3)- (M-3), wherein
M3 is a structural unit derived from a fluorine-containing monomer of formula (5):

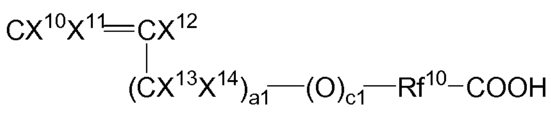

(5)

wherein

$X^{10}$ and $X^{11}$ each independently are H or F;
$X^{12}$ is H, F, Cl, $CH_3$ or $CF_3$;
$X^{13}$ and $X^{14}$ each independently are H or F;

$Rf^{10}$ is a divalent fluorine-containing $C_{1-40}$-alkylene group or a divalent fluorine-containing $C_{2-100}$-alkylene group having ether bond, and
a1 and c1 each independently are 0 or 1;

N3 is a structural unit derived from a monomer copolymerizable with the monomer of formula (5); and
the structural units M3 and N3 are contained in amounts of 55-100 mol-% and 0-45 mol-%, respectively.

The coating composition of the present invention is featured especially by the fluorine-containing polymer (A1). Namely, by specifying the above-mentioned conditions with respect to the structure of the monomer (formula (5)) constituting the structural unit M3, the content of the structural unit M3 and the number average molecular weight of the polymer, the polymer stably dissolves in water or a solvent containing water, thin film forming property is good, and a good reflection reducing effect can be given to the resist film.

In the coating composition of the present invention, the fluorine-containing polymer (A1) contains the above-mentioned structural unit M3 as essential component and is a homopolymer of the monomer of the formula (5) or a copolymer of the monomer of the formula (5) with a monomer copolymerizable therewith.

It is important that the structural unit M3 has the fluorine-containing alkylene group $Rf^{10}$ and -COOH group in its one side chain at the same time, and as a result, the both of hydrophilic property and a low refractive index can be imparted to the polymer.

In the monomer of the formula (5) constituting the structural unit M3, $Rf^{10}$ is a divalent fluorine-containing $C_{1-40}$-alkylene group or a divalent fluorine-containing $C_{2-100}$-alkylene group having ether bond. It is particularly preferable that $Rf^{10}$ is a $C_{1-40}$-perfluoroalkylene group or a divalent $C_{2-100}$-perfluoroalkylene group having ether bond, because a lower refractive index can be given to the polymer.

Examples of the fluorine-containing ethylenic monomer of the formula (5) having COOH group are fluorine-containing ethylenic monomers of formula (5-1):

$$CH_2=CFCF_2\text{-}O\text{-}Rf^{10}\text{-}COOH \qquad (5\text{-}1)$$

wherein $Rf^{10}$ is as defined in the formula (5).

The monomers of the formula (5-1) are concretely fluorine-containing ethylenic monomers represented by:

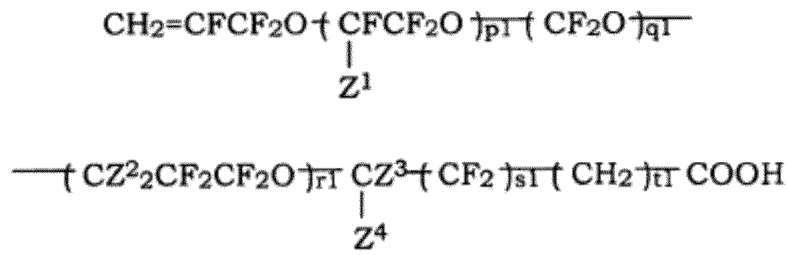

wherein $Z^1$ is F or $CF_3$; $Z^2$ and $Z^3$ are H or F; $Z^4$ is H, F or $CF_3$; p1 + q1 + r1 is an integer of 0-10; s1 is 0 or 1; t1 is an integer of 0-5; when both of $Z^3$ and $Z^4$ are H, p1 + q1 + r1 + s1 is not 0. Those monomers are preferred since homopolymerizability thereof is excellent and more -COOH groups can be introduced to the fluorine-containing polymer, and as a result, good hydrophilic property can be given to the polymer and a low refractive index and excellent solubility in a developing solution can be imparted to the antireflection layer.

Also copolymerizability thereof with fluorine-containing ethylene such as tetrafluoroethylene or vinylidene fluoride is high and a lower refractive index can be imparted to the antireflection layer. Preferred examples thereof are:

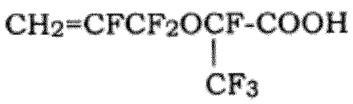 , 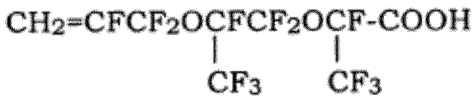 ,

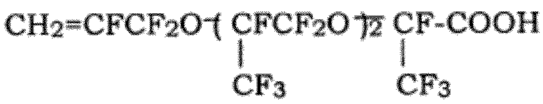 ,

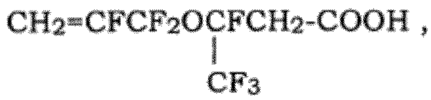

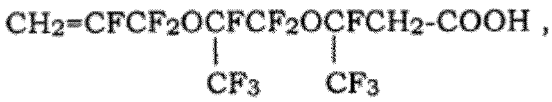

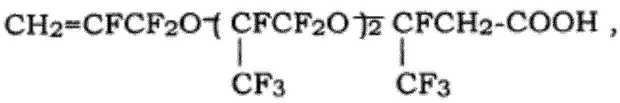

$CH_2=CFCF_2OCH_2CF_2\text{-}COOH$,

$CH_2=CFCF_2O(CH_2CF_2CF_2O)CH_2CF_2\text{-}COOH$,

$CH_2=CFCF_2OCH_2CF_2CH_2\text{-}COOH$,

$CH_2\text{-}CFCF_2O(CH_2CF_2CF_2O)CH_2CF_2CH_2\text{-}COOH$,

$CH_2=CFCF_2OCF_2CF_2\text{-}COOH$,

$CH_2=CFCF_2O(CF_2CF_2CF_2O)CF_2CF_2\text{-}COOH$,

$CH_2=CFCF_2OCF_2CF_2CH_2\text{-}COOH$,

$CH_2=CFCF_2O(CF_2CF_2CF_2O)CF_2CF_2CH_2\text{-}COOH$,

$CH_2=CFCF_2OCF_2\text{-}COOH$,

$CH_2=CFCF_2O(CF_2CF_2O)CF_2\text{-}COOH$,

$CH_2\text{-}CFCF_2OCF_2CH_2\text{-}COOH$,

$CH_2=CFCF_2O(CF_2CF_2O)CF_2CH_2\text{-}COOH$

and particularly preferred are:

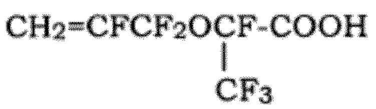 , 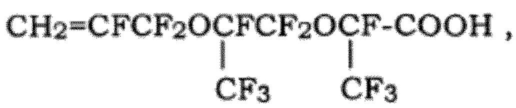

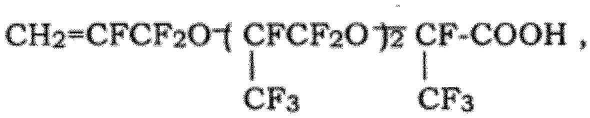

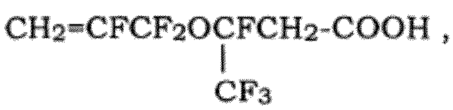

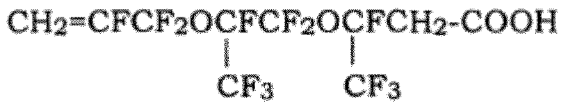

and

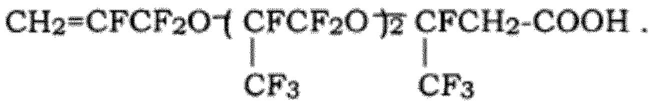

Further examples of the fluorine-containing ethylenic monomer of the formula (5) having -COOH group are fluorine-containing ethylenic monomers of formula $CF_2$=CF-O-$Rf^{10}$-COOH (5-2):
, wherein $Rf^{10}$ is as defined in the formula (5).

The monomers of the formula (5-2) are concretely fluorine-containing ethylenic monomers represented by:

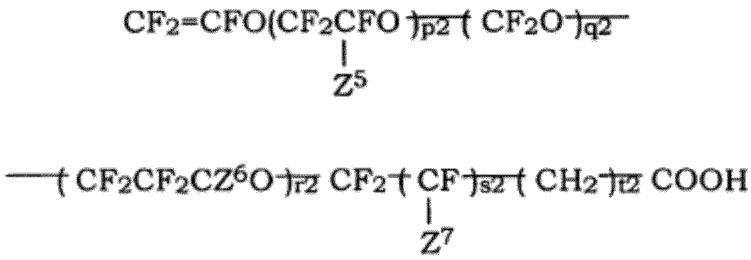

wherein $Z^5$ is F or $CF_3$; $Z^6$ is H or F; $Z^7$ is H or F; p2 + q2 + r2 is an integer of 0-10; s2 is 0 or 1; t2 is an integer of 0-5. Those monomers have high copolymerizability with fluorine-containing ethylene such as tetrafluoroethylene or vinylidene fluoride and can impart a lower refractive index to the antireflection layer.

Preferred examples of the monomer of the formula (5-2) are:

$CF_2$=$CFOCF_2CF_2$-COOH,

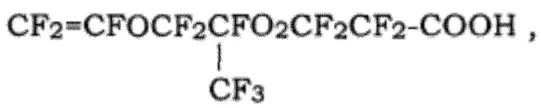

$CF_2$=$CFOCF_2CF_2CF_2$-COOH,

$CF_2$-$CFOCF_2CF_2CH_2$-COOH,

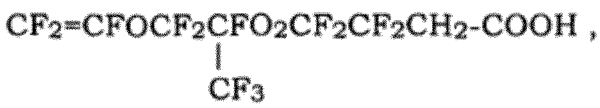

$CF_2$-$CFOCF_2CF_2CF_2CH_2$-COOH,

$CF_2$=$CFOCF_2CF_2OCF_2$-COOH,

$CF_2$=$CFOCF_2CF_2CF_2OCF_2CF_2$-COOH,

$CF_2$=$CFOCF_2CF_2CH_2OCF_2CF_2$-COOH,

$CF_2$=$CFOCF_2CF_2OCF_2CH_2$-COOH,

$CF_2$-$CFOCF_2CF_2CF_2OCF_2CF_2CH_2$-COOH,

$CF_2$=$CFOCF_2CF_2CH_2OCF_2CF_2CH_2$-COOH

Other examples of the fluorine-containing ethylenic monomer of the formula (5) having - COOH group are fluorine-containing ethylenic monomers represented by:

$CF_2$=$CFCF_2$-O-$Rf^{10}$-COOH,
$CF_2$-CF-$Rf^{10}$-COOH,
$CH_2$=CH-$Rf^{10}$-COOH and
$CH_2$=CH-O-$Rf^{10}$-COOH,

wherein $Rf^{10}$ is as defined in the formula (5). Examples thereof are:

$CF_2$=$CFCF_2OCF_2CF_2CF_2$-COOH,

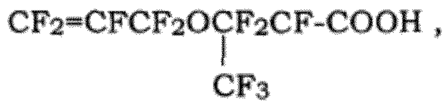

$CF_2$-$CFCF_2OCF_2CF_2CF_2CH_2$-COOH,

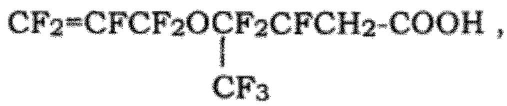

$CF_2$=$CFCF_2$-COOH,
$CF_2$=$CFCF_2CH_2$-COOH,
$CH_2$-$CHCF_2CF_2CH_2CH_2$-COOH,
$CH_2$-$CHCF_2CF_2$-COOH,
$CH_2$=$CHCF_2CF_2CH_2$-COOH,
$CH_2$-$CHCF_2CF_2CF_2CF_2$-COOH,
$CH_2$=$CHCF_2CF_2CF_2CF_2CH_2$-COOH,
$CH_2$=$CHOCH_2CF_2CF_2$-COOH,
$CH_2$=$CHOCH_2CF_2CF_2CH_2$-COOH

In the case of a copolymer, the structural unit (N3) as a copolymerizable component can be optionally selected, but is preferably selected for the purpose of setting a refractive index low within a range of maintaining water solubility and solubility in a developing solution. Concretely the structural unit (N3) is selected from structural units derived from fluorine-containing ethylenic monomers.

Particularly preferred are those selected from structural units of the following (N3-1) and (N3-2).

(N3-1) Structural units derived from fluorine-containing ethylenic monomers having 2 or 3 carbon atoms and at least one fluorine atom:

This structural unit N3-1 is preferred since a refractive index can be effectively set low and transparency can be improved without lowering solubility in a developing solution and also since a strength of the antireflection layer can be increased.

There are concretely exemplified $CF_2$=$CF_2$, $CF_2$=CFCl, $CH_2$=$CF_2$, CFH=$CH_2$, CFH=$CF_2$, $CF_2$=$CFCF_3$, $CH_2$=$CFCF_3$ and $CH_2$=$CHCF_3$. Among them, from the viewpoint of good copolymerizability and high effects of imparting transparency and a low refractive index, tetrafluoroethylene ($CF_2$=$CF_2$), chlorotrifluoroethylene ($CF_2$=CFCl) and vinylidene fluoride ($CH_2$=$CF_2$) are preferred.

(N3-2) Structural units derived from monomers represented by the formula (n3-2):

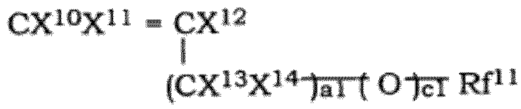

wherein $X^{10}$, $X^{11}$, $X^{12}$, $X^{13}$, $X^{14}$, a1 and c1 are as defined in the formula (5); $Rf^{11}$ is a fluorine-containing $C_{1-40}$-alkyl group or a fluorine-containing $C_{2-100}$-alkyl group having ether bond.

Those structural units are preferred since a refractive index can be decreased effectively and transparency can be improved. Preferred examples are:

$CH_2$=$CFCF_2$-O-$Rf^{11}$, $CF_2$=CF-O-$Rf^{11}$, $CF_2$=$CFCF_2$-O-$Rf^{11}$,

$CF_2$=CF-$Rf^{11}$, $CH_2$=CH-$Rf^{11}$, $CH_2$=CH-O-$Rf^{11}$

wherein $Rf^{11}$ is as defined in the formula (n3-2).

The proportions of each structural unit of the fluorine-containing polymer of the formula (M-3) are optionally selected depending on the above-mentioned preferred fluorine content and hydrophilic group content. A higher content of the structural unit M3 is preferred because water solubility is enhanced when a composition contains water, and also because a mixing ratio of alcohol can be decreased when solubility of the polymer (A1) is increased by mixing alcohol.

With respect to the proportions of components of the fluorine-containing polymer (A1) used for the coating composition of the present invention, the structural unit M3 and structural unit N3 are contained in amounts of 55-100 mol-% and 0-45 mol-%, preferably 60-100 mol-% and 0-40 mol-%, more preferably 70-100 mol-% and 0-30 mol-%, particularly preferably 80-100 mol-% and 0-20 mol-%.

Also among the monomers of the formula (5), in the case of homopolymerizable monomer, the homopolymer obtained therefrom is more preferred since water solubility of the fluorine-containing polymer (A1) and a dissolution rate of the antireflection film in a developing solution can be enhanced. Even in the case of the above-mentioned proportion of the structural unit M3, a low refractive index and transparency can be maintained by using the above-exemplified fluorine-containing monomers.

It is important that the number average molecular weight of the fluorine-containing polymer of the formula (M-3) is 31,000-750,000, which enables the fluorine-containing polymer (A1) to stably maintain its hydrophilic property.

The number average molecular weight is preferably 31,000-500,000, more preferably 31,000-300,000, particularly preferably 40,000-200,000.

If the number average molecular weight is too low, hydrophilic property of the fluorine-containing polymer (A1) is lowered, and in order to make the polymer soluble in a solvent containing water, much amount of alcohol solvent need be mixed. Therefore when forming the antireflection film on the resist film, a reflection reducing effect is lowered due to an intermixing phenomenon at an interface between them. Further the dissolution rate of the coated antireflection film in a developing solution is decreased and resolution of the resist is lowered.

On the contrary, if the molecular weight of the fluorine-containing polymer (A1) is too high, film forming property of the antireflection film is lowered and it becomes difficult to form a uniform thin film.

In the coating composition of the present invention, the solvent (B) is at least one selected from the group consisting of water and alcohols.

It is preferable that the solvent (B) is selected from solvents which do not re-dissolve the previously formed lower photoresist film when the coating composition is applied. From this point of view, the solvent (B) is preferably water and/or alcohols. Further it is preferable that the solvent is water alone or a solvent mixture of water and alcohol. It is particularly preferable that alcohols are not used as far as possible or a solvent mixture containing alcohol at a low ratio is used.

The fluorine-containing polymer (A1) of the present invention has good solubility in those water, alcohols and solvent mixture of water and alcohol.

Among the solvents (B), water is not limited particularly. Preferred are distilled water, ion exchange water, water subjected to filtration and water subjected to adsorption treatment to remove organic impurities and metal ion.

Alcohols are optionally selected from those which do not re-dissolve the lower photoresist layer (L1), depending on kind of the photoresist layer (L1). Generally lower alcohols having 1-6 carbon atoms are preferred, and concretely methanol, ethanol, isopropanol, n-propanol and butyl alcohols are preferred.

When using a solvent mixture of water and alcohol, it is preferable that the mixing ratio of water is > 60 mass-%, more preferably > 65 mass-%, particularly preferably > 70 mass-%, further preferably > 75 mass-% based on the total amount of water and alcohol.

In addition to the solvent (B), a water soluble organic solvent may be used together for the purpose of improving

coatability, etc. within a range not re-dissolving the photoresist layer (L1).

A water soluble organic solvent is not limited particularly as far as it dissolves in water in an amount of ≥ 1 mass-%. Examples thereof are, for instance, ketones such as acetone and methyl ethyl ketone; esters of acetic acids such as methyl acetate and ethyl acetate; and polar solvents such as dimethylformamide, dimethyl sulfoxide, methyl cellosolve, cellosolve acetate, butyl cellosolve, butyl carbitol and carbitol acetate.

An adding amount of the water soluble organic solvent to be added in addition to water or alcohol is 0.1-30 mass-%, preferably 0.5-20 mass-%, more preferably 1-10 mass-%, particularly preferably 1-5 mass-% based on the total amount of solvents (B).

To the coating composition of the present invention may be added, as case demands, at least one selected from basic substances, for example, ammonia and organic amines. In this case, a part or the whole of -COOH groups in the fluorine-containing polymer (A1) may be, for example, in the form of salt such as ammonium salt or amine salt.

The addition of the basic substance is effective for enhancing water solubility and solubility in a developing solution and also for maintaining repeatability of the dissolution rate in a developing solution. Also it is effective for adjusting the pH value of the coating composition to be within an optimum range.

Further in the present invention, water solubility of the fluorine-containing polymer (A1) can be improved, and for example, even in the case of using a solvent mixture of water and alcohol, a mixing ratio of alcohol can be decreased and the polymer can be dissolved in a solvent containing water at a high mixing ratio or can be dissolved in a solvent of water only not containing alcohols.

With respect to organic amines, preferred are water soluble organic amine compounds. Preferred examples thereof are, for instance, primary amines such as methylamine, ethylamine, propylamine, butylamine and cyclohexylamine; secondary amines such as dimethylamine, diethylamine, dipropylamine and dibutylamine; tertiary amines such as trimethylamine, triethylamine, tripropylamine, tributylamine, pyridine, pyrrole, piperidine, oxazole and morpholine; hydroxylamines such as monoethanolamine, propanolamine, diethanolamine, triethanolamine and tris (hydroxymethyl) aminomethane; quaternary ammonium compounds such as tetramethylammonium hydroxide, tetraethylammonium hydroxide, tetrapropylammonium hydroxide and tetrabutylammonium hydroxide; primary, and secondary and tertiary polyamines such as ethylenediamine, diethylenediamine, tetraethylenediamine, diethylenetriamine, tetraethylenetriamine, imidazole, imidazolidine, pyrazine and s-triazine.

Among them, from the point of maintaining a low refractive index, increasing the dissolution rate in a developing solution and improving water solubility, preferred are hydroxylamines such as monoethanolamine, propanolamine, diethanolamine, triethanolamine and tris(hydroxymethyl)aminomethane, and particularly preferred is monoethanolamine.

In the coating composition of the present invention, ammonia or organic amine can be added usually in an amount of 0.01-10 mole, preferably 0.1-5 mole, more preferably 0.1-2 mole, particularly preferably 0.4-1 mole based on 1 mole of hydrophilic group of the fluorine-containing polymer (A1) to be used.

To the coating composition of the present invention may be added, as case demands, a known surfactant.

The addition of a surfactant is effective for improving wettability of the coating composition to the surface of the lower photoresist layer and for forming a uniform thin film, and further is preferred for decreasing a surface tension of the obtained antireflection layer after the coating, thereby stabilizing solubility in a developing solution. Further the addition of a surfactant is preferred for preventing striation.

Also in the present invention, water solubility of the fluorine-containing polymer (A1) can be improved. For example, even in the case of using a solvent mixture of water and alcohol, a mixing ratio of alcohol can be decreased and the polymer can be dissolved in a solvent containing water at a higher mixing ratio or can be dissolved in a solvent of water only not containing alcohols.

Examples of the surfactant to be added are nonionic surfactants, anionic surfactants and ampholytic surfactants, and anionic surfactants are used preferably.

Examples of nonionic surfactants are polyoxyethylene alkyl ethers, for instance, polyoxyethylene lauryl ether, polyoxyethylene stearyl ether, polyoxyethylene oleyl ether, polyoxyethylene cetyl ether, polyoxyethylene octylphenyl ether, polyoxyethylene nonylphenyl ether, polyethylene glycol dilaurate and polyethylene glycol distearate; polyoxyethylene fatty acid diester, polyoxy fatty acid monoester, polyoxyethylene/polyoxypropylene block polymer and acetylene glycol derivative.

Examples of the anionic surfactants are alkyl diphenylether disulfonic acid and its ammonium salt or organic amine salt; alkyl diphenylether sulfonic acid and its ammonium salt or organic amine salt; alkylbenzene sulfonic acid and its ammonium salt or organic amine salt; polyoxyethylene alkyl ether sulfuric acid and its ammonium salt or organic amine salt; and alkyl sulfuric acid and its ammonium salt or organic amine salt.

Examples of ampholytic surfactants are 2-alkyl-N-carboxymethyl-N-hydroxyethyl imidazolinium betaine and lauric acid amidopropylhydroxysulfone betaine.

Also fluorine-containing surfactants are preferred because a low refractive index of the antireflection layer can be maintained. Examples thereof are:

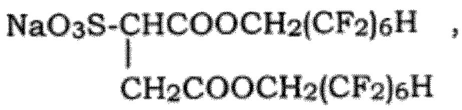

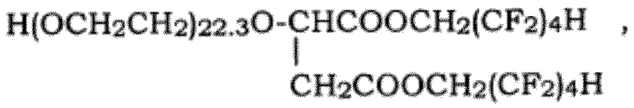

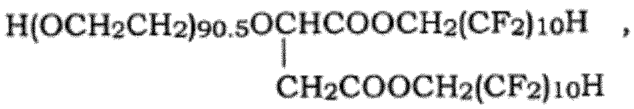

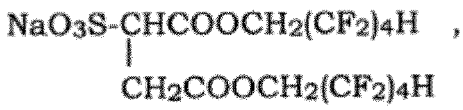

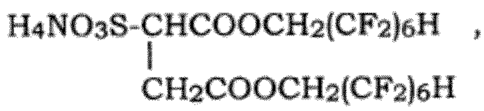

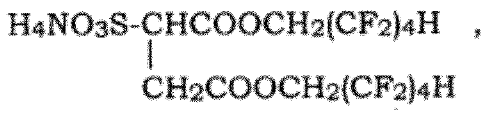

$H(CF_2CF_2)_5$-COONa, $F_3C$-$(CF_2)_7$-$SO_3K$,
H-$(CF_2)_6$-$CH_2$-$OSO_3Na$,

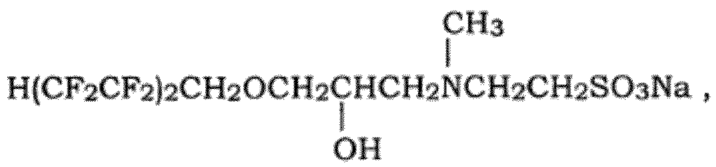

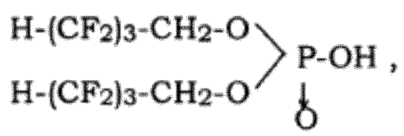

$H(CF_2CF_2)_5$-$COONH_4$, $F_3C$-$(CF_2)_7$-$SO_3NH_4$,
H-$(CF_2)_6$-$CH_2$-$OSO_3NH_4$,

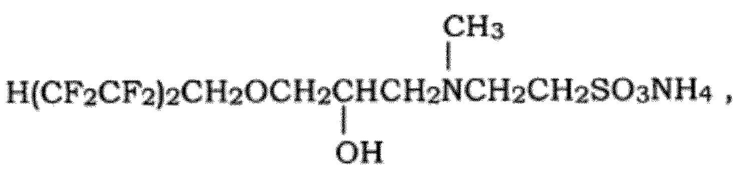

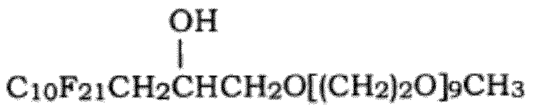,

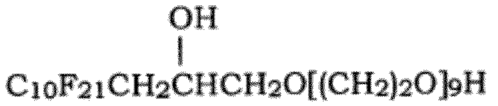,

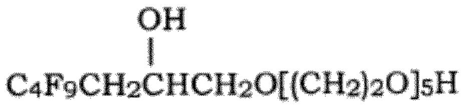,

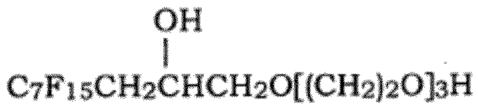,

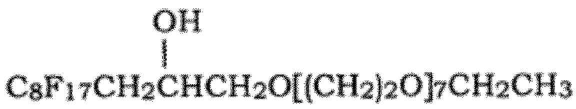,

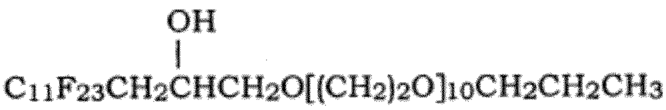,

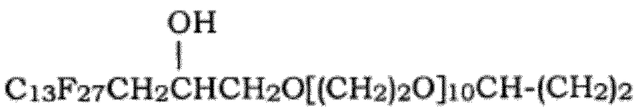

With respect to the fluorine-containing surfactants, not only the above-mentioned low molecular weight compounds but also the following high molecular weight compounds are preferred because a low refractive index of the antireflection layer (L2) can be maintained. There are concretely copolymers having a number average molecular weight of 1,000-500,000 and containing component units derived from (a) acrylic ester or methacrylic acid ester having fluoroalkyl group (monomer (a)), (b) polyalkylene glycol acrylate or polyalkylene glycol methacrylate (monomer (b)), (c) 3-chloro-2-hydroxypropyl (meth)acrylate (monomer (c)) and (d) glycerol mono(meth)acrylate (monomer (d)) and fluorine-containing polymer surfactants containing such a copolymer.

The monomers providing each component unit are explained below.

Examples of the monomer (a) are, for instance, one or two or more compounds represented by the formula:

$$Rf^{20}R^{10}OCOCR^{11}=CH_2$$

wherein $Rf^{20}$ is linear or branched $C_{3-20}$-perfluoroalkyl; $R^{11}$ is H or methyl; $R^{10}$ is linear or branched $C_{1-10}$-alkylene, $-SO_2N(R^{12})R^{13}-$ ($R^{12}$ is $C_{1-10}$-alkyl; $R^{13}$ is linear or branched $C_{1-10}$-alkylene) or $-CH_2CH(OR^{14})CH_2-$ ($R^{14}$ is H or an $C_{1-10}$-acyl).

Preferred examples of the monomer (a) are as follows. Those monomers may be used alone or in a mixture of two or more thereof.

(a-1)

$$CF_3(CF_2)_n(CH_2)_mOCOCR^{11}=CH_2$$

($R^{11}$ is H or methyl; n is an integer of 2-19, m is an integer of 1-10). Examples thereof are:

$CF_3(CF_2)_7(CH_2)_{10}OCOCH=CH_2$,

$CF_3(CF_2)_7(CH_2)_2OCOCH=CH_2$,

$CF_3(CF_2)_6CH_2OCOC(CH_3)=CH_2$,

$CF_3(CF_2)_7(CH_2)_2OCOC(CH_3)=CH_2$,

$CF_3(CF_2)_9(CH_2)_2OCOC(CH_3)=CH_2$.

$CF_3(CF_2)_{11}(CH_2)_2OCOC(CH_3)=CH_2$

(a-2)

$(CF_3)_2CF(CF_2)_n(CH_2)_mOCOCR^{11}=CH_2$

($R^{11}$ is H or methyl; n is an integer of 0-17, m is an integer of 1-10). An examples thereof is:

$(CF_3)_2CF(CF_2)_8(CH_2)_2OCOCH=CH_2$

(a-3)

$CF_3(CF_2)_nSO_2N(R^{12})(CH_2)_mOCOCR^{11}=CH_2$

($R^{11}$ is H or methyl; $R^{12}$ is $C_{1-10}$-alkyl; n is an integer of 2-19, m is an integer of 1-10). Examples thereof are:

$CF_3(CF_2)_7SO_2N(CH_3)(CH_2)_2OCOCH=CH_2$

$CF_3(CF_2)_7SO_2N(C_2H_5)(CH_2)_2OCOC(CH_3)=CH_2$

(a-4)

$(CF_3)_2CF(CF_2)_nCH_2CH(OR^{14})(CH_2)_mOCOCR^{11}=CH_2$

($R^{11}$ is H or methyl; $R^{14}$ is H or $C_{1-10}$-acyl; n is an integer of 0-17, m is an integer of 1-10). Examples thereof are:

$(CF_3)_2CF(CF_2)_8CH_2CH(OCOCH_3)CH_2OCOC(CH_3)=CH_2$,

$(CF_3)_2CF(CF_2)_8CH_2CH(OH)CH_2OCOCH=CH_2$

It is preferable that the monomer (b) is, for instance, one or two or more compounds represented by the formula:

$CH_2=CR^{15}COO-(R^{16}O)_n-R^{17}$

wherein $R^{15}$ and $R^{17}$ are H or methyl; $R^{16}$ is $C_{2-6}$-alkylene, n is an integer of 3-50.

Usually $-CH_2CH_2-$ is suitable as $R^{16}$. $R^{16}$ for example may be $-CH(CH_3)CH_2-$ or $-CH(C_2H_5)CH_2-$. Namely, in the present invention, polyethylene glycol acrylate or methacrylate in which $R^{16}$ is $-CH_2CH_2-$ can be used particularly preferably. Also, n is selected from integers of 3-50, and usually when n is selected from integers of 9-25, especially good result can be obtained. It is a matter of course that the monomer (b) may be in the form of a mixture of two or more monomers having different kind of $R^{16}$ and different number of n.

Examples of the monomer (b) are as follows. Those monomers may be used alone or in a mixture of two or more thereof.

**(b-1)**

$CH_2-CR^{15}COO(CH_2CH_2O)_nR^{17}$

($R^{15}$ and $R^{17}$ are H or methyl; n is an integer of 3-50). Examples thereof are:

$CH_2=C(CH_3)COO(CH_2CH_2O)_3H$,

$CH_2=C(CH_3)COO(CH_2CH_2O)_6H$,

$CH_2=C(CH_3)COO(CH_2CH_2O)_9H$,

$CH_2-C(CH_3)COO(CH_2CH_2O)_{40}H$,

$CH_2=C(CH_3)COO(CH_2CH_2O)_9CH_3$,

$CH_2=C(CH_3)COO(CH_2CH_2O)_{23}CH_3$

(b-2)

$CH_2=CR^{15}COO(CH_2CH(CH_3)O)_nR^{17}$

($R^{15}$ and $R^{17}$ are H or methyl; n is an integer of 3-50). Examples thereof are:

$CH_2=C(CH_3)COO(CH_2CH(CH_3)O)_{12}H$,

$CH_2=CHCOO(CH_2CH(CH_3)O)_nCH_3$

(b-3)

$CH_2=CR^{15}COO(CH_2CH_2O)_n(CH_2CH(CH_3)O)_mR^{17}$

($R^{15}$ and $R^{17}$ are hydrogen atom or methyl; n + m is an integer of 3 to 50)

An example thereof is:

$CH_2=C(CH_3)COO(CH_2CH_2O)_5(CH_2CH(CH_3)O)_3H$

3-Chloro-2-hydroxypropyl (meth)acrylate of the monomer (c) is 3-chloro-2-hydroxypropyl acrylate and/or 3-chloro-2-hydroxypropyl methacrylate represented by:

$CH_2=CR^{18}COOCH_2CH(OH)CH_2Cl$

wherein $R^{18}$ is H or methyl.

Glycerol mono(meth)acrylate of the monomer (d) is glycerol monoacrylate and/or glycerol monomethacrylate represented by:

$CH_2=CR^{19}COOCH_2CH(OH)CH_2OH$

wherein $R^{19}$ is H or methyl.

In the copolymer to be used in the present invention as a fluorine-containing polymer surfactant, a copolymerization ratio of the (meth)acrylic acid ester (monomer (a)) having fluoroalkyl group is $\geq$ 5 mass-%, preferably 6-70 mass-%.

A copolymerization ratio of the polyalkylene glycol (meth)acrylate (monomer (b)) is $\geq$ 10 mass-%, preferably 14-60 mass-%. If the ratio is < 10 mass-%, dispersibility in water tends to be lowered.

A copolymerization ratio of the 3-chloro-2-hydroxypropyl (meth)acrylate (monomer (c)) is at least 0.5 mass-%, preferably from 0.5-30 mass-%. A copolymerization ratio of the glycerol mono(meth)acrylate (monomer (d)) is at least 0.5 mass-%, preferably from 0.5 to 30 mass-%.

It is preferable that a total amount of 3-chloro-2-hydroxypropyl (meth)acrylate (monomer (c)) and glycerol mono(meth)acrylate (monomer (d)) is at least 1 mass-%, preferably 1.2-30 mass-%. Also it is preferable that a ratio of 3-chloro-2-hydroxypropyl (meth)acrylate (monomer (c)) to the sum of monomer (c) and monomer (d) is 10-90 mass-%, particularly 20-80 mass-%.

A number average molecular weight of the fluorine-containing polymer surfactant is 1,000-500,000, preferably

5,000-200,000. If it is < 1,000, durability tends to be lowered, and if it exceeds 500,000, there is a case where a viscosity of the surfactant solution becomes high and workability is lowered. The fluorine-containing polymer surfactant may be a random copolymer or a block copolymer.

With respect to those copolymers to be used as the fluorine-containing polymer surfactant, besides the monomers (a), (b), (c) and (d) can be copolymerized a copolymerizable monomer having no fluoroalkyl group such as ethylene, vinyl chloride, halogenated vinylidene, styrene, (meth)acrylic acid, alkyl ester of (meth)acrylic acid, benzyl methacrylate, vinyl alkyl ketone, vinyl alkyl ether, isoprene, chloroprene, maleic anhydride or butadiene. When those other monomers are copolymerized, dispersibility, uniform coatability, water- and oil-repellency and durability can be enhanced and a low refractive index can be obtained. Also other various properties such as solubility and water resistance can be optionally improved. A copolymerization ratio of the comonomer having no fluoroalkyl group is 0-40 mass-%, preferably 0-20 mass-%.

The copolymer suitable as the fluorine-containing polymer surfactant of the present invention contains, for example, the following copolymerizable components, but the composition of the copolymer is not limited to them.

(Composition I)

Copolymer containing:

19-22 parts by mass of a monomer (a) represented by
$CF_3CF_2(CF_2CF_2)_nCH_2CH_2OCOC(CH_3)=CH_2$ (a mixture of compounds of n=3, n=4 and n=5 in a weight ratio of 5:3: 1),
8 to 13 parts by mass of monomer (b) represented by $CH_2=C(CH_3)COO(CH_2CH_2O)_9CH_3$.
4 to 7 parts by mass of monomer (b) represented by $CH_2=C(CH_3)COO(CH_2CH(CH_3)O)_{12}H$,
3 to 5 parts by mass of monomer (c) represented by $CH_2=C(CH_3)COOCH_2CH(OH)CH_2Cl$ and
1 to 2 parts by mass of monomer (d) represented by $CH_2=C(CH_3)COOCH_2CH(OH)CH_2OH$.

(Composition II)

Copolymer containing:

8 to 13 parts by mass of monomer (a) represented by $CF_3CF_2(CF_2CF_2)_nCH_2CH_2OCOC(CH_3)=CH_2$ (a mixture of compounds of n=3 and n=4 in a weight ratio of 5.4:1),
8 to 12 parts by mass of monomer (b) represented by $CH_2=C(CH_3)COO(CH_2CH_2O)_9CH_3$,
4 to 9 parts by mass of monomer (b) represented by $CH_2=C(CH_3)COO(CH_2CH(CH_3)O)_{12}H$,
0.5 to 3 parts by mass of monomer (c) represented by $CH_2=C(CH_3)COOCH_2CH(OH)CH_2Cl$ and
0.3 to 2 parts by mass of monomer (d) represented by $CH_2=C(CH_3)COOCH_2CH(OH)CH_2OH$.

(Composition III)

Copolymer containing:

5 to 8 parts by mass of monomer (a) represented by $CF_3CF_2(CF_2CF_2)_nCH_2CH_2OCOC(CH_3)=CH_2$ (a mixture of compounds of n=3 and n=4 in a weight ratio of 3.9:1),
14 to 17 parts by mass of monomer (b) represented by $CH_2=C(CH_3)COO(CH_2CH_2O)_9CH_3$,
5 to 8 parts by mass of monomer (b) represented by $CH_2=C(CH_3)COO(CH_2CH(CH_3)O)_{12}H$,
0.5 to 1.5 parts by mass of monomer (c) represented by $CH_2=C(CH_3)COOCH_2CH(OH)CH_2Cl$ and
0.5 to 1.5 parts by mass of monomer (d) represented by $CH_2=C(CH_3)COOCH_2CH(OH)CH_2OH$.

Examples of commercial products of the copolymer are KP341 (trade name available from Shin-Etsu Chemical Co., Ltd.), POLYFLOW No.75 and POLYFLOW No.95 (trade name available from Kyoeisha Chemical Co., Ltd.), F TOP EF301, EF303, EF352 and EF204 (trade name available from Tokem Products Co., Ltd.), MEGAFAC F171 and F173 (trade name available from Dai-Nippon Ink and Chemicals Incorporated), Fluorad FC430 and FC431 (trade name available from Sumitomo Three M), Asahi Guard AG710, Surfron S-382, SC-101, SC-102, SC-103, SC-104, SC-105 and

SC-106 (trade name available from Asahi Glass Co., Ltd.) and the like. Those surfactants can be used alone or in a mixture of two or more thereof.

An amount of the surfactant is usually not more than 100 parts by mass, preferably not more than 70 parts by mass, particularly preferably from 0.01 to 50 parts by mass, especially from 0.1 to 30 parts by mass, further from 0.5 to 20 parts by mass based on the total parts by mass of polymer components in the antireflection film material.

To the coating composition of the present invention may be added, as case demands, a known acid.

The acid is added mainly for the purpose of adjusting a pH value of the coating composition to be not more than 4, preferably not more than 3, more preferably not more than 2.

By forming the antireflection layer (L2) with the acidic coating composition, diffusion and migration of an acid to the antireflection layer from the photoresist layer after the exposure can be prevented and the resist pattern profile can be prevented from being in the form of T-top.

With respect to the acid to be used in the present invention, any of an organic acid and inorganic acid may be used. Preferred examples of the organic acid are alkylsulfonic acid, alkylbenzenesulfonic acid, alkylcarboxylic acid, alkylbebzenecarboxylic acid and partly fluorinated acids thereof. Preferred alkyl groups are those having 1 to 20 carbon atoms. Those organic acids are used in an amount of usually from 0.1 to 2.0 mass-%, preferably from 0.5 to 1.0 mass-% in the composition.

Fluorine-containing organic acids may be fluoroalkylsulfonic acid and fluoroalkylcarboxylic acid having a fluorine chain of perfluoroalkyl group or hydrofluoroalkyl group, and the fluorine chain may be a linear or branched chain. Examples of the fluoroalkyl group are not only those having 1-4 carbon atoms but also those having 5-15 carbon atoms. Other examples thereof are 1,1,2,2,3,3,4,4,5,5-decafluoropentyl; 1,1,2,2,3,3,4,4,5,5,6,6-decafluorohexyl, 1,1,2,2,3,3,4,4,5,5,6,6,7,7-tetradecafluoroheptyl, 1,1,2,2,3,3,4,4,5,5,6,6,7,7,8,8-hexadecafluorooctyl; 1,1,2,2,3,3,4,4,5,5,6,6,7,7,8,8,9,9-octadecafluorononyl; 1,1,2,2,3,3,4,4,5,5,6,6,7,7,8,8,9,9,10,10-eicosafluorodecyl; 2-(perfluorononyl)ethyl, 2,2,3,3,4,4,5,5,6,6,7,7,8,8,9,9,10,10,11,11-eicosafluoroundecyl, perfluorodecylmethyl, 1,1,2,2,3,3,4,4,5,5,6,6,7,78,8,9,9,10,10,11,11-docosafluoroundecyl, perfluoroundecyl; 2-(perfluorodecyl)ethyl, 2,2,3,3,4,4,5,5,6,6,7,7,8,8,9,9,10,10,11,11,12,12-docosafluorododecyl, perfluoroundecylmethyl, 1,1,2,2,3,3,4,4,5,5,6,6,7,7,8,8,9,9,10,10,11,11,12,12- tetracosafluorododecyl, perfluorododecyl; 2-(perfluoroundecyl) ethyl, 2,2,3,3,4,4,5,5,6,6,7,7,8,8,9,9,10,10,11,11,12,12,13,13-tetracosafluorotridecyl, perfluorododecylmethyl, 1,1,2,2,3,3,4,4,5,5,6,6,7,7,8,8,9,9,10,10,11,11,12,12,13,13-hexacosafluorotridecyl, perfluorotridecyl, 2-(perfluorododecyl)ethyl, 2.2.3.3.4.4.5.5.6.6.7.7.8.8.9.9.10.10.11.11.12.12.13.13.14.14-hexacosafluorotetradecyl, perfluorotridecylmethyl, 1.1.2.2.3.3.4.4.5.5.6.6.7.7.8.8.9.9.10.10.11.11.12.12.13.13.14.14-octacosafluorotetradecyl, perfluorotetradecyl, 2-(perfluorotridecyl)ethyl, 2,2,3,3,4,4,5,5,6,6,7,7,8,8,9,9,10,10,11,11,12,12,13,13,14,14,15,15-octacosafluoropentadecyl, perfluorotetradecylmethyl, 1,1,2,2,3,3,4,4,5,5,6,6,7,7,8,8,9,9,10,10,11,11,12,12,13,13,14,14,15,15-triacontafluoropentadecyl and perfluoropentadecyl.

Examples of such a fluoroalkylsulfonic acid are 2-(perfluoropropyl)ethanesulfonic acid, 1,1,2,2,3,3,4,4,5,5-decafluoropentanesulfonic acid, perfluoropentanesulfonic acid; 2-(perfluorobutyl)ethanesulfonic acid, 1,1,2,2,3,3,4,4,5,5,6,6-dodecafluorohexane sulfonic acid, perfluorohexanesulfonic acid, 2-(perfluoropentyl)ethanesulfonic acid, 1,1,2,2,3,3,4,4,5,5,6,6,7,7-tetradecafluoroheptanesulfonic acid, perfluoroheptanesulfonic acid; 2-(perfluorohexyl)ethanesulfonic acid, 1,1,2,2,3,3,4,4,5,5,6,6,7,7,8,8-hexadecafluorooctanesulfonic acid, perfluorooctanesulfonic acid; 2-(perfluoroheptyl)ethanesulfonic acid, 1,1,2,2,3,3,4,4,5,5,6,6,7,7,8,8,9,9-octadecafluorononanesulfonic acid, perfluorononanesulfonic acid; 2-(perfluorooctyl)ethanesulfonic acid, 1,1,2,2,3,3,4,4,5,5,6,6,7,7,8,8,9,9,10,10-eicosafluorodecanesulfonic acid, perfluorodecanesulfonic acid; 2-(perfluorononyl)ethanesulfonic acid, 1,1,2,2,3,3,4,4,5,5,6,6,7,7,8,8,9,9,10,10,11,11-docosafluoroundecanesulfonic acid, perfluoroundecanesulfonic acid; 2-(perfluorodecyl) ethane sulfonic acid, 1,1,2,2,3,3,4,4,5,5,6,6,7,7,8,8,9,9,10,10,11,11,12,12-tetracosafluorododecanesulfonic acid, perfluorododecanesulfonic acid; 2-(perfluoroundecyl)ethanesulfonic acid, 1,1,2,2,3,3,4,4,5,5,6,6,7,7,8,8,9,9,10,10,11,11,12,12,13,13-hexacosafluorotridecanesulfonic acid, perfluorotridecanesulfonic acid; 2-(perfluorododecyl) ethane sulfonic acid, 1,1,2,2,3,3,4,4,5,5,6,6,7,7,8,8,9,9,10,10,11,11,12,12,13,13,14,14-octacosafluorotetradecanesulfonic acid, perfluorotetradecanesulfonic acid; 2-(perfluorotridecyl) ethane sulfonic acid, 1,1,2,2,3,3,4,4,5,5,6,6,7,7,8,8,9,9,10,10,11,11,12,12,13,13,14,14,15,15-triacontafluoropentadecanesulfonic acid and perfluoropentadecanesulfonic acid.

Examples of fluoroalkylcarboxylic acid are 2-(perfluoropropyl)ethanecarboxylic acid, 1,1,2,2,3,3,4,4,5,5-decafluoropentanecarboxylic acid, perfluoropentanecarboxylic acid; 2-(perfluorobutyl)ethanecarboxylic acid, 1,1,2,2,3,3,4,4,5,5,6,6-dodecafluorohexanecarboxylic acid, perfluorohexanecarboxylic acid; 2-(perfluoropentyl)ethanecarboxylic acid, 1,1,2,2,3,3,4,4,5,5,6,6,7,7- tetradecafluoroheptanecarboxylic acid, perfluoroheptanecarboxylic acid; 2-(perfluorohexyl)ethanecarboxylic acid, 1,1,2,2,3,3,4,4,5,5,6,6,7,7,8,8-hexadecafluorooctanecarboxylic acid, perfluorooctanecarboxylic acid; 2-(perfluoroheptyl)ethanecarboxylic acid, 1,1,2,2,3,3,4,4,5,5,6,6,7,7,8,8,9,9-octadecafluorononanecarboxylic acid, perfluorononanecarboxylic acid; 2-(perfluorooctyl)ethanecarboxylic acid, 1,1,2,2,3,3,4,4,5,5,6,6,7,7,8,8,9,9,10,10-eicosafluorodecanecarboxylic acid, perfluorodecanecarboxylic acid; 2-(perfluorononyl)ethanecarboxylic acid, 1,1,2,2,3,3,4,4,5,5,6,6,7,7,8,8,9,9,10,10,11,11-docosafluoroundecanecarboxylic acid, perfluoroundecanecarboxylic acid; 2-(perfluorodecyl)ethanecarboxylic acid, 1,1,2,2,3,3,4,4,5,5,6,6,7,7,8,8,9,9,10,10,11,11,12,12-tetracosafluorododecanecarboxylic acid, perfluorododecanecarboxylic acid; 2-(perfluoroundecyl) ethanecarboxylic acid, 1,1,2,2,3,3,4,4,5,5,6,6,7,7,8,8,9,9,10,10,11,11,12,12,13,13-hexacosafluorotridecanecarboxylic acid, perfluorotridecanecarboxylic acid; 2-(perfluorododecyl) ethanecarboxylic acid, 1,1,2,2,3,3,4,4,5,5,6,6,7,7,8,8,9,9,10,10,11,11,12,12,13,13,14,14-octacosafluorotetradecanecarboxylic acid, perfluorotetradecanecarboxylic acid; 2-(perfluorotridecyl)ethanecarboxylic acid, 1,1,2,2,3,3,4,4,5,5,6,6,7,7,8,8,9,9,10,10,11,11,12,12,13,13,14,14,15,15-triacontafluoropentadecanecarboxylic acid and perfluoropentadecanecarboxylic acid.

Those fluoroalkylsulfonic acids and fluoroalkylcarboxylic acids can be used alone or in a mixture of two or more thereof.

Preferred examples of the inorganic acid are sulfuric acid, hydrochloric acid, nitric acid, phosphoric acid, hydrofluoric acid, hydro bromic acid and the like. Those inorganic acids are preferred for the purpose of adjusting a pH value of the coating composition to $\leq 4.0$. The inorganic acid is usually used in an amount of 0.01-0.2 mass-% based on the coating composition. The above-mentioned organic acids and inorganic acids may be used alone or in a mixture of two or more thereof.

To the coating composition of the present invention may be added, as case demands, a water soluble polymer other than the fluorine-containing polymer (A1). The water soluble polymer can be used for improving film forming property, and may be used within a range (kind and amount of the polymer) neither having an adverse effect on a refractive index of the coating film nor lowering transparency of the coating film.

Examples of the water soluble polymer are, for instance, polyvinyl alcohols, polyalkyl vinyl ethers (polymethyl vinyl ether, polyethyl vinyl ether), polyacrylic acids, acrylate resins having carboxyl group, polymethacrylates, polyethylene glycols and celluloses.

A composition obtained by blending the water soluble polymer to the coating composition of the present invention is useful as a reflection reducing composition used for KrF resist and the like, and can make it possible to reduce an amount of perfluoroalkyl sulfonic acids (for example, those having 4-8 carbon atoms) which have been used for conventional compositions or can make use thereof unnecessary.

An amount of the water soluble polymer is 0.1-100 parts by mass (pbm), preferably 0.5-50 pbm, more preferably 1-30 pbm, particularly preferably 1-10 pbm based on 100 pbm of the fluorine-containing polymer (A1) contained in the coating composition.

To the coating composition of the present invention may be added, as case demands, a known photoacid generator. The addition of a photoacid generator to the coating composition can prevent diffusion and migration of an acid to the antireflection layer from the photoresist layer after the exposure and the resist pattern profile can be prevented from being in the form of T-top.

Examples of the acid generator are, for instance, onium salt, haloalkyl group-containing compound, o-quinonediazide compound, nitrobenzyl compound, sulfonic acid ester compound, sulfone compound and the like. Those acid generators can be used alone or in a mixture of two or more thereof. The preferred acid generator is onium salt.

An amount of the acid generator is usually $\leq 20$ pbm, preferably $\leq 10$ pbm, particularly preferably $\leq 5$ pbm based on 100 pbm of the fluorine-containing polymer (A1) contained in the coating composition. If the amount of the acid generator is too large, there is a tendency that developing property of the laminated resist is lowered and transparency and a refractive index of the antireflection film are deteriorated.

Also to the coating composition forming the antireflection film of the present invention may be added, as case demands, a defoaming agent, light absorbing agent, storage stabilizer, antiseptic agent, adhesion promoter, photoacid generator, dye and the like.

In the coating composition of the present invention, the content of the fluorine-containing polymer (A1) having hydrophilic group varies depending on kind and molecular weight of the polymer, kind and amount of additives, kind of a solvent and the like, and is optionally selected so that a suitable viscosity being capable of forming a thin coating film is obtained. For example, the content is 0.1-50 mass-%, preferably 0.5-30 mass-%, more preferably 1-20 mass-%, particularly preferably 2-10 mass-% based on the whole coating composition.

In the claims and specification of the present invention, physical properties are measured by the following methods. Measuring methods of a pKa value, refractive index, dissolution rate in a developing solution and reflectance are explained in examples.

(1) Analysis of composition: Calculated from data of $^1$H-NMR, $^{19}$F-NMR and IR.
AC-300 available from BRUKER is used for NMR.
Measurement is carried out at room temperature under the following conditions:

Measuring conditions of $^1$H-NMR: 300 MHz

(Tetramethylsilane=0 ppm)
Measuring conditions of $^{19}F$-NMR: 282 MHz
(Trichlorofluoromethane=0 ppm)
IR analysis: Measurement is carried out at room temperature with a Fourier-transform infrared spectrophotometer 1760X available from Perkin Elmer Co., Ltd.

(2) Fluorine content (mass-%):
The fluorine content is obtained by burning 10 mg of a sample by an oxygen flask combustion method, absorbing cracked gas in 20 ml of de-ionized water and then measuring a fluorine ion concentration in the solution by a fluoride-ion selective electrode method (using a fluorine ion meter model 901 available from Orion).
(3) Number average molecular weight:
A number average molecular weight is calculated based on monodisperse polystyrene from the data measured with gel permeation chromatography (GPC) by using GPC HLC-8020 available from Toso 20 Kabushiki Kaisha and columns available from Shodex (one GPC KF-801, one GPC KF-802 and two GPC KF-806M were connected in series) and flowing tetrahydrofuran (THF) as a solvent at a flowing rate of 1 ml/min.
(4) Content of hydrophilic groups Y (number of moles/100 g of polymer): Calculated from data of $^{1}H$-NMR, $^{19}F$-NMR and IR. AC-300 available from BRUKER is used for NMR.
Measurement is carried out at room temperature under the following conditions:

Measuring conditions of $^{1}H$-NMR: 300 MHz
(Tetramethylsilane=0 ppm)
Measuring conditions of $^{19}F$-NMR: 282 MHz
(Trichlorofluoromethane=0 ppm)
and the number of moles of hydrophilic groups contained in 100 g of polymer is calculated from the proportions of each structural unit in the polymer.

(5) Measurement of pH value of coating composition

Measurement of a pH value is carried out at 25°C with a pH METER F-22 available from HORIBA.
The present invention is then explained by means of examples but is not limited to them.

PREPARATION EXAMPLE 1

(Synthesis of fluorine-containing polymer having -COOH)

Into a 100 ml four-necked glass flask equipped with a stirrer and thermometer were poured 21.1 g of perfluoro-(9,9-dihydro-2,5-bistrifluoromethyl-3,6-dioxa-8-nonenoic acid) :

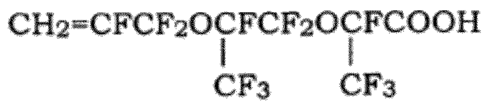

and 21.6 g of perfluorohexane solution of 8.0 mass-% of:

$$[H-(CF_2CF_2)_3COO]_2$$

(Solution (A)) and after sufficiently replacing the inside of the flask with nitrogen gas, polymerization reaction was continued at 20°C for 24 hours in nitrogen gas atmosphere and a solid having a high viscosity was obtained.
The obtained solid dissolved in acetone was poured into n-hexane and was subjected to separation and vacuum drying to obtain 17.6 g of a colorless transparent polymer.
According to $^{1}H$-NMR, $^{19}F$-NMR and IR analyses, the obtained polymer was found to be a fluorine-containing polymer containing only a structural unit of the above-mentioned fluorine-containing allyl ether having COOH group.
With respect to the molecular weight of the polymer, the above-mentioned GPC measurement was carried out after methyl-esterification of the carboxyl group in the polymer by the following method.

(Reaction of methyl-esterification)

In 5 ml of tetrahydrofuran (THF) was dissolved 1 g of the obtained polymer, and titration of 2-N hexane solution of trimethylsilyldiazomethane was carried out with stirring until the reaction solution turned to light yellow. After the reaction, the solvent was distilled off under reduced pressure and according to $^{1}$H-NMR analysis of the obtained reaction product, it was confirmed that all COOH groups of the sample was converted to methyl ester.

After the conversion to methyl ester, the number average molecular weight of the fluorine-containing polymer measured by GPC was 13,000.

PREPARATION EXAMPLE 2

(Synthesis of fluorine-containing polymer having COOH group)

Polymerization reaction and separation of a polymer were carried out in the same manner as in Preparation Example 1 except that 23.5 g of perfluoro-(12,12-dihydro-2,5,8-tristrifluoromethyl-3,6,9-trioxa-11-dodecenic acid):

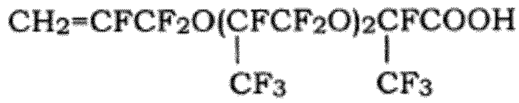

was used instead of perfluoro-(9,9-dihydro-2,5-bistrifluoromethyl-3,6-dioxa-8-nonenoic acid) and 17.3 g of Solution (A) was used, and 20.6 g of a colorless transparent polymer was obtained.

According to $^{1}$H-NMR, $^{19}$F-NMR and IR analyses, the obtained polymer was found to be a fluorine-containing polymer containing only a structural unit of the above-mentioned fluorine-containing allyl ether having COOH group.

PREPARATION EXAMPLE 3

(Synthesis of fluorine-containing polymer having COOH group)

Polymerization reaction and separation of a polymer were carried out in the same manner as in Preparation Example 1 except that 22.6 g of perfluoro-(15,15-dihydro-2,5,8,11-tetrakistrifluoromethyl-3,6,9,12- tetraoxa-14-pentadecenic acid):

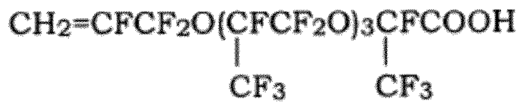

was used instead of perfluoro-(9,9-dihydro-2,5-bistrifluoromethyl-3,6-dioxa-8-nonenoic acid) and 12.9 g of Solution (A) was used, and 18.6 g of a colorless transparent polymer was obtained.

According to $^{1}$H-NMR, $^{19}$F-NMR and IR analyses, the obtained polymer was found to be a fluorine-containing polymer containing only a structural unit of the above-mentioned fluorine-containing allyl ether having COOH group.

PREPARATION EXAMPLE 4

(Synthesis of fluorine-containing polymer having COOH group)

Into a 100 ml four-necked glass flask equipped with a stirrer and thermometer were poured 5.0 g of 1,1,2,4,4,8-hexahydro-3-oxa-1-octene: $CH_2$=$CHOCH_2(CF_2CF_2)_2$-H, 50 g of ethyl acetate and 0.03 g of azobisisobutyronitrile (AIBN), and after replacing the inside of the system with nitrogen gas, 5 g of 2-(trifluoromethyl)acrylic acidwas added and a reaction was continued at 60°C in a stream of nitrogen gas with stirring.

The obtained reaction solution was taken out and was subjected to re-precipitation with a hexane solvent to separate a solid. This solid was subjected to vacuum drying until a constant weight was reached, and 9.1 g of a copolymer in the form of white powder was obtained.

According to $^{1}$H-NMR and $^{19}$F-NMR analyses, the copolymer was one containing perfluoro(1,1,2,4,4,8-hexahydro-3-oxa-1-octene) and 2-(trifluoromethyl)acrylic acid in a percent by mole ratio of 50/50. The number average molecular weight thereof was 87,000.

PREPARATION EXAMPLE 5

(Synthesis of fluorine-containing polymer having COOH group)

Polymerization reaction and separation of a polymer were carried out in the same manner as in Preparation Example 4 except that 4.0 g of maleic anhydride was used instead of 2-(trifluoromethyl)acrylic acid, and 8.2 g of a polymer in the form of white powder was obtained.

According to $^1$H-NMR and $^{19}$F-NMR analyses, the copolymer was one containing perfluoro(1,1,2,4,4,8-hexahydro-3-oxa-1-octene) and maleic anhydride in a percent by mole ratio of 50/50.

The obtained polymer was poured into 100 ml of aqueous solution of 1N-NaOH and was dissolved homogeneously by stirring. To this solution was added 35 % concentrated hydrochloric acid to adjust its pH value to 2 or less. The acidic solution was extracted with dichloromethane to take out an organic substance. After drying of the organic layer, dichloromethane was concentrated and distilled off. As a result, 7.0 g of a copolymer in the form of white solid was obtained.

According to $^1$H-NMR and $^{19}$F-NMR analyses, the copolymer was one containing perfluoro(1,1,2,4,4,8-hexahydro-3-oxa-1-octene) and maleic acid in a percent by mole ratio of 50/50.

REFERENCE PREPARATION EXAMPLE 7

(Synthesis of fluorine-containing polymer having OH group as the hydrophilic group Y)

Into a 100 ml stainless steel autoclave equipped with a valve, pressure gauge and thermometer were poured 5.2 g of 1,1-bistrifluoromethyl-3-buten-1-ol:

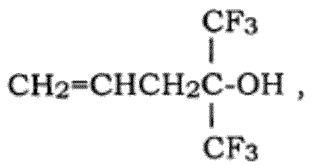

30 ml of $CH_3CCl_2F$ (HCFC-141b) and 10 g of perfluorohexane solution of 10 % by mole of n-heptafluorobutyryl peroxide (HBP), and the inside of the system was sufficiently replaced with nitrogen gas while cooling with dry ice/methanol solution. Then 10 g of tetrafluoroethylene (TFE) was introduced through the valve and a reaction was carried out at 30°C with shaking. During the reaction, there was no change in a gauge pressure in the system (9.0 MPaG before starting of the reaction), and also 20 hours after, the gauge pressure was 9.0 MPaG.

Twenty hours after starting of the reaction, the unreacted monomer was released. The precipitated solid was taken out and dissolved in acetone and was subjected to re-precipitation with a hexane solvent to separate and refine a solid. The solid was vacuum-dried until a constant weight was reached, and 3.0 g of a copolymer was obtained.

According to $^1$H-NMR and $^{19}$F-NMR analyses, the copolymer was one containing 1,1-bistrifluoromethyl-3-buten-1-ol and tetrafluoroethylene in a percent by mole ratio of 50/50. The number average molecular weight thereof was 4,900.

PREPARATION EXAMPLE 8

(Synthesis of fluorine-containing polymer having -COOH group)

Polymerization reaction and post-treatment were carried out in the same manner as in Preparation Example 1 except that 40.0 g of perfluoro-(9,9-dihydro-2,5-bistrifluoromethyl-3,6-dioxa-8-nonenoic acid):

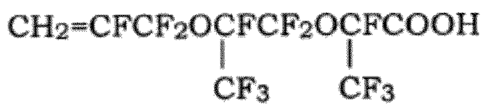

and 59.2 g of Solution (A) were used, and 38.2 g of a colorless transparent polymer was obtained.

According to $^1$H-NMR, $^{19}$F-NMR and IR analyses, the obtained polymer was found to be a fluorine-containing polymer containing only a structural unit of the above-mentioned fluorine-containing allyl ether having COOH group.

Also GPC measurement was carried out after methyl-esterification of carboxyl group in the same manner as

in Preparation Example 1. The number average molecular weight thereof was 7,800.

PREPARATION EXAMPLE 9

(Synthesis of fluorine-containing polymer having -COOH group)

Polymerization reaction and post-treatment were carried out in the same manner as in Preparation Example 1 except that 40.0 g of perfluoro-(9,9-dihydro-2,5-bistrifluoromethyl-3,6-dioxa-8-nonenoic acid) :

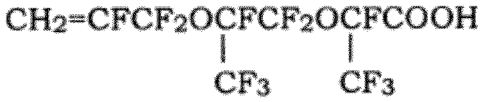

and 8.46 g of Solution (A) were used, and 32.6 g of a colorless transparent polymer was obtained.

According to $^{1}$H-NMR, $^{19}$F-NMR and IR analyses, the obtained polymer was found to be a fluorine-containing polymer containing only a structural unit of the above-mentioned fluorine-containing allyl ether having COOH group.

Also GPC measurement was carried out after methyl-esterification of carboxyl group in the same manner as in Preparation Example 1. The number average molecular weight thereof was 29,000.

PREPARATION EXAMPLE 10

(Synthesis of fluorine-containing polymer having -COOH group)

Into a 100 ml four-necked glass flask equipped with a stirrer and thermometer were poured 30.0 g of perfluoro-(6,6-dihydro-2-trifluoromethyl-3-oxa-5-hexenoic acid):

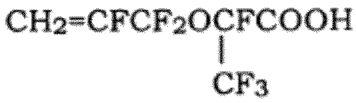

and 31.4 g of Solution (A) and after sufficiently replacing the inside of the flask with nitrogen gas, polymerization reaction was continued at 20°C for 24 hours in nitrogen gas atmosphere and a solid having a high viscosity was obtained.

The obtained solid dissolved in acetone was poured into n-hexane and then subjected to separation and vacuum drying to obtain 27.9 g of a colorless transparent polymer.

According to $^{1}$H-NMR, $^{19}$F-NMR and IR analyses, the obtained polymer was found to be a fluorine-containing polymer containing only a structural unit of the above-mentioned fluorine-containing allyl ether having COOH group.

Also GPC measurement was carried out after methyl-esterification of carboxyl group in the same manner as in Preparation Example 1. The number average molecular weight thereof was 11,000.

PREPARATION EXAMPLE 11

(Synthesis of fluorine-containing polymer having -COOH group)

Polymerization reaction and post-treatment were carried out in the same manner as in Preparation Example 10 except that 50.0 g of perfluoro-(6,6-dihydro-2-trifluoromethyl-3-oxa-5-hexenoic acid):

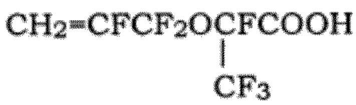

and 13.9 g of Solution (A) were used, and 43.2 g of a colorless transparent polymer was obtained.

According to $^{1}$H-NMR, $^{19}$F-NMR and IR analyses, the obtained polymer was found to be a fluorine-containing polymer containing only a structural unit of the above-mentioned fluorine-containing allyl ether having COOH group.

Also GPC measurement was carried out after methyl-esterification of carboxyl group in the same manner as in Preparation Example 1. The number average molecular weight thereof was 34,000.

PREPARATION EXAMPLE 12

(Synthesis of fluorine-containing polymer having -COOH group)

Polymerization reaction and post-treatment were carried out in the same manner as in Preparation Example 10 except that 5.0 g of perfluoro-(6,6-dihydro-2-trifluoromethyl-3-oxa-5-hexenoic acid):

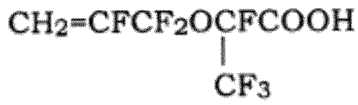

and 1.39 g of Solution (A) were used, and 4.1 g of a colorless transparent polymer was obtained.
According to $^1$H-NMR, $^{19}$F-NMR and IR analyses, the obtained polymer was found to be a fluorine-containing polymer containing only a structural unit of the above-mentioned fluorine-containing allyl ether having COOH group.
Also GPC measurement was carried out after methyl-esterification of carboxyl group in the same manner as in Preparation Example 1. The number average molecular weight thereof was 55,000.

PREPARATION EXAMPLE 13

(Synthesis of fluorine-containing polymer having -COOH group)

Polymerization reaction and post-treatment were carried out in the same manner as in Preparation Example 10 except that 50.0 g of perfluoro-(9,9-dihydro-2,5-bistrifluoromethyl-3,6-dioxa-8-nonenoic acid :

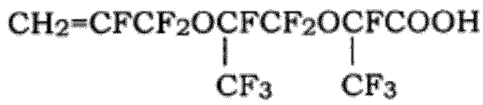

and 5.3 g of Solution (A) were used, and 39.5 g of a colorless transparent polymer was obtained.
According to $^1$H-NMR, $^{19}$F-NMR and IR analyses, the obtained polymer was found to be a fluorine-containing polymer containing only a structural unit of the above-mentioned fluorine-containing allyl ether having COOH group.
Also GPC measurement was carried out after methyl-esterification of carboxyl group in the same manner as in Preparation Example 1. The number average molecular weight thereof was 50,000.

PREPARATION EXAMPLE 14

(Synthesis of fluorine-containing polymer having -COOH group

Into a 100 ml four-necked glass flask equipped with a stirrer and thermometer were poured 10.0 g of perfluoro-(6,6-dihydro-2-trifluoromethyl-3-oxa-5-hexenoic acid) :

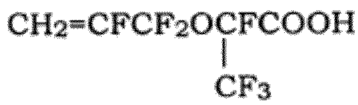

and a solution prepared by dissolving 89 mg of ammonium persulfate in 20 g of water and after sufficiently replacing the inside of the flask with nitrogen gas, polymerization reaction was continued at 80°C for six hours in nitrogen gas atmosphere. After completion of the polymerization, to the obtained solution was added 10 g of 10 % hydrochloric acid to precipitate the polymer. The precipitated polymer dissolved in acetone was poured into n-hexane and then subjected to separation and vacuum drying to obtain 8.3 g of a colorless transparent polymer.
According to $^1$H-NMR, $^{19}$F-NMR and IR analyses, the obtained polymer was found to be a fluorine-containing polymer containing only a structural unit of the above-mentioned fluorine-containing allyl ether having COOH group.
Also GPC measurement was carried out after methyl-esterification of carboxyl group in the same manner as in Preparation Example 1. The number average molecular weight thereof was 54,000.

PREPARATION EXAMPLE 15

(Synthesis of fluorine-containing polymer having -COOH group)

Into a 100 ml four-necked glass flask equipped with a stirrer and thermometer were poured 25.0 g of perfluoro-(9,9-dihydro-2,5-bistrifluoromethyl-3,6-dioxa-8-nonenoic acid) :

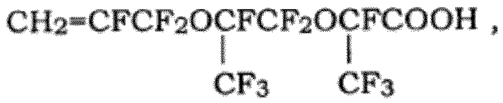

25.0 g of perfluoro-(6,6-dihydro-2-trifluoromethyl-3-oxa-5-hexenoic acid) :

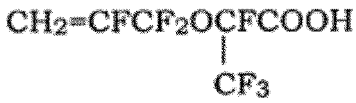

and a solution prepared by dissolving 180 mg of ammonium persulfate in 100 g of water and after sufficiently replacing the inside of the flask with nitrogen gas, polymerization reaction was continued at 80°C for six hours in nitrogen gas atmosphere. After completion of the polymerization, to the obtained solution was added 50 g of 10 % hydrochloric acid to precipitate the polymer. The precipitated polymer dissolved in acetone was poured into n-hexane and then subjected to separation and vacuum drying to obtain 38 g of a colorless transparent polymer.

According to $^{1}$H-NMR, $^{19}$F-NMR and IR analyses, the obtained polymer was found to be a fluorine-containing polymer containing perfluoro-(9,9-dihydro-2,5-bistrifluoromethyl-3,6-dioxa-8-nonenoic acid) and perfluoro-(6,6-dihydro-2-trifluoromethyl-3-oxa-5-hexenoic acid) in a percent by mole ratio of 38/62.

Also GPC measurement was carried out after methyl-esterification of carboxyl group in the same manner as in Preparation Example 1. The number average molecular weight thereof was 39,000.

PREPARATION EXAMPLE 16

(Synthesis of fluorine-containing polymer having -COOH group)

Into a 100 ml four-necked glass flask equipped with a stirrer and thermometer were poured 15.0 g of perfluoro-(9,9-dihydro-2,5-bistrifluoromethyl-3,6-dioxa-8-nonenoic acid):

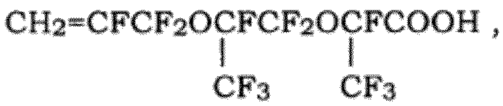

35.0 g of perfluoro-(6,6-dihydro-2-trifluoromethyl-3-oxa-5-hexenoic acid):

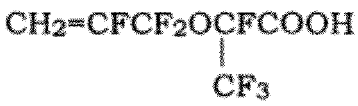

and a solution prepared by dissolving 200 mg of ammonium persulfate in 100 g of water and after sufficiently replacing the inside of the flask with nitrogen gas, polymerization reaction was continued at 80°C for six hours in nitrogen gas atmosphere. After completion of the polymerization, to the obtained solution was added 50 g of 10 % hydrochloric acid to precipitate the polymer. The precipitated polymer dissolved in acetone was poured into n-hexane and then subjected to separation and vacuum drying to obtain 8.3 g of a colorless transparent polymer.

The obtained solid was dissolved in acetone, poured into n-hexane and then subjected to separation and vacuum drying to obtain 39 g of a colorless transparent polymer.

According to $^{1}$H-NMR, $^{19}$F-NMR and IR analyses, the obtained polymer was found to be a fluorine-containing polymer containing perfluoro-(9,9-dihydro-2,5-bistrifluoromethyl-3,6-dioxa-8-nonenoic acid) and perfluoro-(6,6-dihydro-2-trifluoromethyl-3-oxa-5-hexenoic acid) in a percent by mole ratio of 17/83.

Also GPC measurement was carried out after methyl-esterification of carboxyl group in the same manner as in Preparation Example 1. The number average molecular weight thereof was 37,000.

PREPARATION EXAMPLE 17

(Synthesis of fluorine-containing polymer having -COOH group)

Into a 300 ml autoclave were poured 20.0 g of perfluoro-(6,6-dihydro-2-trifluoromethyl-3-oxa-5-hexenoic acid):

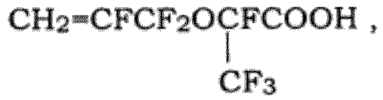

80 g of $CH_3CCl_2F$ and 0.2 g of dinormalpropylperoxy dicarbonate. After sufficiently replacing the inside of the autoclave with nitrogen, 20 g of tetrafluoroethylene was introduced. This autoclave was subjected to shaking on a 40°C hot water bath for 15 hours, and a colorless transparent solid was produced.

This solid dissolved in acetone was poured into n-hexane, followed by separation and vacuum drying, and 17.3 g of a colorless transparent polymer was obtained.

According to $^{19}F$-NMR analysis, $^{1}H$-NMR analysis and IR analysis, the polymer was a copolymer containing:

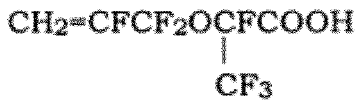

and tetrafluoroethylene in a percent by mole ratio of 67:33.

Also after methyl-esterification of the carboxyl group in the same manner as in Preparation Example 1, measurement by GPC was carried out. The number average molecular weight thereof was 61,000.

PREPARATION EXAMPLE 18

(Synthesis of fluorine-containing polymer having -COOH group)

Into a 100 ml autoclave were poured 10.0 g of perfluoro-(6,6-dihydro-2-trifluoromethyl-3-oxa-5-hexenoic acid):

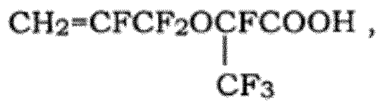

40 g of $CH_3CCl_2F$ and 0.1 g of dinormalpropylperoxy dicarbonate. After sufficiently replacing the inside of the autoclave with nitrogen, 5 g of tetrafluoroethylene was introduced. This autoclave was subjected to shaking on a 40°C hot water bath for 15 hours, and a colorless transparent solid was produced.

This solid dissolved in acetone was poured into n-hexane, followed by separation and vacuum drying, and 7.5 g of a colorless transparent polymer was obtained.

According to $^{19}F$-NMR analysis, $^{1}H$-NMR analysis and IR analysis, the polymer was a copolymer containing:

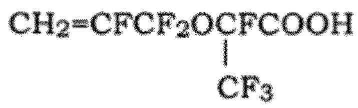

and tetrafluoroethylene in a percent by mole ratio of 82:18.

Also after methyl-esterification of the carboxyl group in the same manner as in Preparation Example 1, measurement by GPC was carried out. The number average molecular weight thereof was 46,000.

EXPERIMENTAL EXAMPLE 1

(To confirm solubility of fluorine-containing polymer in a solvent)

Solubility in water and alcohols was confirmed using the fluorine-containing polymers having hydrophilic group which were obtained in Preparation Examples 1-5 and 10-18.

The polymers were blended in each solvent shown in Table 1 so that concentrations thereof became 5 mass-%, and were allowed to stand at room temperature for 24 hours with stirring. Then appearance of the solutions was evaluated. The evaluation was made by the following criteria. The results are shown in Table 1.

O: A polymer is completely soluble, and a solution becomes transparent and homogeneous.
X: A polymer is partly insoluble or completely insoluble, and a solution is not transparent.

TABLE 1

| | Water | Methanol | Ethanol | Isopropanol |
|---|---|---|---|---|
| Preparation Example 1 | ○ | ○ | ○ | ○ |
| Preparation Example 2 | ○ | ○ | ○ | ○ |
| Preparation Example 3 | X | X | X | X |
| Preparation Example 4 | ○ | ○ | ○ | ○ |
| Preparation Example 5 | ○ | ○ | ○ | ○ |
| | | | | |
| | | | | |
| Preparation Example 10 | ○ | ○ | ○ | ○ |
| Preparation Example 11 | ○ | ○ | ○ | ○ |
| Preparation Example 12 | ○ | ○ | ○ | ○ |
| Preparation Example 13 | ○ | ○ | ○ | ○ |
| Preparation Example 14 | ○ | ○ | ○ | ○ |
| Preparation Example 15 | ○ | ○ | ○ | ○ |
| Preparation Example 16 | ○ | ○ | ○ | ○ |
| Preparation Example 17 | ○ | ○ | ○ | ○ |
| Preparation Example 18 | ○ | ○ | ○ | ○ |

EXPERIMENTAL EXAMPLE 2

(Measurement of a pKa value of a monomer having hydrophilic group)

With respect to the monomers having hydrophilic group used in Preparation Examples 1-5 and 10, and Reference Preparation Example 7 a pKa value of hydrophilic group thereof was calculated by the following method (in Preparation Example 5, measurement was made with respect to maleic acid instead of maleic anhydride).

(Method of determining a pKa value)

The method of determining a pKa value is mentioned below using 1,1-bistrifluoromethyl-3-buten-1-ol:

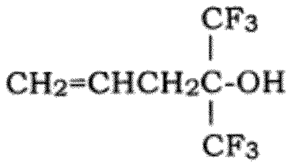

(used in Reference Preparation Example 7) as an example of a monomer.

In a water/acetone mixture (10/15 ml) solution was poured 0.7865 g of $CH_2=CHCH_2C(CF_3)_2OH$, followed by stirring at room temperature. After it was confirmed that the solution was homogeneous, titration was carried out with about 0.2 mol/L NaOH solution. A titration curve was obtained by adding the NaOH solution dropwise in increments of 0.15 ml and recording a pH value at every addition. An equivalence point was determined by an inflection point (maximum differential value of titration curve = dpH/dml) of the titration curve. In this case, the equivalence point was 14.5 ml. A pH value at 7.25 ml which was a half of the equivalence point was read from the titration curve and was found to be 10.58. From a titration curve of water/acetone solution and aqueous solution which had been measured previously as a blank solution, a difference in a pH value derived from an electric potential difference between the solutions at titration of 7.25 ml was 1.29. Therefore from 10.98 - 1.29 = 9.69, it was decided that a pKa value of this $CH_2=CHCH_2C(CF_3)_2OH$ was 9.69.

In the case of titration of 1.0865 g of $CH_2=CHCH_2C(CF_3)_2OH$ by the same procedures as above, an equivalence point was 20.15 ml and a half of equivalence point was 10.08 ml. A pH value at a half of the equivalence point was 10.78. A difference in a pH value between the both solutions at 10.08 ml was 1.14, and from 10.78 - 1.14 = 9.64, it was decided that a pKa value of $CH_2=CHCH_2C(CF_3)_2OH$ was 9.64.

When the same procedures as above were carried out by changing the titration solution to about 0.05 mol/L NaOH, an equivalence point of 0.115 g of $CH_2=CHCH_2C(CF_3)_2OH$ was 8.00 ml and a half of the equivalence point was 4.00 ml. A pH value at this time was 10.92. A difference in a pH value between the both solutions at 4.00 ml was 1.38, and from 10.92 - 1.38 = 9.54, it was decided that a pKa value of $CH_2=CHCH_2C(CF_3)_2OH$ was 9.54.

From those experiments carried out three times, it was decided that a pKa value of $CH_2=CHCH_2C(CF_3)_2OH$ was 9.6.

With respect to the various fluorine-containing ethylenic monomers having OH group shown in Table 2, a pKa value was measured by the same procedures as above. The results are shown in Table 2.

TABLE 2

| | Monomer having hydrophilic group | pKa |
|---|---|---|
| Prep. Ex. 1 | 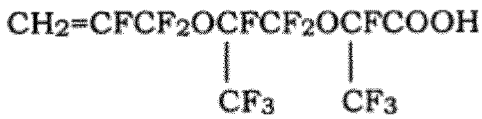 | 3.6 |
| Prep. Ex. 2 | 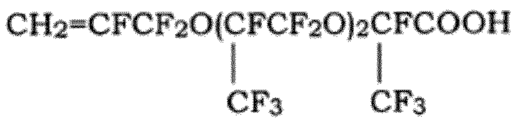 | 3.8 |
| Prep. Ex. 3 | 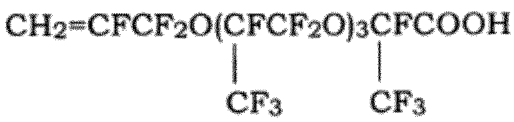 | 4.0 |
| Prep. Ex. 4 | 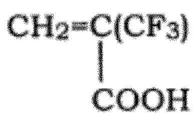 | 3.9 |
| Prep. Ex. 5 | Maleic acid | 1.4 |

(continued)

| | Monomer having hydrophilic group | pKa |
|---|---|---|
| Ref. Prep. Ex. 7 | 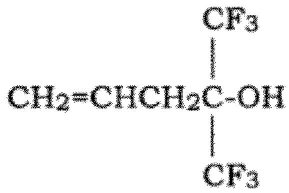 | 9.6 |
| Prep. Ex. 10 | 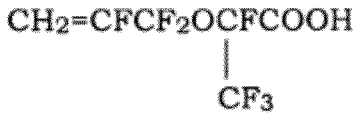 | 3.4 |

EXPERIMENTAL EXAMPLE 3

(Measurement of fluorine content and hydrophilic group content)

With respect to the fluorine-containing polymers having hydrophilic group obtained in Preparation Examples 1-5, 10 and 15-18, a fluorine content (mass-%) and a hydrophilic group content (number of moles/100 g of polymer) thereof were measured. The results are shown in Table 3.

TABLE 3

| | Fluorine content (mass-%) | Hydrophilic group content (number of moles/100 g of polymer) |
|---|---|---|
| Prep. Ex. 1 | 58.5 | 0.237 |
| Prep. Ex. 2 | 61.4 | 0.170 |
| Prep. Ex. 3 | 64.2 | 0.135 |
| Prep. Ex. 4 | 52.5 | 0.251 |
| Prep. Ex. 5 | 42.4 | 0.532 |
| Prep. Ex. 10 | 52.0 | 0.39 |
| Prep. Ex. 15 | 54.9 | 0.323 |
| Prep. Ex. 16 | 53.6 | 0.352 |
| Prep. Ex. 17 | 55.8 | 0.33 |
| Prep. Ex. 18 | 54.0 | 0.36 |

EXPERIMENTAL EXAMPLE 4

(Preparation of coating composition)

The fluorine-containing polymers obtained in Preparation Examples 1, 2, 4 and 5 respectively were dissolved in an amount of 10 g in 10 ml of methanol. The obtained total amount of methanol solution of fluorine-containing polymer was added dropwise in 150 ml of pure water over about ten minutes at room temperature with stirring.

Further pure water was added thereto to adjust the total amount of composition to 200 ml, followed by filtrating with a filter having an opening size of 0.2 μm to obtain a homogeneous coating composition.

EXPERIMENTAL EXAMPLE 6

(Preparation of coating composition)

The fluorine-containing polymer obtained in Preparation Example 3 was dissolved in an amount of 10 g in 200 ml of acetone, and then subjected to filtration with a filter having an opening size of 0.2 μm to obtain a homogeneous

coating composition.

EXPERIMENTAL EXAMPLE 7

(Preparation of coating composition)

The fluorine-containing polymer obtained in Preparation Example 1 was dissolved in an amount of 21.1 g in 20 ml of methanol, and further 0.6 g of ethanolamine was blended thereto. The obtained total amount of methanol solution of fluorine-containing polymer was added dropwise in 350 ml of pure water over about ten minutes at room temperature with stirring, and further pure water was added thereto to adjust the total amount of composition to 420 ml, followed by filtrating with a filter having an opening size of 0.2 μm to obtain a 20 homogeneous coating composition.

EXPERIMENTAL EXAMPLE 8

(Preparation of coating composition)

A coating composition of fluorine-containing polymer was obtained in the same manner as in Experimental Example 7 except that ethanolamine was added in an amount of 1.5 g.

EXPERIMENTAL EXAMPLE 9

(Preparation of coating composition)

A coating composition of fluorine-containing polymer was obtained in the same manner as in Experimental Example 7 except that ethanolamine was added in an amount of 3.0 g.

EXPERIMENTAL EXAMPLE 10

(Measurement of refractive index of coating film)

The respective coating compositions prepared in Experimental Examples 4 and 6-9 were coated on a 8-inch silicon wafer substrate with a spin coater at 300 rpm for three seconds and then at 4,000 rpm for twenty seconds while rotating the wafer to form a coating film so that a thickness of the dried coating film became about 100 nm.

With respect to the respective coating films formed on the silicon wafer substrate by the above-mentioned method, refractive indices thereof were measured. The results are shown in Table 4. (Measurement of refractive index)

A refractive index at 193 nm wavelength and a coating thickness are measured with a spectroscopic ellipsometer (VASE ellipsometer available from J.A. Woollam).

EXPERIMENTAL EXAMPLE 11

(Measurement of a dissolution rate of a coating film in a developing solution)

A dissolution rate (nm/sec) in a developing solution was measured in the manner mentioned below by the quartz crystal oscillation method (QCM method). The results are shown in Table 4.

Production of sample:

The respective coating compositions prepared in Experimental Examples 4 and 6-9 were applied on a 24 mm diameter quartz oscillation panel coated with gold and was dried to make an about 100 nm coating film.

Measurement of dissolution rate in a developing solution:

A coating film thickness is calculated by converting the number of oscillations of the quartz crystal oscillation panel.

The quartz oscillation panel produced above by coating the fluorine-containing polymer was dipped in an aqueous solution of 2.38 mass-% of tetramethylammonium hydroxide (TMAH) as a standard developing solution. After the dipping of the panel, a change in a coating thickness was obtained from a change in the number of oscillations with the progress of time, and a dissolution rate per unit time (nm/sec) was calculated (Reference bulletin: Advances in Resist

Technology and Proceedings of SPIE Vol. 4690, 904(2002)).

EXAMPLE 1

(Formation of laminated resist)

Formation of photoresist layer (L1):

A photoresist TArF-P6071 for ArF lithography (Tokyo Ohka Kogyo Kabushiki Kaisha) was coated on a 8-inch silicon substrate with a spin coater while changing the number of revolutions to adjust the coating thickness to be 200-300 nm, followed by pre-baking at 130°C for 60 seconds to form the photoresist layer (L1).

Formation of antireflection layer (L2):

On the photoresist layer (L1) formed above were coated the respective coating compositions containing the fluorine-containing polymer having hydrophilic group which were prepared in Experimental Examples 4 and 7-9 with a spin coater at 300 rpm for three seconds and then at 4,000 rpm for twenty seconds while rotating the wafer to form the antireflection layer (L2) so that the coating thickness became about 100 nm. Thus the laminated photoresist was formed.

The reflectance at 193 nm of the obtained laminated photoresist was measured. The results are shown in Table 4.

(Measurement of reflectance)

A reflectance at 193 nm wavelength is measured with a spectroscopic ellipsometer (VASE ellipsometer available from J.A. Woollam).

Also with respect to the laminated photoresist produced by forming the antireflection layer (L2) in the same manner as above by using the fluorine-containing polymer which was confirmed to have solubility in a developing solution in Experimental Example 11, stationary puddle-developing was carried out at 23°C for 60 seconds by using a developing solution of 2.38 mass-% of tetramethylammonium hydroxide and then rinsing with pure water was carried out. It was confirmed that in any of coating compositions, the antireflection layer (L2) had been selectively removed.

TABLE 4

| Coating composition | Experimental Example 4 | | | |
|---|---|---|---|---|
| (A) Fluorine-containing polymer | Prep. Ex. 1 | Prep. Ex. 2 | Prep. Ex. 4 | Prep. Ex. 5 |
| Fluorine content (% by mass) | 58.5 | 61.4 | 52.5 | 42.4 |
| Kind of hydrophilic group | COOH | COOH | COOH | COOH |
| pKa value of hydrophilic group | 3.6 | 3.8 | 3.9 | 1.4 |
| Hydrophilic group content (mole/100 g of polymer) | 0.237 | 0.170 | 0.251 | 0.279 |
| Concentration of polymer (g/100 ml) | 5.0 | 5.0 | 5.0 | 5.0 |
| (B) Solvent (% by volume) | | | | |
| Water | 95 | 95 | 95 | 95 |
| Methanol | 5 | 5 | 5 | 5 |
| Acetone | | | | |

- continued-

- continued -

| Coating composition | Experimental Example 6 | Experimental Example 7 | Experimental Example 8 | Experimental Example 9 |
|---|---|---|---|---|
| (A) Fluorine-containing polymer | Prep. Ex. 3 | | Prep. Ex. 1 | |
| Fluorine content (% by mass) | 64.2 | | 58.5 | |
| Kind of hydrophilic group | COOH | | COOH | |
| pKa value of hydrophilic group | 4.0 | | 3.6 | |
| Hydrophilic group content (mole/100 g of polymer) | 0.135 | | 0.237 | |
| Concentration of polymer (g/100 ml) | 5.0 | | 5.0 | |
| (B) Solvent (% by volume) | | | | |
| Water | | | 95 | |
| Methanol | | | 5 | |
| Acetone | 100 | | | |

- continued -

- continued -

| Coating composition | Experimental Example 4 | | | | Experimental Example 5 |
|---|---|---|---|---|---|
| (C) Organic amine (equivalent/hydrophilic group) | | | | | |
| Ethanolamine | | | | | |
| Characteristics of coating film | | | | | |
| Refractive index (λ = 193 nm) | 1.41 | 1.39 | 1.45 | 1.51 | |
| Dissolution rate in a developing solution (nm/sec) | 150 | 100 | 1000 | 1000 | |
| Characteristics of laminated resist | | | | | |
| Reflectance (%) | 1.17 | 0.9 | 1.84 | 3.07 | |

- continued -

- continued -

| Coating composition | Experimental Example 6 | Experimental Example 7 | Experimental Example 8 | Experimental Example 9 |
|---|---|---|---|---|
| (C) Organic amine (equivalent/ hydrophilic group) | | | | |
| Ethanolamine | | 0.2 | 0.5 | 1.0 |
| Characteristics of coating film | | | | |
| Refractive index ($\lambda$ = 193 nm) | 1.38 | 1.41 | 1.42 | 1.43 |
| Dissolution rate in a developing solution (nm/sec) | Insoluble | 200 | 300 | 500 |
| Characteristics of laminated resist | | | | |
| Reflectance (%) | - | 1.17 | 1.33 | 1.49 |

EXPERIMENTAL EXAMPLE 12

(Solubility of fluorine-containing polymer (A1) in a solvent mixture of water / isopropanol)

To 1 g each of the respective fluorine-containing polymers obtained in Preparation Examples 1 and 8-18 was added 9 g of a solvent mixture of water/isopropanol (IPA) having the composition shown in Table 5, followed by allowing to stand at room temperature for 24 hours with stirring and then further allowing to stand at room temperature for 24 hours. Then appearance of the solution was observed.

Evaluation was carried out by the following criteria. The results are shown in Table 5.

O: A polymer is completely soluble, and a solution becomes transparent and homogeneous and has a low viscosity.
Δ: A solution becomes transparent and homogeneous, but is in the form of gel having a high viscosity.
X : The polymer is partly insoluble or completely insoluble, and a solution is opaque.

The results are shown in Table 5.

TABLE 5

| Polymer (A1) | Prep. Ex. 8 | Prep. Ex. 1 | Prep. Ex. 9 | Prep. Ex. 10 | Prep. Ex. 11 | Prep. Ex. 12 |
|---|---|---|---|---|---|---|
| Number average molecular weight | 7800 | 13000 | 29000 | 11000 | 34000 | 55000 |
| Solubility<br>Water/IPA ratio (% by mass) | | | | | | |
| 0/100 | O | O | O | O | O | O |
| 60/40 | O | O | O | O | O | O |
| 65/35 | X | O | O | O | O | O |
| 70/30 | X | X | O | O | O | O |
| 75/25 | X | X | X | X | O | O |
| 80/20 | X | X | X | X | X | O |
| 85/15 | X | X | X | X | X | X |
| 100/0 | Δ | Δ | Δ | O | O | O |

- continued -

- continued -

| Polymer (A1) | Prep. Ex. 13 | Prep. Ex. 14 | Prep. Ex. 15 | Prep. Ex. 16 | Prep. Ex. 17 | Prep. Ex. 18 |
|---|---|---|---|---|---|---|
| Number average molecular weight | 50000 | 54000 | 39000 | 37000 | 61000 | 46000 |
| Solubility<br>Water/IPA ratio (% by mass) | | | | | | |
| 0/100 | O | O | O | O | O | O |
| 60/40 | O | O | O | O | O | O |
| 65/35 | O | O | O | O | O | O |
| 70/30 | O | O | O | O | O | O |
| 75/25 | O | O | O | O | O | O |
| 80/20 | O | O | X | X | O | O |
| 85/15 | X | X | X | X | O | O |
| 100/0 | Δ | O | O | O | O | O |

EXAMPLE 2

(Preparation of coating composition)

The fluorine-containing polymer obtained in Preparation Example 1 was dissolved in an amount of 10 g in 35 g of isopropanol. The total amount of the obtained isopropanol solution of fluorine-containing polymer was added dropwise to 65 g of pure water at room temperature over about 10 minutes with stirring. Further a solution mixture of water/isopropanol of 65/35 mass-% was added thereto to adjust the total amount of the composition to 200 g, and 10 then filtration was carried out with a filter having an opening size of 0.2 μm to obtain a homogeneous coating composition.

EXAMPLE 3

(Preparation of coating composition)

The fluorine-containing polymer obtained in Preparation Example 9 was dissolved in an amount of 10 g in 30 g of isopropanol. The total amount of the obtained isopropanol solution of fluorine-containing polymer was added dropwise to 70 g of pure water at room temperature over about 10 minutes with stirring. Further a solution mixture of water/isopropanol of 70/30 mass-% was added thereto to adjust the total amount of the composition to 200 g, and then filtration was carried out with a filter having an opening size of 0.2 μm to obtain a homogeneous coating composition.

EXPERIMENTAL EXAMPLE 13

The fluorine-containing polymer obtained in Preparation Example 8 was dissolved in an amount of 10 g in 40 g of isopropanol. The total amount of the obtained isopropanol solution of fluorine-containing polymer was added dropwise to 60 g of pure water at room temperature over about 10 minutes with stirring. Further a solution mixture of water/isopropanol of 60/40 mass-% was added thereto to adjust the total amount of the composition to 200 g, and then filtration was carried out with a filter having an opening size of 0.2 μm to obtain a homogeneous coating composition.

EXAMPLE 4

(Preparation of coating composition)

The fluorine-containing polymer obtained in Preparation Example 10 was mixed in an amount of 10 g to 190 g of pure water, and was completely dissolved by stirring at room temperature for 24 hours. The obtained aqueous solution was filtrated with a filter having an opening size of 0.2 μm to obtain a homogeneous coating composition.

EXAMPLE 5

(Preparation of coating composition)

A coating composition was obtained in the same manner as in Example 4 except that the fluorine-containing polymer obtained in Preparation Example 11 was used instead of the fluorine-containing polymer obtained in Preparation Example 10.

EXAMPLE 6

(Preparation of coating composition)

A coating composition was obtained in the same manner as in Example 4 except that the fluorine-containing polymer obtained in Preparation Example 12 was used instead of the fluorine-containing polymer obtained in Preparation Example 10.

EXPERIMENTAL EXAMPLE 14

(Measurement of refractive index of coating film)

A refractive index was measured using light of 193 nm wavelength in the same manner as in Experimental Example 10 after forming a coating film on a silicon wafer by using the coating compositions obtained in Examples 2, 3

and 4 to 6 and Experimental Example 13.
The results are shown in Table 6.

EXPERIMENTAL EXAMPLE 15

(Measurement of a dissolution rate of a coating film in a developing solution)

Production of a sample and measurement of a dissolution rate (nm/sec) in a developing solution by the quartz crystal oscillation method (QCM method) were carried out in the same manner as in Experimental Example 11 by using the respective coating compositions obtained in Examples 2, 3 and 4 to 6 and Experimental Example 13.
The results are shown in Table 6.

EXPERIMENTAL EXAMPLE 16

(Formation of laminated resist and measurement of reflectance)

Formation of photoresist layer:

A photoresist layer was formed by using a resist for ArF lithography in the same manner as in Example 1.

Formation of antireflection layer:

A laminated photoresist was obtained by forming an antireflection layer on the photoresist layer formed above in the same manner as in Example 1 by using the respective coating compositions obtained in Examples 2-6 and Experimental Example 13.
The reflectance of the obtained laminated photoresists was measured with light of 193 nm wavelength in the same manner as in Example 1.
The results are shown in Table 6.

TABLE 80

| Coating composition | Ex. 2 | Ex. 3 | Exp. Ex. 13 | Ex. 4 | Ex. 5 | Ex. 6 |
|---|---|---|---|---|---|---|
| (A1) Fluorine-containing polymer | Prep. Ex. 1 | Prep. Ex. 9 | Prep. Ex. 8 | Prep. Ex. 10 | Prep. Ex. 11 | Prep. Ex. 12 |
| Number average molecular weight: Mn | 13000 | 29000 | 7800 | 11000 | 34000 | 55000 |
| Concentration of polymer (% by mass) | 5.0 | 5.0 | 5.0 | 5.0 | 5.0 | 5.0 |
| (B) Solvent (% by mass) | | | | | | |
| Water | 65 | 70 | 60 | 100 | 100 | 100 |
| Isopropanol | 35 | 30 | 40 | 0 | 0 | 0 |
| Characteristics of coating film | | | | | | |
| Refractive index (193 nm) | 1.41 | 1.41 | 1.41 | 1.44 | 1.44 | 1.44 |
| Dissolution rate in a developing solution (nm/sec) | 150 | 500 | 50 | 500 | 1000 or more | 1000 or more |
| Characteristics of laminated resist | | | | | | |
| Reflectance (%) | 1.17 | 1.17 | 1.17 | 1.65 | 1.65 | 1.65 |

EXAMPLE 7

(Preparation of coating composition)

(Addition of amine (C))

To 10 g of the fluorine-containing polymer obtained in Preparation Example 1 was mixed diethanolamine (1.5 g) in an amount of 0.6 equivalent based on the carboxyl group contained in the fluorine-containing polymer. Further pure

water was added thereto to adjust the total amount of the composition to be 200 g, followed by stirring at room temperature for six hours. Then after allowing the solution to stand at room temperature for 24 hours, appearance of the solution was observed.

The evaluation was carried out by the following criteria.

O: A polymer is completely soluble, and a solution becomes transparent and homogeneous and has a low viscosity.
Δ: A solution becomes transparent and homogeneous, but is in the form of gel having a high viscosity.
X : A polymer is partly insoluble or is completely insoluble, and a solution is opaque.

(Addition 1 of acid (D))

To 50 g of the above-mentioned coating composition containing amine was mixed para-toluenesulfonic acid in an amount of 0.2 equivalent based on the carboxyl group contained in the fluorine-containing polymer. After stirring at room temperature for six hours and then allowing to stand at room temperature for 24 hours, appearance of the solution was observed in the same manner as above. (Addition 2 of acid (D))

To 50 g of the above-mentioned coating composition containing amine was mixed perfluoro butanoic acid in an amount of 0.2 equivalent based on the carboxyl group contained in the fluorine-containing polymer. After stirring at room temperature for six hours and then allowing to stand at room temperature for 24 hours, appearance of the solution was observed in the same manner as above. (Measurement of a pH value of a coating composition)

A pH value of the above coating composition was measured with the above-mentioned pH meter. Also a pH value of the coating composition obtained in Example 5 was measured.

The results are shown in Table 7.

| | Example 7 | | | Example 5 |
|---|---|---|---|---|
| Coating composition | Prep. Ex. 1 | Prep. Ex. 1 | Prep. Ex. 1 | Prep. Ex. 11 |
| (Al) Fluorine-containing polymer | | | | |
| Concentration of polymer (% by mass) | 5.0 | 5.0 | 5.0 | 5.0 |
| (B) Water (content (%) in a solvent) | 100 | 100 | 100 | 100 |
| (C) Diethanolamine (equivalent) | 0.6 | 0.6 | 0.6 | - |
| (D) Para-toluenesulfonic acid (equivalent) | - | 0.2 | - | - |
| Perfluoro butanoic acid (equivalent) | - | - | 0.2 | - |
| Evaluation of solubility | ○ | ○ | ○ | ○ |
| pH | 2.37 | 1.75 | 1.86 | 1.70 |

EXAMPLE 8

(Preparation of coating composition)

(Addition of surfactant (E))

The fluorine-containing polymer obtained in Preparation Example 1 was dissolved in an amount of 10 g in 25 g of isopropanol. The total amount of the obtained isopropanol solution of fluorine-containing polymer was added dropwise to 75 g of pure water at room temperature over about 10 minutes with stirring. Further a solution mixture of water/isopropanol of 75/25 mass-% was added 10 thereto to adjust the total amount of the composition to 200 g, and stirring was continued at room temperature for six hours. Then after allowing to stand at room temperature for 24 hours, appearance of the solution was observed. An undissolved substance remains partly in the solution and the solution was opaque.

The above composition was separated to four compositions of 50 g each, and to the respective compositions was added 0.05 g (2.0 mass-% based on the polymer in the composition) of a surfactant of the following formulae (E-1), (E-2), (E-3) and (E-4):

(E-1): $C_7F_{15}COONH_4$
(E-2):

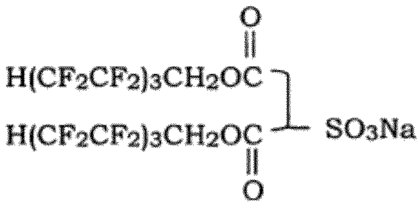

(E-3):

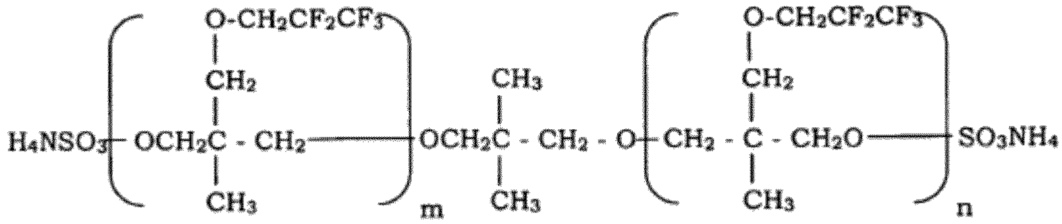

($1 \leq m + n \leq 50$, an average of m + n is 7)

(E-4): A Copolymer which has a number average molecular weight of 12,000 (based on styrene) and is prepared by copolymerizing:

20 g of a compound represented by

$CF_3CF_2(CF2CF_2)_nCH_2CH_2OCOC(CH_3)=CH_2$ (a mixture of compounds of n=3, n=4 and n=5 in a weight ratio of 5:3:1),
10 g of $CH_2=C(CH_3)COO(CH_2CH_2O)_9CH_3$,
5 g of $CH_2=C(CH_3)COO(CH_2CH(CH_3)O)_{12}H$,
4 g of $CH_2=C(CH_3)COOCH_2CH(OH)CH_2Cl$ and
1 g of $CH_2=C(CH_3)COOCH_2CH(OH)CH_2OH$,

and then stirring was continued at room temperature for six hours. Then after allowing to stand at room temperature for 24 hours, appearance of the solution was observed.

The evaluation was carried out by the following criteria.

O: A polymer is completely soluble, and a solution becomes transparent and homogeneous and has a low viscosity.
Δ: A solution becomes transparent and homogeneous, but is in the form of gel having a high viscosity.
X : A polymer is partly insoluble or is completely insoluble, and a solution is opaque.

The results are shown in Table 8.

TABLE 8

| Coating composition<br>(A) Fluorine-containing polymer | Prep. Ex. 1 | Prep. Ex. 1 | Prep. Ex. 1 | Prep. Ex. 1 | Prep. Ex. 1 |
|---|---|---|---|---|---|
| (B) Solvent (% by mass in a solvent) | | | | | |
| Water/ isopropanol | 75/25 | 75/25 | 75/25 | 75/25 | 75/25 |
| (E) Surfactant (% by mass based on polymer) | | | | | |
| (E-1) | - | 2.0 | - | - | - |
| (E-2) | - | - | 2.0 | - | - |
| (E-3) | - | - | - | 2.0 | - |
| (E-4) | - | - | - | - | 2.0 |
| Evaluation of solubility | X | ○ | ○ | ○ | ○ |

EXAMPLE 9

(Preparation of coating composition)

The fluorine-containing polymer obtained in Preparation Example 13 was dissolved in an amount of 10 g in 20 g of isopropanol. The total amount of the obtained isopropanol solution of fluorine-containing polymer was added dropwise to 80 g of pure water at room temperature over about 10 minutes with stirring. Further a solution mixture of water/isopropanol of 80/20 mass-% was added thereto to adjust the total amount of composition to 200 g, and then filtration was carried out with a filter having an opening size of 0.2 μm to obtain a homogeneous coating composition.

EXAMPLE 10

(Preparation of coating composition)

A coating composition was obtained in the same manner as in Example 9 except that the fluorine-containing polymer obtained in Preparation Example 14 was used instead of the fluorine-containing polymer obtained in Preparation Example 13.

EXAMPLE 11

(Preparation of coating composition)

A coating composition was obtained in the same manner as in Example 9 except that the fluorine-containing polymer obtained in Preparation Example 15 was used instead of the fluorine-containing polymer obtained in Preparation Example 13.

EXAMPLE 12

(Preparation of coating composition)

A coating composition was obtained in the same manner as in Example 9 except that the fluorine-containing polymer obtained in Preparation Example 16 was used instead of the fluorine-containing polymer obtained in Preparation Example 13.

EXPERIMENTAL EXAMPLE 17

(Measurement of a refractive index of a coating film)

A refractive index was measured using light of 193 nm wavelength in the same manner as in Experimental Example 10 after forming a coating film on a silicon wafer by using the coating compositions obtained in Examples 9-12.
The results are shown in Table 9.

EXPERIMENTAL EXAMPLE 18

(Measurement of a dissolution rate of a coating film in a developing solution)

Production of a sample and measurement of a dissolution rate (nm/sec) in a developing solution by the quartz crystal oscillation method (QCM method) were carried out in the same manner as in Experimental Example 11 by using the respective coating compositions obtained in Examples 9-12.
The results are shown in Table 9.

EXPERIMENTAL EXAMPLE 19

(Formation of laminated resist and measurement of reflectance)

Formation of photoresist layer:

A photoresist layer was formed by using a resist for ArF lithography in the same manner as in Example 1.

Formation of antireflection layer:

A laminated photoresist was obtained by forming, on the photoresist layer formed above, an antireflection layer in the same manner as in Example 1 by using the respective coating compositions obtained in Examples 9-12.
The reflectance of the obtained laminated photoresists was measured with light of 193 nm wavelength in the same manner as in Example 1.
The results are shown in Table 9.

EXPERIMENTAL EXAMPLE 20

(Measurement of a dissolution rate of a coating film in water)

A dissolution rate (nm/sec) in water was measured in the manner mentioned below by the quartz crystal oscillation method (QCM method). The results are shown in Table 10.

Production of sample:

Compositions prepared in Examples 6 and 9-12 were applied on a 24 mm diameter quartz crystal oscillation panel coated with gold to make about 100 nm thick coating films.

Measurement of dissolution rate in water:

A coating film thickness is calculated by converting the number of oscillations of the quartz crystal oscillation panel.
The quartz oscillation panel produced above by coating the fluorine-containing polymer was dipped in pure water. After dipping of the panel, a change in a coating thickness was obtained from a change in the number of oscillations with the progress of time, and a dissolution rate per unit time (nm/sec) was calculated (Reference bulletin: Advances in Resist Technology and Proceedings of SPIE Vol. 4690, 904(2002)). The results are shown in Table 10.

TABLE 9

| Coating composition | Ex. 9 | Ex. 10 | Ex. 11 | Ex. 12 |
|---|---|---|---|---|
| (A1) Fluorine-containing polymer | Prep. Ex. 13 | Prep. Ex. 14 | Prep. Ex. 15 | Prep. Ex. 16 |
| Number average molecular weight: Mn | 50000 | 54000 | 39000 | 37000 |
| Concentration of polymer (% by mass) | 5.0 | 5.0 | 5.0 | 5.0 |
| (B) Solvent | | | | |
| Water | 80 | 100 | 100 | 100 |
| Isopropanol | 20 | 0 | 0 | 0 |
| Characteristics of coating film | | | | |
| Refractive index (193 nm) | 1.41 | 1.44 | 1.42 | 1.43 |
| Dissolution rate in a developing solution (nm/sec) | 1000 or more | 1000 or more | 1000 or more | 1000 or more |
| Characteristics of laminated resist | | | | |
| Reflectance (%) | 1.17 | 1.65 | 1.33 | 1.50 |

TABLE 10

| Coating composition | Ex. 6 | Ex. 9 | Ex. 10 | Ex. 11 | Ex. 12 |
|---|---|---|---|---|---|
| (A1) Fluorine-containing polymer | Prep. Ex. 12 | Prep. Ex. 13 | Prep. Ex. 14 | Prep. Ex. 15 | Prep. Ex. 16 |
| Dissolution rate in water (nm/sec) | 1000 or more | 1000 or more | 1000 or more | 1000 or more | 1000 or more |

EXAMPLE 13

(Preparation of coating composition)

The fluorine-containing polymer obtained in Preparation Example 17 was dissolved in an amount of 5 g in 24 g of isopropanol. The total amount of the obtained isopropanol solution of fluorine-containing polymer was added dropwise to 96 g of pure water at room temperature over about 10 minutes with stirring, followed by filtrating with a filter having an opening size of 0.2 μm to obtain a homogeneous coating composition.

EXAMPLE 14

(Preparation of coating composition)

A coating composition was obtained in the same manner as in Example 13 except that the fluorine-containing polymer obtained in Preparation Example 18 was used.

EXPERIMENTAL EXAMPLE 21

(Measurement of a refractive index of a coating film)

A refractive index was measured using light of 193 nm wavelength in the same manner as in Experimental Example 10 after forming a coating film on a silicon wafer by using the coating compositions obtained in Examples 13 and 14.

The results are shown in Table 11.

EXPERIMENTAL EXAMPLE 22

(Measurement of a dissolution rate of a coating film in a developing solution)

Production of a sample and measurement of a dissolution rate (nm/sec) in a developing solution by the quartz crystal oscillation method (QCM method) were carried out in the same manner as in Experimental Example 11 by using the respective coating compositions obtained in Examples 13 and 14.

The results are shown in Table 11.

EXPERIMENTAL EXAMPLE 23

(Formation of laminated resist and measurement of reflectance)

Formation of photoresist layer:

A photoresist layer was formed by using a resist for ArF lithography in the same manner as in Example 1.

Formation of antireflection layer:

A laminated photoresist was obtained by forming, on the photoresist layer formed above, an antireflection layer in the same manner as in Example 1 by using the respective coating compositions obtained in Examples 13 and 14.

The reflectance of the obtained laminated photoresists was measured with light of 193 nm wavelength in the same manner as in Example 1.

The results are shown in Table 11.

TABLE 11

| Coating composition | Ex. 13 | Ex. 14 |
|---|---|---|
| (A) Fluorine-containing polymer | Prep. Ex. 17 | Prep. Ex. 18 |
| Fluorine content | 55.8 | 54.0 |

(continued)

| Coating composition | Ex. 13 | Ex. 14 |
|---|---|---|
| Number average molecular weight: Mn | 61000 | 46000 |
| Concentration of polymer (g/100 ml) | 5.0 | 5.0 |
| (B) Solvent | | |
| Water | 20 | 20 |
| Isopropanol | 80 | 80 |
| Characteristics of coating film | | |
| Refractive index | 1.43 | 1.44 |
| Dissolution rate in a developing solution | 1000 or more | 1000 or more |
| Characteristics of laminated resist | | |
| Reflectance (%) | 1.50 | 1.65 |

INDUSTRIAL APPLICABILITY

The present invention is featured especially by the fluorine-containing polymer (A) used for the antireflection layer (L2). When this fluorine-containing polymer (A) is present in the antireflection layer (L2) as main component, it is possible to reduce adverse effects on a resist pattern attributable to a standing wave effect arising in the case of using the photoresist layer (L1) alone and to a multiple reflection effect in patterning on a substrate having a step, and also it is possible to reduce a change of a pattern form attributable to an influence of outside atmosphere (an acidic or basic substance, water and the like in the air). As a result, the pattern form and dimensional accuracy are enhanced, and an ultrafme resist pattern being excellent in repeatability thereof can be formed.

The fluorine-containing polymer (A) used for the antireflection layer (L2) of the present invention can satisfy requirements for both of a low refractive index and water solubility or solubility in a developing solution (dissolution rate) though it has been difficult to satisfy the requirements. As a result, the polymer has performance adaptable to a conventional photolithography process, especially a developing process as before in addition to the above-mentioned effects in the pattern formation.

According to the present invention, since the antireflection layer of the laminated resist contains the fluorine-containing polymer containing hydrophilic group and having a high fluorine content, in a step for forming a laminated photoresist for lithography, particularly in lithography using ArF (193 nm) laser or $F_2$ laser as exposure light, it is possible to prevent lowering of dimensional accuracy of a pattern and decreasing of a dissolution rate in the developing step, which arise due to interference between the exposure light and the reflection light in the photoresist layer, and processability in micro fabrication can be improved.

## Claims

**1.** A method of forming a laminated photoresist which comprises the steps of:

(I) forming a photoresist layer (L1) on a substrate, and
(II) forming an antireflection layer (L2) on the photoresist layer (L1) by applying a coating composition comprising a fluorine-containing polymer (A) which has

(i) in a structural unit derived from a fluorine-containing ethylenic monomer having a -COOH group, ≥ 0.14 moles of -COOH groups per 100 g of the polymer (A), which -COOH group has a pKa value of ≥ 11;
(ii) a fluorine content of ≥ 50 mass-%, and
(iii) a number average molecular weight of 31,000-750,000.

**2.** The method of claim 1, wherein the number of moles of -COOH in 100 g of the polymer (A) is ≥ 0.21.

**3.** The method of claim 1, wherein the number of moles of -COOH in 100 g of the polymer (A) is 0.21-0.290.

**4.** The method of any of claims 1-3, wherein the polymer (A) is represented by the formula -(M1)-(N1)-, wherein M1 is a structural unit derived from a fluorine-containing monomer of formula (1):

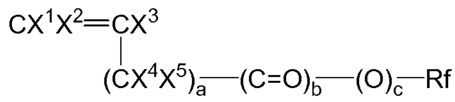

(1)

wherein

$X^1$ and $X^2$ each independently are H or F;
$X^3$ is H, F, Cl, $CH_3$ or $CF_3$;
$X^4$ and $X^5$ each independently are H or F;
Rf is a monovalent organic group in which 1-4 hydrophilic groups Y are bonded to a fluorine-containing $C_{1-40}$-alkyl group or a monovalent organic group in which 1-4 hydrophilic groups Y are bonded to a fluorine-containing $C_{2-100}$-alkyl group having ether bond; and
a, b and c each independently are 0 or 1,
N1 is a structural unit derived from a monomer copolymerizable with the monomer of formula (1), and the structural units M1 and N1 are contained in amounts of 30-100 mol-% and 0-70 mol-%, respectively.

**5.** The method of claim 4, wherein M1 is a structural unit derived from a fluorine-containing monomer of formula (2):

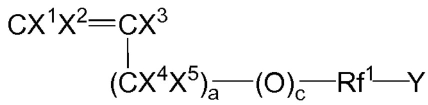

(2)

wherein $X^1$-$X^5$, a, c and Y are as defined in formula (1); $Rf^1$ is a divalent fluorine-containing $C_{1-40}$-alkylene group or a divalent fluorine-containing $C_{2-100}$-alkylene group having ether bond.

**6.** The method of claim 4, wherein the structural unit M1 is a structural unit derived from a fluorine-containing monomer of formula (3):

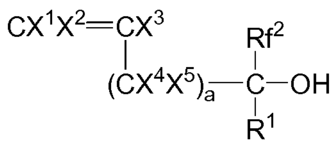

(3)

wherein $X^1$-$X^5$ and a are as defined in formula (1); $Rf^2$ is a fluorine-containing $C_{1-10}$-alkyl group which may have ether bond; $R^1$ is at least one of H, a $C_{1-10}$-hydrocarbon group and a fluorine-containing $C_{1-10}$-alkyl group which may have ether bond.

**7.** The method of any of claims 1-3, wherein the polymer (A) is represented by the formula -(M2)-(N2)-, wherein

M2 is a structural unit derived from a fluorine-containing monomer of formula (4):

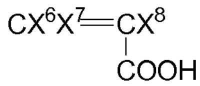

(4)

wherein $X^6$ and $X^7$ each independently are H or F; $X^8$ is H, F, Cl, $CH_3$ or $CF_3$; at least one of $X^6$-$X^8$ contains F;
N2 is a structural unit derived from a monomer copolymerizable with the monomer of formula (4); and

the structural units M2 and N2 are contained in amounts of 10-100 mol-% and 0-90 mol-%, respectively.

**8.** The method of any of claims 1-7, wherein the coating composition further contains (B) at least one solvent selected from water and alcohols.

**9.** The method of claim 8, wherein the coating composition further contains (C) at least one of ammonia and organic

amines.

**10.** A coating composition comprising:

(A1) a fluorine-containing polymer having carboxyl group and
(B) at least one solvent selected from water and alcohols;

the polymer (A1) has a number average molecular weight of 31,000-750,000 and is represented by the formula -(M3)-(N3)-, wherein

M3 is a structural unit derived from a fluorine-containing monomer of formula (5):

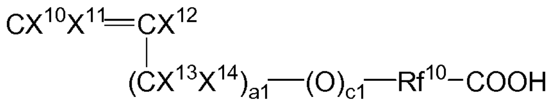
(5)

wherein

$X^{10}$ and $X^{11}$ each independently are H or F;
$X^{12}$ is H, F, Cl, $CH_3$ or $CF_3$;
$X^{13}$ and $X^{14}$ each independently are H or F;
$Rf^{10}$ is a divalent fluorine-containing $C_{1-40}$-alkylene group or a divalent fluorine-containing $C_{2-100}$-alkylene group having ether bond, and
a1 and c1 each independently are 0 or 1;

N3 is a structural unit derived from a monomer copolymerizable with the monomer of formula (5); and

the structural units M3 and N3 are contained in amounts of 55-100 mol-% and 0-45 mol-%, respectively.

**11.** The coating composition of claim 10, wherein in the polymer (A1), the structural units M3 and N3 are contained in amounts of 70-100 mol-% and 0-30 mol-%, respectively.

**12.** The coating composition of any of claim 10 or 11, wherein the solvent (B) is selected from water and mixtures of water and alcohol, and the content of water in the solvent (B) exceeds 65 mass-% based on the total weight of water and alcohol.

**13.** The coating composition of any of claims 10-12, which further contains (C) at least one of ammonia and organic amines.

**14.** The coating composition of claim 13, wherein (C) at least one of ammonia and organic amines is at least one of ammonia and hydroxyalkyl amines.

## Patentansprüche

**1.** Verfahren zur Bildung eines laminierten Fotoresists, umfassend die Schritte:

(I) Bilden einer Fotoresistschicht (L1) auf einem Substrat, und
(II) Bilden einer Antireflexionsschicht (L2) auf der Fotoresistschicht (L1) durch Aufbringen einer Beschichtungszusammensetzung, umfassend ein fluorhaltiges Polymer (A), das

(i) in einer von einem fluorhaltigen ethylenischen Monomer mit einer -COOH-Gruppe abgeleiteten Struktureinheit ≥ 0,14 mol -COOH-Gruppen pro 100 g des Polymers (A), wobei die -COOH-Gruppe einen pKa-Wert von ≥ 11 hat;
(ii) einen Fluorgehalt von ≥ 50 Masse-% und
(iii) ein zahlengemitteltes Molekulargewicht von 31.000 bis 750.000

aufweist.

2. Verfahren gemäss Anspruch 1, wobei die Anzahl der Mole von -COOH in 100 g des Polymers (A) ≥ 0,21 beträgt.

3. Verfahren gemäss Anspruch 1, wobei die Anzahl der Mole von -COOH in 100 g des Polymers (A) 0,21 bis 0,290 beträgt.

4. Verfahren gemäss einem der Ansprüche 1 bis 3, wobei das Polymer (A) durch die Formel -(M1)-(N1)- dargestellt ist, worin M1 eine von einem fluorhaltigen Monomer der Formel (1) abgeleitete Struktureinheit ist:

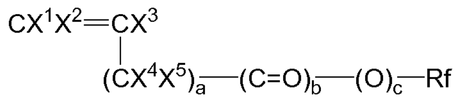
(1)

worin

$X^1$ und $X^2$ jeweils unabhängig H oder F sind;
$X^3$ H, F, Cl, $CH_3$ oder $CF_3$ ist;
$X^4$ und $X^5$ jeweils unabhängig H oder F sind;
Rf eine monovalente organische Gruppe, in welcher 1 bis 4 hydrophile Gruppen Y an eine fluorhaltige $C_{1-40}$-Alkylgruppe gebunden sind, oder eine monovalente organische Gruppe, in welcher 1 bis 4 hydrophile Gruppen Y an eine fluorhaltige $C_{2-100}$-Alkylgruppe mit einer Etherbindung gebunden sind; ist und
a, b und c jeweils unabhängig 0 oder 1 sind,
N1 eine Struktureinheit ist, abgeleitet von einem Monomer, das mit einem Monomer der Formel (1) copolymerisierbar ist, und
die Struktureinheiten M1 und N1 in Mengen von 30 bis 100 mol-% bzw. 0 bis 70 mol-% enthalten sind.

5. Verfahren gemäss Anspruch 4, worin M1 eine von einem fluorhaltigen Monomer der Formel (2) abgeleitete Struktureinheit ist:

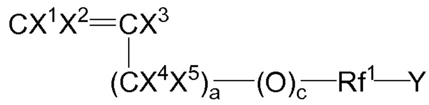
(2)

worin $X^1$ bis $X^5$, a, c und Y wie in Formel (1) definiert sind; $Rf^1$ eine divalente fluorhaltige $C_{1-40}$-Alkylengruppe oder eine divalente fluorhaltige $C_{2-100}$-Alkylengruppe mit einer Etherbindung ist.

6. Verfahren gemäss Anspruch 4, wobei die Struktureinheit M1 eine von einem fluorhaltigen Monomer der Formel (3) abgeleitete Struktureinheit ist:

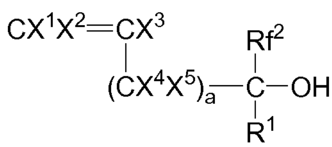
(3)

worin $X^1$ bis $X^5$ und a wie in Formel (1) definiert sind; $Rf^2$ eine fluorhaltige $C_{1-10}$-Alkylgruppe ist, die Etherbindungen aufweisen kann; $R^1$ zumindest eines von H, einer $C_{1-10}$-Kohlenwasserstoffgruppe und einer fluorhaltigen $C_{1-10}$-Alkylgruppe, die Etherbindungen aufweisen kann, ist.

7. Verfahren gemäss einem der Ansprüche 1 bis 3, wobei das Polymer (A) durch die Formel -(M2)-(N2)- dargestellt ist, worin

M2 eine von einem fluorhaltigen Monomer der Formel (4) abgeleitete Struktureinheit ist:

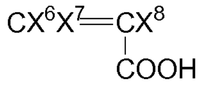

(4)

worin $X^6$ und $X^7$ jeweils unabhängig H oder F sind; $X^8$ H, F, Cl, $CH_3$ oder $CF_3$ ist; zumindest eines von $X^6$ bis $X^8$ F enthält;
N2 eine Struktureinheit ist, abgeleitet von einem Monomer, das mit einem Monomer der Formel (4) copolymerisierbar ist,

die Struktureinheiten M2 und N2 in Mengen von 10 bis 100 mol-% bzw. 0 bis 90 mol-% enthalten sind.

**8.** Verfahren gemäss einem der Ansprüche 1 bis 7, wobei die Beschichtungszusammensetzung ferner (B) zumindest ein Lösungsmittel, ausgewählt aus Wasser und Alkoholen, enthält.

**9.** Verfahren gemäss Anspruch 8, wobei die Beschichtungszusammensetzung ferner (C) zumindest eines von Ammoniak und organischen Aminen enthält.

**10.** Beschichtungszusammensetzung umfassend:

(A1) ein fluorhaltiges Polymer, das eine Carboxylgruppe aufweist, und
(B) zumindest ein Lösungsmittel, ausgewählt aus Wasser und Alkoholen;

wobei das Polymer (A1) ein zahlengemitteltes Molekulargewicht von 31.000 bis 750.000 aufweist und durch die Formel -(M3)-(N3)- dargestellt ist, wobei

M3 eine von einem fluorhaltigen Monomer der Formel (5) abgeleitete Struktureinheit ist:

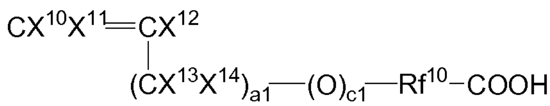

(5)

worin

$X^{10}$ und $X^{11}$ jeweils unabhängig H oder F sind;
$X^{12}$ H, F, Cl, $CH_3$ oder $CF_3$ ist;
$X^{13}$ und $X^{14}$ jeweils unabhängig H oder F sind;
$Rf^{10}$ eine divalente fluorhaltige $C_{1-40}$-Alkylengruppe oder eine divalente fluorhaltige $C_{2-100}$-Alkylengruppe, die eine Etherbindung aufweist, ist und
a1 und c1 jeweils unabhängig 0 oder 1 sind;

N3 eine Struktureinheit ist, abgeleitet von einem Monomer, das mit einem Monomer der Formel (5) copolymerisierbar ist,

die Struktureinheiten M3 und N3 in Mengen von 55 bis 100 mol-% bzw. 0 bis 45 mol-% enthalten sind.

**11.** Beschichtungszusammensetzung gemäss Anspruch 10, wobei in dem Polymer (A1) die Struktureinheiten M3 und N3 in Mengen von 70 bis 100 mol-% bzw. 0 bis 30 mol-% enthalten sind.

**12.** Beschichtungszusammensetzung gemäss einem der Ansprüche 10 oder 11, wobei das Lösungsmittel (B) aus Wasser und Mischungen von Wasser und Alkohol ausgewählt ist und der Wassergehalt in dem Lösungsmittel (B) 65 Masse-%, bezogen auf das Gesamtgewicht von Wasser und Alkohol, übersteigt.

**13.** Beschichtungszusammensetzung gemäss einem der Ansprüche 10 bis 12, die ferner (C) zumindest eines von Ammoniak und organischen Aminen enthält.

**14.** Beschichtungszusammensetzung gemäss Anspruch 13, wobei (C) zumindest eines von Ammoniak und organischen

Aminen zumindest eines von Ammoniak und Hydroxyalkylaminen ist.

**Revendications**

**1.** Procédé de formation d'un photorésist stratifié qui comprend les étapes consistant à :

(I) former une couche de photorésist (L1) sur un substrat, et
(II) former une couche antireflet (L2) sur la couche de photorésist (L1) en appliquant une composition de revêtement comprenant un polymère contenant du fluor (A) qui présente

(i) une unité structurale dérivée d'un monomère éthylénique contenant du fluor présentant un groupe -COOH, ≥ à 0,14 moles de groupes -COOH dans 100 g du polymère (A), dont les groupes -COOH présentent une valeur pKa ≥ à 11 ;
(ii) une teneur en fluor ≥ à 50 % en masse, et
(iii) une masse moléculaire moyenne en nombre de 31000-750000.

**2.** Procédé selon la revendication 1, dans lequel le nombre de moles de -COOH dans 100 g du polymère (A) est ≥ à 0,21.

**3.** Procédé selon la revendication 1, dans lequel le nombre de moles de -COOH dans 100 g du polymère (A) est de 0,21-0,290.

**4.** Procédé selon l'une quelconque des revendications 1 à 3, dans lequel le polymère (A) est représenté par la formule -(M1)-(N1)-, dans laquelle M1 est une unité structurale dérivée d'un monomère contenant du fluor de formule (1) :

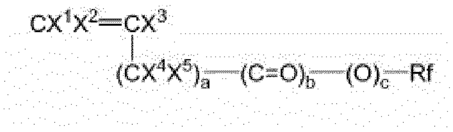
(1)

où

$X^1$ et $X^2$ sont chacun indépendamment H ou F ;
$X^3$ est H, F, Cl, $CH_3$ ou $CF_3$ ;
$X^4$ et $X^5$ sont chacun indépendamment H ou F ;
Rf est un groupe organique monovalent dans lequel 1-4 groupes hydrophiles Y sont liés à un groupe alkyle en $C_{1-40}$ contenant du fluor ou un groupe organique monovalent dans lequel 1 à 4 groupes hydrophiles Y sont liés à un groupe alkyle en $C_{2-100}$ contenant du fluor ; et
a, b et c sont chacun indépendamment 0 ou 1,
N1 est une unité structurale dérivée d'un monomère copolymérisable avec le monomère de formule (1), et les unités structurales M1 et N1 sont contenues en des quantités de 30-100 % en mole et de 0-70 % en mole, respectivement.

**5.** Procédé selon la revendication 4, dans lequel M1 est une unité structurale dérivée d'un monomère contenant du fluor de formule (2) :

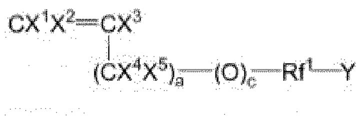
(2)

où $X^1$-$X^5$, a, c et Y sont tels que définis dans la formule (1) ; $Rf^1$ est un groupe alkylène divalent en $C_{1-40}$ contenant du fluor ou un groupe alkylène divalent en $C_{2-100}$ contenant du fluor présentant une liaison éther.

**6.** Procédé selon la revendication 4, dans lequel l'unité structurale M1 est une unité structurale dérivée d'un monomère contenant du fluor de formule (3) :

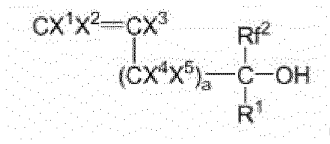
(3)

où $X^1$-$X^5$ et a sont tels que définis dans la formule (1) ; $Rf^2$ est un groupe alkyle en $C_{1-10}$ contenant du fluor qui peut avoir une liaison éther; $R^1$ est au moins un de H, un groupe hydrocarboné en $C_{1-10}$ et un groupe alkyle en $C_{1-10}$ contenant du fluor qui peut avoir une liaison éther.

**7.** Procédé selon l'une quelconque des revendications 1-3, dans lequel le polymère (A) est représenté par la formule -(M2)-(N2)-, dans lequel M2 est une unité structurale dérivée d'un monomère contenant du fluor de formule (4) :

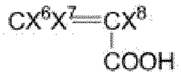
(4)

où $X^6$ et $X^7$ sont chacun indépendamment H ou F ;
$X^8$ est H, F, Cl, $CH_3$ ou $CF_3$; au moins l'un de $X^6$-$X^8$ contient un atome de F,
N2 est une unité structurale dérivée d'un monomère copolymérisable avec le monomère de formule (4), et les unités structurales M2 et N2 sont contenues en des quantités de 10-100 % en moles et de 0-90 % en moles, respectivement.

**8.** Procédé selon l'une quelconque des revendications 1-7, dans lequel la composition de revêtement contient en outre (B) au moins un solvant choisi parmi l'eau et les alcools.

**9.** Procédé selon la revendication 8, dans lequel la composition de revêtement contient en outre (C) au moins l'un parmi l'ammoniac et les amines organiques.

**10.** Composition de revêtement comprenant :

(A1) un polymère contenant du fluor présentant un groupe carboxyle et
(B) au moins un solvant choisi parmi l'eau et les alcools ;

le polymère (A1) présente une masse moléculaire moyenne en nombre de 31000-750000 et est représenté par la formule -(M3)-(N3)-, dans laquelle M3 est une unité structurale dérivée d'un monomère contenant du fluor de formule (5) :

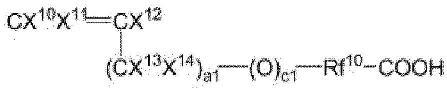
(5)

où

$X^{10}$ et $X^{11}$ sont chacun indépendamment H ou F ;
$X^{12}$ est H, F, Cl, $CH_3$ ou $CF_3$ ;
$X^{13}$ et $X^{14}$ sont chacun indépendamment H ou F ;
$Rf^{10}$ est un groupe alkylène divalent en $C_{1-40}$ contenant du fluor ou un groupe alkylène divalent en $C_{2-100}$ contenant du fluor présentant une liaison éther ; et
a1 et c1 sont chacun indépendamment 0 ou 1,
N3 est une unité structurale dérivée d'un monomère copolymérisable avec le monomère de formule (5), et les unités structurales M3 et N3 sont contenues en des quantités de 55-100 % en moles et de 0-45 % en moles, respectivement.

**11.** Composition de revêtement selon la revendication 10, dans laquelle dans le polymère (A1), les unités structurales M3 et N3 sont contenues en des quantités de 70-100 % en moles et de 0-30 % en moles, respectivement.

**12.** Composition de revêtement selon l'une quelconque des revendications 10 ou 11, dans laquelle le solvant (B) est choisi parmi l'eau et les mélanges de solvants d'eau et d'alcool, et la teneur en eau dans le solvant (B) dépasse 65 % en masse par rapport au poids total d'eau et d'alcool.

**13.** Composition de revêtement selon l'une quelconque des revendications 10-12, qui contient en outre (C) au moins l'un de l'ammoniac et les amines organiques.

**14.** Composition de revêtement selon la revendication 13, dans laquelle (C) au moins l'un de l'ammoniac et les amines organiques est au moins l'un de l'ammoniac et les hydroxyalkylamines.

FIG. 1

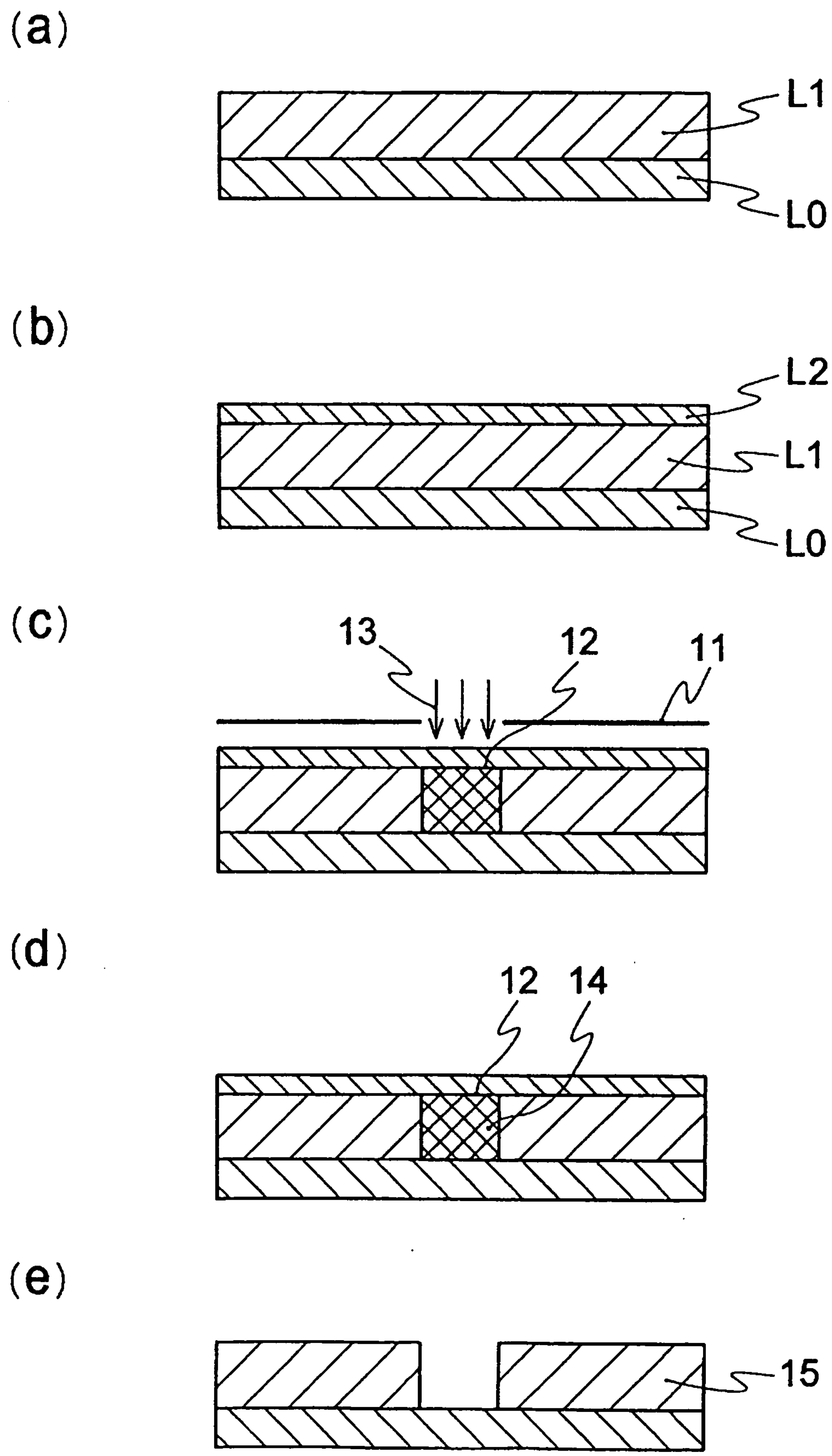

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 60038821 A
- JP 6262520 A
- JP 62062521 A
- JP 62159143 A
- JP 5188598 A
- JP 6041768 A
- JP 651523 A
- JP 7234514 A
- JP 8305032 A
- JP 8292562 A
- JP 11349857 A
- JP 11352697 A
- JP 2001194798 A
- JP 2001200019 A
- JP 2001133984 A
- JP 11124531 A
- JP 2004037887 A

### Non-patent literature cited in the description

- *Reference bulletin: Advances in Resist Technology and Proceedings of SPIE,* 2002, vol. 4690, 904
- Advances in Resist Technology and Proceedings of SPIE. *Reference bulletin,* 2002, vol. 4690, 904